(19) Europäisches Patentamt
European Patent Office
Office européen des brevets

(11) EP 2 944 972 A1

(12) **EUROPEAN PATENT APPLICATION**

(43) Date of publication:
**18.11.2015 Bulletin 2015/47**

(51) Int Cl.:
***G01R 33/28*** *(2006.01)* ***G01R 33/48*** *(2006.01)*

(21) Application number: **14001658.5**

(22) Date of filing: **12.05.2014**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(71) Applicant: **Max-Delbrück-Centrum für Molekulare Medizin (MDC)**
**13125 Berlin (DE)**

(72) Inventors:
- **Winter, Lukas**
  **13353 Berlin (DE)**
- **Oberacker, Eva**
  **76185 Karlsruhe (DE)**
- **Niendorf, Prof. Thoralf**
  **52074 Aachen (DE)**

(74) Representative: **Cohausz Hannig Borkowski Wißgott**
**Patent- und Rechtsanwaltskanzlei**
**Schumannstrasse 97-99**
**40237 Düsseldorf (DE)**

(54) **Method for the assessment of radiofrequency induced power absorption of conducting implants during MRI**

(57) The invention relates to a method for the assessment of radiofrequency induced power absorption, in particular heating of conducting implants, in particular intercoronary stents during magnetic resonance imaging by calculating a specific absorption rate (SAR) using a mathematical model, the model comprising a dependency of the absorption rate from a COS-function of the angular position between the long axis of the stent and the E-field-vector.

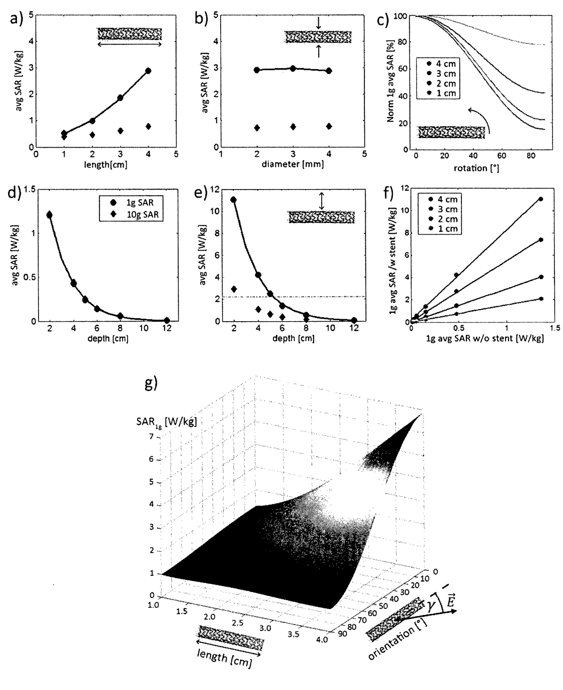


Figure 1.3

EP 2 944 972 A1

Printed by Jouve, 75001 PARIS (FR)

## Description

The invention relates to the assessment of radiofrequency induced power absorption, in particular heating of conducting implants, in particular intercoronary stents.

A growing number of reports refer to explorations into ultrahigh field magnetic resonance (UHF-MR, $B_0 \geq 7.0$ T). En route to broader clinical UHF-MR studies it is essential to gain a better insight into the interaction of passive conducting implants with radiofrequency (RF) fields. While a broad spectrum of conducting implants is declared to be MR safe at lower magnetic field strengths practical concerns evoked by the paucity of data about RF safety at frequencies of f≥298MHz are driving the notion that conducting implants are considered to be contraindications *per* se for UHF-MR.

A priori, it cannot be ruled out that RF antenna effects due to conducting implants together with RF wavelength shortening at UHF-MR may bear the potential to cause local RF power deposition which may exceed regulatory limits and RF exposure guidelines.

Recognizing this potential, UHF-MR institutions observe contraindications very carefully including reports on exclusion of subjects equipped with conducting implants from UHF-MR examinations. The lack of data and the need for RF safety assessment at $B_0 \geq 7.0$T prompted research into RF induced heating of passive, conducting implants. Pioneering efforts included a portfolio of extracranial neurosurgical implants, cranial fixation plates, aneurysm clips, intraocular lenses and upper eyelid implants, dental retainer wires and metallic peripheral arterial stents.

The conclusions drawn from these studies are valuable but constrained to the very specific experimental setup used. Factors for electrodynamic influences of the medical implants include:

- Geometry and shape of the implant
- Position of the implant within the human body
- Patient anatomy and physiology
- Electromagnetic and thermal material properties of the implant
- MR Imaging technique and parameter used (RF pulse peak power, RF pulse shape, RF pulse duration, repetition time)
- RF coil used
- RF amplitude and phase modulation for multi-channel transmit coils (e.g. B1-shimming, parallel transmit)

It is an object of the invention to provide a method for assessing / estimating the influence of radiofrequency to conducting implants in particular the specific absorption rate SAR.

In accordance with the invention this object is solved by performing a multi-parametric safety assessment particularly using numerical electromagnetic field (EMF) and thermal simulations to calculate the specific absorption rate (SAR) and/or temperature induced by the medical implant.

However, when using realistic human voxel model simulation, models tend to get extensively complex and very time-consuming. These constraints does not allow a generalized approach to cover the super-broad spectrum of medical implants, positions and MR applications.

The new method provides a generalized estimation of induced RF power deposition (SAR) levels based on an a *priori* estimation and simplification of the physical model to the most relevant parameters. In a preferred embodiment this estimation is performed by calculating the power deposition (SAR) using a mathematical model, in this model the power deposition particularly being dependent at least upon a COS-function of angular stent position, the angular stent position being defined by the angle between the long axis of the stent and the E-field vector. Preferably the model furthermore comprises parameters representing the stent length, in particular these parameters being normalized coefficients.

According to the invention the mathematical model may be-derived by the following steps:

1. Defining the boundary conditions for an investigated clinical implant, in particular these boundary condition being the geometry and/or shape and/or material of implant and / or positions inside the human body

2. Performing electromagnetic field simulations and/or thermal simulations and validation measurements in a uniform phantom to determine at least one critical parameter that influences induced SAR levels, in particular the parameter being the length of implant, and/or the position with relation to the E-field vector and / or SAR levels at location of implant without the presence of the implant.

3. Generation of fitting functions that match induced SAR levels of a single critical parameter.

4. Merging of the results into the multi-parametric SAR estimation.

Furthermore the method may be improved by

5. Validation of the SAR estimation as compared to simulations in realistic human voxel models including the medical implant.

The method according to the invention provides the following advantages:

- Generalized approach based upon an analytical solution (for example please see equation 3 in the attached manuscript) for a broad range of conducting implant configurations for the investigated implant boundary conditions

- The method provides an analytical estimation which describes SAR induced by an arbitrary intracoronary stent or other conducting implant interfering with electromagnetic fields generated by an arbitrary RF coil configuration.

- Generalized approach that supports a broad range of if not all MR applications (MRI, MRS) including single feeding channel, multiple feeding channel and parallel RF transmission regimes.
  The method provides a conservative estimation of induced SAR peak levels without the need of performing simulations with the stent integrated in the in vivo human voxel model.

- capability for fast and on the fly or real time calculation of estimated RF power absorption levels, that can be easily incorporated in the scanner applications and routine.

- The method provides a new metric and design criterion for RF coils and holds the promise and offers the ability to perform RF coil design based on the proposed SAR estimation for MR applications with medical implants.

- Ability to perform medical implant design based on the proposed SAR estimation for reduced/increased induced SAR levels in MRI applications.

- Although our approach is a generalized approach it provides means for personalized and individualized SAR assessment for subjects equipped with medical implants due to its speed and simplicity.

- Although the basic feasibility was demonstrated for MRI at 7.0 T the method can be translated to all other magnetic field strength used in MRI.

In today's MR, SAR monitoring regimes are fixed to 6 min and 10 s duration governed by the IEC guidelines. The method provides means to define and manage flexible and subject specific SAR monitoring periods based upon heating induced by a medical implant or by the RF transmission source. For example, the RF power exposure can be set different for periods where the RF induced heating of a stent is dominating SAR peak levels/RF power deposition constraints versus periods where the heating induced by the RF transmission source is dominating SAR peak levels. This approach helps to make MR sequences more efficient by making good use of the RF power deposition limits.
The method for assessing the deposited RF power furthermore provides the possibility to design implants, in particular stents and / or MRT coils in order to adapt the design to fulfill the assessment according to the invention.
For example using the inventive estimation for the SAR value a design of a coil may be chosen so that the calculated SAR value for a specific stent and coil will not exceed the SAR value calculated for the coil alone (without stent). This approach will be applicable in general for any kind of implant, particularly after adaption of the mathematical model.
Preferred embodiments of the method are disclosed in the following description and the figures / tables.
Purpose:

Examine radiofrequency (RF) induced heating of intracoronary stents at 7.0 T to derive an analytical approach which supports RF heating assessment of arbitrary stent geometries and RF coils.

Material and Methods:

Electromagnetic field (EMF) simulations are performed to detail E-fields, local specific absorption rates (SAR) and

temperature changes. For validation E-field measurements and RF heating experiments are conducted. To progress to clinical setups RF coils tailored for cardiac MRI at 7.0T and intracoronary stents were incorporated into EMF simulations using an *in vivo* human voxel model.

Results:

Our simulations of intracoronary stents at 298 MHz were confirmed by E-field and temperature measurements. An analytical solution which describes $SAR_{(1g\ tissue\ voxel)}$ induced by an arbitrary intracoronary stent interfering with E-fields generated by an arbitrary RF coil was derived. The analytical approach yielded conservative estimation of induced $SAR_{(1g\ tissue\ voxel)}$ maxima without the need for integrating the stent into EMF simulations of the human voxel model.

Conclusion:

The proposed analytical approach can be applied for any patient, intracoronary stent type, RF coil configuration and RF transmission regime. The generalized approach is of value for RF heating assessment of other passive electrically conductive implants and provides a novel design criterion for RF coils and conducting passive medical implants.

Introduction

A growing number of reports refer to explorations into ultrahigh field magnetic resonance (UHF-MR, $B_0 \geq 7.0$ T). En route to broader clinical UHF-MR studies it is essential to gain a better insight into the interaction of passive conducting implants with radiofrequency (RF) fields. While a broad spectrum of conducting implants is declared to be MR safe at lower magnetic field strengths practical concerns evoked by the paucity of data about RF heating at frequencies of f≥298MHz are driving the notion that conducting implants are considered to be contraindications *per* se for UHF-MR. A priori, it cannot be ruled out that RF antenna effects due to conducting implants together with RF wavelength shortening at UHF-MR may bear the potential to cause local RF power deposition which may exceed regulatory limits and RF exposure guidelines. Recognizing this potential, UHF-MR institutions observe contraindications very carefully including reports on exclusion of subjects equipped with conducting implants from UHF-MR examinations. The lack of data and the need for RF heating assessment at $B_0 \geq 7.0$T prompted research into RF induced heating of passive, conducting implants. Pioneering efforts included a portfolio of extracranial neurosurgical implants, cranial fixation plates, aneurysm clips, intraocular lenses and upper eyelid implants, dental retainer wires and metallic peripheral arterial stents. The conclusions drawn from these studies are valuable but constrained to the very specific experimental setup used.

With an ever increasing population of patients with a history of intracoronary stent implementation, detailing the interaction of intracoronary stents with RF fields is of profound relevance for the advancement of UHF-MR. At UHF-MR the RF wavelength (λ) in myocardial tissue and blood renders sufficiently short (λ~12cm) to allow for resonance effects in intracoronary stents with a length of up to ~4cm, which is commonly used in clinical practice. This geometry accords with λ/3 of the transmitted RF wavelength which yields a maximum in elevated RF power absorption. Initial studies suggested that temperature increase due to intra coronary stents does not exceed baseline RF heating. While being important these early studies run the caveat of not employing a setup which resembles a clinical scenario.

Recognizing the need and opportunities for broader clinical UHF-MR studies this work examines RF induced heating of intracoronary stents at 7.0T. For this purpose electromagnetic field (EMF) simulations are performed for a broad range of stent configurations to detail electric fields (E-fields) and local specific absorption rates (SAR). For validation of EMF simulations, E-field measurements of intracoronary stents are conducted. For the assessment of RF induced temperature changes numerical thermal simulations are executed and verified by RF heating experiments at 7.0T. To advance from phantom setups to a clinical setup that uses RF coil configurations tailored for cardiac MRI at 7.0T EMF simulations of coronary stents incorporated into an *in vivo* human voxel model are carried out. To translate our results to arbitrary intracoronary stent geometries and RF coil configurations an analytical estimation for the assessment of EM fields induced in intracoronary stents is proposed.

Materials and Methods

Intracoronary stent configurations

Stent length, diameter, orientation versus the E-field vector and the location of the stent with respect to the RF source influence SAR and the antenna effect. Table 1.1 surveys intracoronary stent geometries and configurations commonly used in today's clinical practice with stent locations being almost equally distributed across the right coronary artery (RCA), left circumflex artery (LCX) and the left anterior descending artery (LAD). To resemble the clinical scenario

we included stent configurations with a length of 10-40mm and a diameter ranging from 2-4mm as exemplified in Figure 1.1a. The alignment of the long axis of the stent versus the E-field vector was varied between 0° and 90°. The distance between the stent and the RF antenna building block used for transmission was changed between 20mm and 120mm.

Numerical electromagnetic field simulations

To investigate stent induction phenomena for a given EMF distribution numerical EMF simulations the finite-difference time-domain (FDTD) method (SEMCAD X, SPEAG, Zurich, Switzerland) was used. The E-fields deduced from the FDTD approach accorded with the E-fields derived with t the finite integration technique (FIT) (CST MWS, Darmstadt, Germany) as depicted in Figure 1.1b-c.

For the simulation setup a bow tie electric dipole antenna building block (35) was placed on top of a virtual phantom mimicking myocardial tissue

$$(\sigma = 0.77\ S/m, \varepsilon_r = 58.2, \rho = 1090\ kg/m^3) \quad \text{(Figure 1.1d).}$$

With the Poynting vector being perpendicular to the main axis of the bow tie building block the long axis of the passive conducting device was placed in parallel with the E-field vector (Figure 1.1e). To resemble the broad spectrum of stent mesh structures and to allow for reasonable computation times, a copper tube was used as a stent equivalent. This is a legitimate approach since the antenna effect rather than the stent mesh is the dominant source in electromagnetic coupling behavior as shown in Figure 1.1f. EMF simulations were performed with a simulation mesh size of (200x200x200) $\mu m^3$ for regions inside the stent equivalent and for regions in close vicinity of the stent equivalent. For the remaining regions inside the phantom a mesh size of (2.5 x 2.5 x 2.5) $mm^3$ was applied.

Figure 1.1g provides an overview of EM field interaction with the stent equivalent showing absolute E-fields at the tip of the stent equivalent. To examine RF induced SAR, 1g ($V_{1g}$=(10 x 10 x 10) $mm^3$)) and 10g ($V_{10g}$=(21 x 21 x 21) $mm^3$) averaging masses were applied (Figure 1.1h,i).

E-field measurements

For validation of the EMF simulations E-field measurements were performed. Figure 1.2a shows a basic scheme of the setup used for the E-field measurements. An ASTM phantom was constructed (Figure 1.2b) and filled with a TWEEN20 water mixture to mimic myocardial tissue properties at 300MHz ($\varepsilon_r$ = 60, $\sigma$ = 0.9$S/m$)). The phantom was equipped with a tube (inner diameter=14mm) to accommodate electro-optical E-field probes (OEFS-S1B, Seikoh Giken, Chiba, Japan). A bow tie building block (f=298MHz) was positioned on top of the ASTM phantom so that the tube was located at a distance of 56mm from the RF antenna as depicted in Figure 1.2c. The RF antenna was matched to S11< -20dB and a parallel resonant circuit cable trap was used to block unwanted RF currents on the cable outer conductors during measurements.

E-field measurements were performed without and with a coronary stent (l=40mm, d=4mm, PRO-Kinetic Energy Cobalt Chromium Coronary Stent System, Biotronik, Bülach, Switzerland) and a stent equivalent (Cu-tube, l=40mm, d=4mm). The device under investigation (DUI) was placed on top of the tube. To maintain a reproducible distance of 2mm between the tube wall and the DUI, a custom built device holder was implemented (Figure 1.2d). The absolute E-field vector was recorded by forwarding the E-field probe along the tube over a distance of 20cm (Figure 1.2e).

Prior to the E-field measurements calibration was carried out to provide an E-field measurement reference which is independent on power losses in the RF chain feeding the antenna. For this purpose a TEM cell was used (Figure 1.2f) with the measured E-field being referred to 1W input peak power.

Numerical thermal simulations

Numerical thermal simulations were conducted using the FDTD solver of SEMCAD X (SPEAG, Zurich, Switzerland) solving equation:

$$c\rho \frac{\partial T}{\partial t} = \nabla k \nabla T + \rho(SAR) \quad (1)$$

with c being the heat capacity ($c_{phantom}$ = 3546$W/kg \cdot K$), $\rho$ the material density, $T$ the temperature and $k$ the thermal conductivity ($k_{phantom}$ = 0.53$W/m \cdot K$). A total input power of 77W was applied to match the effective input power used for the RF heating experiments. RF heating duration was set to 8min.

RF heating experiments

RF heating experiments were performed in a whole body 7.0T MR scanner (Magnetom, Siemens Healthcare, Erlangen, Germany). A rectangular phantom (size: (20x30x12)cm$^3$) was implemented (Figure 1.2g) and filled with a mixture of distilled water, copper sulfate (Cu(II)-$SO_4$, 0.7g/l) and sodium chloride (NaCl, 5g/l). Agarose ($C_{12}H_{18}O_9$, 20.2g/l) was used as a binding agent to avoid thermal convection. The resulting electromagnetic properties ($\varepsilon_r$ = 79, $\sigma$ = 0.8$S$ / m) were reproduced in the EMF and thermal simulation setups. Two small polyethylenterephthalat (PET) tubes (outer diameter=2.8mm) were incorporated into the phantom to accommodate fiber optic temperature probes (Omniflex, Neoptix, Québec, Canada) with a distance of 20mm and 50mm to the phantoms surface (Figure 1.2h). A coronary stent (PRO-Kinetic Energy Cobalt Chromium Coronary Stent System, Biotronik, Bülach, CH) was embedded in the agarose mixture close to the PET tube located at 50mm distance from the phantom's surface. The bow tie building block used for the E-field measurements was placed on top of the phantom, parallel to the long axis of the stent. For RF heating the bow tie building block was operated with a transmit power of 100W for a duration of 8min using an external RF power amplifier (RFPA) (driver: LZY-1, Mini-Circuits, New York, USA; output stage: E10110, ELMACOM, Rome, Italy).

For temperature mapping 2D MR thermometry (MRTh) was conducted at t=2,4,6 and 8min of the RF heating paradigm using a proton resonance frequency (PRF) method and a birdcage volume coil (Basic coil, Siemens, Erlangen, Germany). To compensate for $B_0$ drift a vegetable oil reference was used. To correct for temperature induced changes in electrical conductivity a dual gradient-echo technique (FOV=(300 x 300)mm$^2$, slice thickness=4mm, spatial resolution=(1.6 x 1.6 x 4)mm$^3$, repetition time TR=61 ms, echo times $TE_1$=2.26ms and $TE_2$=6.34ms, receiver bandwidth=898 Hz/pixel, nominal flip angle = 30°, transmit reference voltage = 400V) was implemented.

Human voxel model simulations

To transition from phantom studies using a single bow tie building block to RF coil configurations customized for cardiac MRI at 7.0 T EMF simulations were extended to the *in vivo* human voxel model "Duke" from the virtual family. For this purpose (i) a RF array equipped with four transmit/receive loop elements and (ii) a RF array comprising 8 bow tie dipole antennas was employed. Nine phase settings were applied for each RF coil: $PS_{B1+\ opt}$ optimized for transmission uniformity across the heart and eight randomly generated phase settings (PS1-PS8, Table 1.3) to mimic parallel transmission. $SAR_{1g}$ was mapped for a total accepted input power of 20W with and without the stent equivalent being positioned at two different locations inside the heart of the human voxel model with a distance of the stent to the chest surface of 30mm. Since the stent equivalent was surrounded by vessel wall tissue a conductivity of (0.77 S/m) was used.

Results

Impact of stent geometry and position on SAR

Our EMF simulations showed that a coronary stent induced lower E-field peak values ($|\overline{E}_{abs}|$=xx V/m) than the stent equivalent ($|\overline{E}_{abs}|$=yy V/m) with an average difference of approximately 20% which confirms previous results.

Our EMF simulations provided $SAR_{1g}$ and $SAR_{10g}$ for a broad range of stent configurations. $SAR_{10g}$ was found to level peak SAR at the tip of the stent (Figure 1.3) which caused an apparent reduction by a factor >5 versus peak $SAR_{1g}$. This indicates that the $SAR_{10g}$ approach lacks fidelity and is not appropriate for the assessment of EM induction effects in intracoronary stents.

An increase in the stent length $x_l$ induced a gain in peak $SAR_{1g}$ at the tip of the stent (Figure 1.3a). $SAR_{1g}$ yielded a maximum for $x_l$= 4cm for the investigated range of stent lengths. Stent diameter did not influence $SAR_{1g}$ (Figure 1.3b). $SAR_{1g}$ at the stent tips was largest for a parallel alignment of the stent with the E-field vector (Figure 1.3c). Rotation of the stent out of the E-field vector changes the effective length of the stent in relation to the E-field vector and reduces $SAR_{1g}$. To generalize, the $SAR_{1g}$ peak levels at the tip of the stent were found to be governed by:

$$SAR_{1g}(\gamma) = A \cdot \cos(2\gamma) + B \qquad (2)$$

with $\gamma$ being the rotation angle between the long axis of the stent and the E-field vector and with the stent length dependent normalized coefficients A and B shown in Table 1.2.

Next we studied the relation between stent position with respect to the RF transmission source and SAR. At baseline without a stent being placed in the uniform phantom, $SAR_{1g}$ was found to decrease exponentially with increasing distance between the stent and the bow tie building block (Figure 1.3d). RF exposure in the presence of a coronary stent provided $SAR_{1g}$ peak values being enlarged by a factor ~10 versus baseline (Figure 1.3e). Notwithstanding this gain,

$SAR_{1g}$ showed an exponential decay as a function of depth similar to baseline. This behavior indicates that - alongside with the orientation and length of the stent - the absolute E-field value at any depth is essential for the determination of RF induced $SAR_{1g}$ levels.

The relation between (i) $SAR_{1g}$ peak levels without a stent ($SAR_{1g(w/o)}$) and (ii) maximum $SAR_{1g}$ levels with a stent ($SAR_{1g(/w)}$) are summarized in Figure 1.3f. A linear dependence was observed for $SAR_{1g(/w)}$ versus $SAR_{1g(w/o)}$ with the slope depending on the stent length $x_l$. Taking this observation and equation (2) into account, $SAR_{1g}$ induced by a stent ($SAR_{stent}$) can be described by:

$$SAR_{1g_{stent}}(x_l,\gamma) = 1.71 \cdot SAR_{1g}(\vec{r})_{(w/o)} \cdot (A\cos(2\gamma)+B)\cdot(-0.14x_l^3+1.38x_l^2-1.7x_l+2) \qquad (3)$$

with $SAR_{1g}(\bar{r})_{(w/o)}$ being the local $SAR_{1g}$ at the assumed stent position $\bar{r}$. The last term of equation (3) was retrieved from the slopes of the curves shown in Figure 1.3f. The correction factor 1.71 is introduced to conservatively assume that the stent is completely surrounded by blood which exhibits higher conductivity (1.32 S/m) than muscle and vessel wall tissue (0.77 S/m) and hence would constitute larger SAR levels. To generalize our EMF simulations of discrete stent configurations Figure 1.3g shows $SAR_{1g}$ peak values derived from equation 3 as a function of the stent length and of the orientation of the stent with the E-field vector. Depending on the stent configuration and orientation, induced stent $SAR_{1g}$ peak levels may vary by as much as a factor of approximately 7.

E-field measurements

For validation of the EMF simulations absolute E-field measurements were performed. Without a DUI, E-field measurements showed a good qualitative and quantitative agreement with E-field simulations (Figure 1.4a). E-field simulations provided a maximum $|\bar{E}_{abs}|$ of 19V/m while E-field measurements yielded a (maximum $|\bar{E}_{abs}|$ of 18V/m. A difference of 12.7±6.7% (avg ± std) was found between E-field measurements and simulations. With a DUI the induction effects derived from the EM simulations showed a qualitative agreement with the E-field measurements (Figure 1.4b-c) with an averaged quantitative difference of $\Delta E$=25.3±11.8% (Figure 1.4b). The coronary stent induced lower E-field peak values ($|\bar{E}_{abs}|$=14 V/m) than the stent equivalent ($|\bar{E}_{abs}|$ =18 V/m). The difference of ~22% accords with the difference deduced from our EMF simulations (~20%).

Thermal simulations and MR thermometry

For the RF heating paradigm temperature maps derived from thermal simulations correlated well with MRTh (Figure 1.5). After 8min of RF heating thermal simulations and MRTh showed a temperature increase of $\Delta T$>15C° in the agarose phantom for a position located 20mm below the RF antenna building block (Figure 1.5a-b). For comparison fiber optic temperature measurements are shown in Figure 1.6. After 2min of RF heating, the highest temperature elevation of $\Delta T_{MRTh}$=3.2C° ($\Delta T_{Fiber}$=3.0C°) was not found for a region interfacing with the stent (slice *II-III* in Figure 1.2f) but for the slice located in closest distance to the RF antenna (slice *II* in Figure 1.2f). At this time point, the stent tip exhibited a temperature increase of $\Delta T_{MRTh}$=2.0C° ($\Delta T_{Fiber}$=1.8C°). With progression of the RF heating paradigm maximum temperature elevations were still dominated by surface regions close to the RF antenna which showed a temperature increase of up to $\Delta T_{MRTh}$=15.8C° ($\Delta T_{Fiber}$=15.2C°, $\Delta T_{Simu}$=15.2C°) after 8min. In comparison, the stent tip exhibited a temperature increase of only $\Delta T_{MRTh}$=5.7C° ($\Delta T_{Fiber}$=5.1 C°). It should be noted that immediately after onset of RF power transmission ($P_{in}$=77W) the maximum temperature elevations were found at the stent tip (Figure 1.6) where the maximum induced power deposition levels ($SAR_{1g\,(stent\,tip)}$=264W/kg) were higher than in surface regions ($SAR_{1g\,(slice\,1)}$=117W/kg). The temperature profile of the fiber optic probe located in slice I followed a linear increase with time (Figure 1.6). The temperature profile at the tip of the stent showed a saturation curve, since heat is dissipated from the stent tips due to a high thermal conductivity of the stent ($k_{stent}$=9.4W/K/m) vs. the tissue or phantom material ($k_{phantom}$=0.53W/K/m). At t=80s of the RF heating paradigm (Figure 1.6) a transition point appeared between a stent heating dominated regime (t<80s) and a surface heating dominated regime (t>80s). This transition point is governed by the thermal conductivity of the stent as well as by arterial blood flow and allows for higher overall $SAR_{stent}$ levels with maintaining same temperature elevation levels for a 6min averaging time.

Human voxel model simulations

To approach a clinical setup, an in vivo human voxel model and RF coil arrays designed for cardiac MRI at 7.0T were included with the goal to benchmark EMF simulations with the analytical approach (equation (2)).

$SAR_{1g}$ obtained for the two transceiver arrays is surveyed in Figure 1.7. First we investigated $SAR_{1g}$ for the

phase settings $PS_{B1+-opt}$ (Table 1.3). Without positioning the stent equivalent in the upper torso $PS_{Bi+_opt}$ revealed a maximum $SAR_{1g}$ of 10.6W/kg for the RF loop coil array (Figure 1.7b) and 13.4W/kg (Figure 1.7f) for the bow tie array (). For the location designated for accommodating the stent $SAR_{1g}$ of 5.6W/kg (RF loop array, Figure 1.7c) and 0.4W/kg (bow tie array, Figure 1.7g) were observed. In comparison, with the stent equivalent being positioned at its target position in the upper torso close to the anterior chest wall, $SAR_{1g}$ at stent location increased to 43W/kg (Figure 1.7d) for the RF loop coil and to 2.4W/kg (Figure 1.7h) for the bow tie array. These results accord with the analytical estimation which yielded 47W/kg for the RF loop coil and 3W/kg for the bow tie array.

Next we examined peak $SAR_{1g}$ for the randomized phase settings PS1-PS8 (Table 1.3). For the 8 randomized phase settings maximum $SAR_{1g}$ obtained for the RF loop coil increased by a factor of >4 when including the stent with the stent tips being the hot spots as demonstrated in Figure 1.7i. Five out of the 8 randomized phase settings used for the 4-channel TX/RX loop coil array exceeded baseline SAR of the RF coil and the local SAR limit of 20W/kg (Figure 1.7i). In comparison, maximum local $SAR_{1g}$ for the bow tie array was not affected by the placement of a stent for all investigated phase settings as demonstrated in Figure 1.7j.

Discussion

En route to broader clinical UHF-MR studies this work scrutinized RF induced heating of intracoronary stent geometries commonly used in clinical practice. While covering a broad spectrum of stent configurations our EMF simulations demonstrated elevated E-field, SAR and temperature at the stent tips.

Our findings helped to derive an analytical estimation which describes $SAR_{1g}$ induced by an arbitrary intracoronary stent interfering with E-fields generated by an arbitrary RF coil configuration. The analytical approach was benchmarked against EMF simulations and showed a good conservative estimation of induced $SAR_{1g}$ peak levels without the need of performing simulations with the stent integrated in the in vivo human voxel model. Our practical examples of RF coil arrays optimized for cardiac MR at 7.0 T underscore the value of the proposed analytical approach for obeying regulatory RF power limits. For phase settings mimicking $B_1$+-shimming or parallel transmit applications, our proposed SAR estimation sufficiently detected if stent local $SAR_{1g}$ (i) exceeded local SAR limits of 20W/kg or (ii) was below baseline RF power deposition of the RF coil. To generalize, this approach provides a novel metric or design criterion for RF coils and conducting passive medical implants. Our approach can be incorporated into state-of-the art SAR prediction concepts to provide SAR estimations induced by coronary stents for arbitrary RF pulses used for transmission field shimming or parallel transmission.

Our study adds to the current literature since EMF simulations of intracoronary stents at 298MHz were for the first time validated and confirmed by E-field measurements. Our thermal simulations and RF heating experiments provided evidence that surface heating rather than stent heating dictates the maximum temperature increase during a 6min constant application of RF power and a stent positioned at a distance of 5cm from the RF antenna. This finding challenges the common notion that an increase in scan duration pronounces the risk for myocardial tissue damage due to RF induced heating in stents. Immediately after onset of RF transmission the stent tip follows a saturation curve, since the stent itself acts as a heat sink removing temperature from the stent tips due to an increased thermal conductivity compared to tissue. While important, this saturation effect leads to a transition point, which relaxes some of the SAR constraints dictated by current safety guidelines. Notwithstanding higher stent SAR values of as much as 230% compared to surface regions, our particular example demonstrated, that after 80s of RF heating surface heating surpasses stent SAR heating. While important, these findings underline the importance to inspire further research into temperature modelling instead of SAR modelling, suggesting a thermal tissue damage.

To conclude, our findings can be translated to any patient, intracoronary stent type, RF coil configuration and RF transmission regime. Our methodology of a generalized approach to estimate SAR levels, while being backed up by multimodal measurements, may be of value for RF heating investigations of other passive electrically conductive implants. This benefit would be in positive alignment with the needs of explorations that are designed to examine the potential of UHF-MRI for diagnostic imaging.

Introduction

Magnetic resonance imaging (MRI) is of proven diagnostic value with an ever growing number of applications. High soft tissue contrast can be achieved non-invasively without the use of ionizing radiation. In MRI radiofrequency (RF) fields are applied together with a static magnetic field to exploit the nuclear magnetic resonance (NMR) effect for imaging. Current clinical MR systems are operated at a magnetic field strength of up to $B_0$ = 3.0T. More recent research endeavors successfully demonstrated the feasibility of ultrahigh field (UHF) MRI at field strengths $B_0 \geq 7.0T$ [1]. Higher signal-to-noise-ratios (SNR) of UHF MR offer the potential for improved image quality by means of higher spatial and/or temporal resolution, which can be translated into clinical benefits for diagnosis and therapy monitoring of neurological and cardiovascular diseases [10-12]. Since the spin excitation frequency is increased for UHF MRI, the short RF wavelength leads to complex electromagnetic field distributions inside the human body. The RF energy is deposited unequally and local specific absorption rate (SAR) hotspots need to be investigated for safe exposure limits [2, 3]. Additionally, interactions of RF fields with conductive medical implants may potentially lead to high local energy deposition causing temperature elevations above the limits given by the guidelines of the International Electrotechnical Commission (IEC) [3]. In particular, for cardiac MRI (CMR), a detailed research into electromagnetic interactions with coronary stents is needed. Coronary stents play an important role as one of the main treatments for coronary artery disease.

They commonly consist of a metallic mesh with a length of several centimeters and a diameter of few millimeters to reinforce coronary vessel walls. Up to date, only a single scientific study conducted in-depth research into RF heating of a specific coronary stent design at 7.0 T. This work demonstrated that coronary stents might not exceed temperature elevations above currently proposed safety guidelines [4]. However more detailed investigations are essential to explore and estimate electromagnetic induction effects for a broad range of stent configurations and RF coils used.

This study details RF power deposition alterations by the presence of coronary stents in UHF CMR. For this purpose electromagnetic field (EMF) simulations, temperature simulations, E-field measurements, RF heating paradigms, MR thermometry and fiber optic temperature measurements are conducted. Acquired simulation models are used to reduce the complexity of the broad spectrum of stent designs and to elaborate on the RF interactions of these stent types under large range of electrophysical circumstances including stent geometries, patient anatomies and stent locations. This research is designed to facilitate a systematic approach to a priori estimation of SAR levels due to the presence of stent, based upon an estimated tissue dependent temperature increase that includes physiological parameters like blood flow or restenosis of the stented blood vessel. To validate the results obtained in the numerical EMF simulations, electric field measurements are conducted using standardized American Society for Testing and Materials (ASTM) phantoms [6] and calibrated E-field measurement probes. RF heating experiments are performed with home-built phantoms mimicking the electromagnetic and thermal properties of tissue which were benchmarked versus fiber optic temperature probe measurements and 2D MR thermometry. All these efforts afford a qualitative and quantitative comparison between numerical simulations and reality and help to gain a better understanding of the physics behind the complex electromagnetic RF induction phenomena in coronary stents.

The results obtained throughout this study are an important precursor for scientists and clinicians in the field of UHF CMR at 7.0T in order to move towards reasonable RF power exposure limits in patients equipped with conductive intracoronary stents.

## MR Basics

### Nuclear Magnetic Resonance (NMR)

In NMR, protons are seen as rotating charged particles. For nuclei in which the nucleon spins sum up to a resulting spin different from 0, this leads to a magnetic dipole moment $\mu$ that can be described as

$$\vec{\mu} = \gamma \cdot \vec{L}\,, \tag{2.1}$$

where L is the angular momentum of the rotation and $\gamma$ is the gyromagnetic ratio. When a nucleus with a magnetic moment is exposed to an external static magnetic field that is not aligned with its magnetic moment, a precession movement begins, $\mu$ rotates around $\overline{B_0}$ with a constant angular velocity and a fixed angle $\alpha$ between $\mu$ and $\overline{B_0}$. The frequency depends on the gyromagnetic ratio $\gamma$ of the nucleus and the magnetic field strength $B_0$:

$$\omega_0 = \frac{\mu \cdot B \cdot \sin\alpha}{L \cdot \sin\alpha} = \frac{\mu B_0}{L} = \gamma B_0\ . \tag{2.2}$$

The precession frequency depends only on the nucleus and the applied magnetic field but not on the angle enclosed by $\mu$ and $\overline{B_0}$. It is called Larmor frequency and is most often referred to as the angular frequency $\omega_0$. The fact that the value of $\gamma$ is characteristic to a chemical element is one of the basic principles of MRI: frequency selection for the RF pulses is equivalent to isotop selection for imaging. Table 2.1 gives an overview over some of the most commonly exploited nuclei in MRI, their gyromagnetic ratio and the resulting frequency for certain field strengths. Please note that these frequencies were divided by $2\pi$ in order to express the values in MHz.

In a homogenous magnetic field, all spins rotate with the same angular velocity. This is the basis for the introduction of a rotating frame that revolves with the same angular speed as the spins in order to facilitate the description of the movement: in the rotating frame at $\omega_0$ the precession is invisible.In MRI, the coordinate system is chosen in such

manner that the z-axis is aligned with the homogeneous field in the scanner core. This means that the rotation takes place around the z-axis and so the rotating frame is defined with an equivalent z-axis as the static frame but rotates in the x-y plane, as shown in Figure 2.1 [13].

In horizontal MRI magnets used for clinical imaging, the axis of the imaging frame are named with respect to the patient's body: the z-axis is called H-F (Head <-> Feet) and the x- and y-axis are referred to as L-R (Left<->Right) and A-P (Anterior <-> Posterior) respectively.

Magnetic Resonance Imaging (MRI)

The fact that all spins rotate at the same frequency in a homogeneous magnetic field renders spatial differentiation between spin locations unfeasible; for an external observer who is only able to measure the frequency, the spins distributed across a sample or body look all the same. To lift this ambiguity, a field gradient can be applied to change the resonance frequency depending on the position of the spin in the gradient field [14]. For this spatial encoding, different names are given to the technique depending on the instant of time in the sequence of excitation, encoding and readout at which the gradient is applied.

Slice Encoding

With the correct combination of gradients, it is possible to choose an arbitrary imaging plane, which does not need to be aligned with the xyz-axis. This is particularly valuable in cardiovascular imaging in order to obtain a slice through all chambers of the heart (4-*chamber view*) but also for other diagnostic questions. In this section however, spatial encoding is explained in the orthogonal coordinate system for reasons of simplicity.

The resolution along the z-axis can be implemented in two different ways depending on the desired display of the investigated region:

Multi Slice 2D Imaging

The conventional MRI displays the imaged region as a stack of consecutive slices through the volume. This is enabled by applying a constant gradient $G_z$ along the z-axis. This is called "slice selective gradient" because by varying the gradient, the precession frequency of the protons can be manipulated for a specific slice at a given location, as shown in Figure 2.2. When applying a broadband excitation pulse, the resonance conditions will only be met for the selected slice of a given thickness:

$$\omega = \gamma \cdot B = \gamma \cdot (B_0 + G_z \cdot z) = \omega_0 + \gamma G_z z \,. \tag{2.3}$$

3D Imaging

Three dimensional display of the examined region, i.e. continuous spatial resolution vs. discrete slices, is of great interest for particular applications. This can be obtained by exciting the entire volume of interest and using the same phase encoding technique as for the spatial encoding in y-direction, see section 0 for more details.

Phase Encoding

Obtaining a spatial resolution in the y-direction is commonly referred to as "phase encoding". Here, the gradient $G_y$ is applied after the excitation pulse but before the image acquisition. Again, the additional magnetic field induces a change in precession frequency of the concerned spins. Spins in the region of positive additional field are accelerated; spins in the negative region are slowed down. This means that after applying the gradient for a certain time, the rotation angle of the spins is different; some spins will thus need longer to relax back to equilibrium than others. This difference can be measured and translated into spatial resolution in y-direction.

Frequency Encoding

The gradient in x-direction is called "frequency encoding" and sometimes also referred to as read-out gradient. As the name suggests, the gradient $G_x$ is turned on during image acquisition. Spins will precess with different frequencies depending on their location on the x-axis, the spectrum can then provide spatial information. This sequential arrangement needs to be repeated for every phase encoded line, it is thus the number of phase encoding steps that governs the

image acquisition time.

Radiofrequency (RF) Pulses in Magnetic Resonance Imaging

As long as the spins precess in a static magnetic field with no external influence, the movement is infinite with the same angular velocity and the same precession angle $\alpha$. But as one can easily understand, this is not ample for medical imaging. To create a change in the precession that can be detected, a rotating alternating field $\overrightarrow{B_1^+}$ is applied transversal to $\overline{B_0}$ in order to deflect the magnetic dipole moment out of its equilibrium.

$$B_{1x}^+ = B_1^+ \cdot \cos \omega_T t, \qquad (2.4)$$

$$B_{1y}^+ = B_1^+ \cdot \sin \omega_T t. \qquad (2.5)$$

This happens if and only if the frequency of the rotating field matches the precession frequency $\omega_T = \omega_0$. In this case, the magnetic moment moves out of the equilibrium with a spiral movement as shown in Figure 2.3 [13], the angle $\alpha$ between $\mu$ and B changes with an angular velocity of

$$\omega_F = \frac{d\alpha}{dt} = \gamma \cdot B_1^+, \qquad \alpha = \gamma \cdot B_1^+ \cdot \tau. \qquad (2.6)$$

This shows that a transversal field pulse with small amplitude applied for a rather long time will finally lead to the same flip angle as a short pulse of higher amplitude. In order to always match the resonance frequency of the spins, the frequency of the alternating field necessarily increases with the static magnetic field strength $B_0$. At 7T, the frequency amounts to $f_0$ = 298.2 MHz for protons, the center frequency of the pulses used for excitation falls into the radio frequency region, suggesting the denotation "RF pulses".

For the human body with its heterogeneous spin densities, characteristic relaxation times can be found, induced by different tissue types or different pulse and gradient sequences (short: imaging techniques). Thus a multitude of different contrasts can be obtained, adjustable to the diagnostic question. The soft tissue contrast is further enhanced by the chemical shift of the characteristic proton resonance frequency with changing chemical environment. Different molecular constitution of the tissue influences the effective local magnetic field acting upon the investigated water protons.

Ultra High Field (UHF) MRI

While clinical routine is still based on MRI at low (1.5T) or high (3T) magnetic fields, forefront MR research has progressed to Ultra High Field MRI at 7T. The motivations are numerous: gains in signal-to-noise ratio (SNR) and contrast-to-noise ratio (CNR) are driving forces on the imaging side while higher imaging speed and efficiency are of interest for patients and clinicians to track dynamic processes such as contraction and relaxation of the heart [15]. However the advantage of an increased spatial and temporal resolution does not come at no cost. Challenges in RF coil design and safety measures present major technical and physics related challenges which need to be solved by the UHF MRI community. Examples of key challenges and state of the art solutions are presented in the following sections.

Challenges for Radiofrequency (RF) Coil Design for UHF MRI

One of the most significant changes when advancing from lower field strengths to UHF MRI at 7T is the change in frequency. This is of course also of major influence for the RF coil design because it translates into a dramatic decrease of wavelength of the RF signal. The wavelength in the body is approximately $\lambda \approx 60$ cm at 1.5T and $\lambda \approx 30$ cm at 3T respectively, assuming an averaged relative tissue permittivity of $\varepsilon = 60$ and no losses. For 1.5T and 3T, the values are large compared to the size of the targeted volume, enabling a rather homogeneous excitation throughout the region of interest. Interference of the excitation waves plays a minor role. At 7T, the wavelength decreases further down to $\lambda \approx$ 13 cm and is thus in the range of the dimensions of the region of interest for Cardiac MRI (CMR). This can lead to inhomogeneous RF interference patterns within the field of view (FOV) and results in a decreasing image quality. Destructive interference in particular is very undesirable because the regional $B_1^+$ cancellations lead to reduced (or even zero) spin excitation and will be visible as signal voids in the image.

1.5T and 3T scanners are commonly equipped with a whole body RF coil usually designed as a birdcage volume resonator that is already integrated in the scanner. Due to the aforementioned relationship of wavelengths and body dimensions, at these field strengths a large volume may be excited rather homogeneously using this particular RF coil design. In order to gain the maximum SNR, local RF receive coils have been developed to ensure a high sensitivity for the provided signal adapted to the different imaging regions. Consequently, RF volume coils are being used for transmission and local multi-channel receive RF coils for reception as the gold standard for clinical ($B_0 \leq 3T$) MRI. At 7T however, a volume resonator is inefficient in a standard operational mode (linear or quadrature) to provide a sufficiently homogenous transmit field ($B_1^+$) over the imaging region of interest and alternative solutions need to be developed. These solutions come along in form of local RF multichannel transmit/receive coil arrays [16-19]. The additional degree of freedom to change the phase delay between multiple transmit channels enables a modification of the pattern of interference and can be utilized to prevent destructive interferences in the targeted imaging zone, Figure 3.1 [16].

Ultrahigh Field Cardiac MRI

For CMR, a specific RF coil design developed at B.U.F.F. uses an array of 16 bow tie antennas [20] as an alternative to RF coils equipped with loop elements [21]. Bow tie antennas are $\lambda/2$ dipole antennas made of two symmetrical triangles, used for transmission and reception of the RF signal. Their size depends on the targeted frequency and can be reduced by placing the dipole in a high dielectric medium. For example heavy water is used to avoid a MR signal from the surrounding medium, due to a different gyromagnetic ratio yielding a different resonance frequency. The dielectric medium with a high refractive index leads to a shortening of the wavelength and the length of the $\lambda/2$ dipole, allowing smaller building blocks (150 x 70 x 40 $mm^3$ inner dimensions) and thus easier setup of a multichannel array. Figure 3.2 depicts the model of the bow tie antenna building block with the dimensions of interest [20]. Bow tie antennas provide a rather large region of homogeneous field distribution and a higher $B1^+$ penetration depth within the body, due to a Poynting vector directed towards the tissue. For our scenario, this holds the advantage of a well-defined orientation of the E-field lines in the region below the antenna, which allows the placement of a stent analog in a known orientation towards the field lines. Specifically parallel alignment of a stent to the E-field vector transmitted by the RF antennas induces additional RF fields in the stent equivalent, which are being investigated throughout this study. The results obtained from such a scenario can be easily transferred to other RF antennas or RF coil configurations.

To enhance the RF antenna's transmission performance, a matching & tuning network is conneted to the feeding point of the dipole. Consisting of two highly voltage-rated nonmagnetic trimmers, one connected parallel, the second connected in series, it allows the adjustment of the dipole's scatter parameter $S_{11}$. The S-parameter, as shown in equation 3.1, is quantified by the ratio between the power reflected by the phantom and the antenna (if poorly tuned) and the input power emitted by the RF generator. Using two variable capacitances enables the optimization of the antenna's transmission with respect to a targeted center frequency and a given phantom or body region. Matching and tuning further offers the possibility to adjust the bandwidth of the $S_{11}$ peak. Figure 3.3 shows typical $S_{11}$ magnitude plots [dB] of a bow tie electric dipole antenna when tuned to 297 MHz.

$$S_{11} = 10 \log \frac{P_{refl}}{P_{in}} \qquad (3.1)$$

A bow tie dipole antenna is characterized by its broad bandwidth, when compared to a rectangular strip dipole [20]. By this, a trade-off between a very good adjustment to the center frequency (297 MHz at 7T, Figure 3.3 a) and a good adjustment covering a frequency range of a couple of MHz around the center frequency (Figure 3.3 b) can be made. In MRI, this holds the advantage of a more constant antenna performance despite anatomical differences of changing imaging subjects [20].

MR Safety - RF Power Deposition

Another challenge at higher field strength are the RF power deposition constraints to prevent tissue heating [20]. With increasing frequency (128 MHZ at 3T to 300 MHz at 7T), a lower $B_1^+$ is achieved for a given power deposition limit [1]. In order to obtain the same excitation field at 7T, the input power needs to be increased, holding the risk of locally high power depositions in the body. In conductive tissue, the radiated power induces eddy currents which are usually rapidly attenuated whilst the power is deposited in the surrounding tissue and leads to an increase in temperature [23]. The quantity to describe this phenomenon is the specific absorption rate (SAR) that indicates the absorbed power in a certain volume with a given density $\rho$ and electrical conductivity $\sigma$ over a certain period of time.

$$\mathrm{SAR} = \frac{\sigma\,|\vec{E}^2|}{2\,\rho} \qquad (3.2)$$

In the microwave frequency range, the predominant energy absorption is due to the absolute value of the electric field vector that scales SAR quadratically. Due to the short wavelength regime, the RF field inhomogeneities at ultrahigh fields and heterogeneous electromagnetic tissue properties, large spatial differences in energy deposition can be found.

It is important to examine and quantify the absorbed power in tissue because the resulting heating can lead to tissue damage and can occur either on the surface but also deep in the targeted volume [23]. SAR investigations are thus of major importance in patient safety regulations and play a pivotal role in the development of new RF coil designs. The limits for clinical approval are given by the International Electrotechnical Commission (IEC). Three different values are specified: the local SAR that indicates the value averaged over a 10 g volume, the partial body SAR that averages over the volume enclosed by the RF coil and the whole body SAR specifying the limits for the total power absorption inside the whole human body. Further on, the limits for the Normal Mode and the First Level Controlled Mode are differentiated. Both mode realizations are clinically approved but the second mode requires more safety measures taken by the working personnel during the examination, such as monitoring the patient with pulse oximetry [3]. Table 3.1 summarizes the different safety limits for both scenarios.

Up to now SAR assessment is the gold standard for safe power deposition levels of RF coils designed for MRI [3]. In order to approach the temperature distribution induced by the absorbed power, average SAR has been introduced [24]. The temperature distribution does not necessarily follow the same pattern as the E-field. Judging from a peak SAR occurring in a small region only, high impact in the tissue might be expected. However, due to thermal conductivity and diffusion, the heating is less severe than assumed but affects a larger region than point SAR would suggest. To account for this expansion, an averaging volume has been proposed, that should be used for SAR calculation, inducing an artificial smearing of the SAR distribution and thus approaching the thermal behavior. Different institutions suggest different volumes [3, 6], most commonly used is the "mass-based"-approach, calculating SAR in a cube with a mass of 1g or 10g, yielding a density dependent edge length.

SAR might result in a temperature increase in tissue, which can be approximated by the simple relation [25]

$$\Delta \mathrm{T} = \frac{\mathrm{SAR} \cdot \Delta t_{\mathrm{RF}}}{c_p}, \qquad (3.3)$$

where $\Delta t_{RF}$ is the duration of the RF pulse and $c_p$ the specific heat capacity of the irradiated tissue. Thermal diffusion as well as other effects like the basal metabolic rate or blood flow has been neglected at this point. Compared to EMF simulations, temperature simulations require many more parameters, which are difficult to estimate like time-dependent tissue perfusion curves. However, realizing the need for temperature estimations in MRI, the simulation environments are becoming more sophisticated and might one day be used for direct investigations following new guidelines. First temperature limits are already included in the IEC guidelines such as the maximum temperature rise of $\Delta T$ = 1 K for small local RF head coils [3].

MR Safety - Implants

Scanning a patient with an implanted electroconductive device requires additional safety evaluations. Different types of implants request different safety considerations.

Safety hazards caused by the static magnetic field $B_0$ (e.g. in the presence of ferromagnetic objects) or the gradient field $B_1{}^+$ are well known and can be easily prevented by attentive working personnel. However, safety precautions get more complicated as soon as a metallic device is not superficial but embedded in the patient's body - as is frequently the case for medical implants. Eddy currents are induced by the applied RF field in the conductive part of the implant and can cause tissue heating and burns. Multiple studies have been conducted to investigate the MR safety of different implants [26], such as RF stent heating for 1T [27], 1.5T [28-30] and 3T [31]. At 7T, first results concerning the safety of coronary stents were published recently [4], however the relative lack of data at 7T asks for more research into RF induced heating at 7.0 T including a more detailed analysis of this subject. A (growing) number of investigations on the safety of conductive implants (such as dental wires [32] and cranial plates [33]) at 7T underline the relevance of studying RF related interactions.

The aforementioned safety considerations for metallic implants hold true for coronary stents as well. In addition, another factor comes into play in our investigated scenario. Due to the shortened wavelength at ultrahigh fields, the geometry of the stents and their high electric conductivity can cause a RF antenna effect. Approximated as a wire dipole

antenna, stents can efficiently capture the high energy RF pulses and radiate back into the tissue, being most sensitive to the electric component of the RF radiation. Especially at 7T, these effects can be very strong due to additional heating that can occur when implant dimensions reach a quarter of the RF wavelength in the tissue [6]. For a wavelength of $\lambda$ = 13 cm and stents of lengths around l = 4 cm, this is easily the case and may result in damaging surrounding tissue. To address this topic, this study investigates SAR and temperature behavior of coronary stents in the presence of RF fields generated by RF coils used for UHF MRI.

Electrodynamic Interactions of Coronary Stents at 7T MRI

Cardiovascular MRI offers great potential to profit from an increase in SNR inherent to UHF; the possibilities of UHF CMR may potentially include the differentiation between reversible and irreversible myocardial injuries or the detection of inflammatory and ischemic disorders and their differentiation [15], to name only two of the potential diagnostic options. In the aging population, more and more patients suffer from coronary artery disease (CAD) and are treated with the placement of a coronary stent [5]. Even though biodegradable stents are entering the market, their number of implantations has not yet overcome metallic stents [34]. But more importantly, patients that have already undergone a stent surgery and have been treated with a non-biodegradable stent are currently voluntarily excluded from UHF MRI at B.U.F.F. by reasons of unknown safety conditions in the presence of an implanted conductive intra-coronary stent.

At the B.U.F.F., this is the driving force for detailing the RF induced heating of stents which will be presented in detail in the following sections.

Previous Work

First results regarding the electromagnetic behavior of coronary stents at 7T MR frequencies have already been performed[4]. For this purpose, high resolution EMF simulations using CST Microwave Studio (CST Studio Suite 2011, CST GmbH, Darmstadt, Germany) were conducted to depict small details in the field distribution around a coronary stent. Therefore, a CAD model with a length of l = 4 cm, an outer diameter of $d_{out}$ = 4 mm and a wall thickness of t = 100 $\mu$m provided by the manufacturer (PRO-Kinetic Energy Cobalt Chromium Coronary Stent System, Biotronik, Bülach, CH) was simulated in a phantom mimicking myocardial tissue. As shown in Figure 4.1 [4], results described a very similar behavior to a copper tube of the same dimensions.

As expected, both show a very prominent antenna effect with the highest field values at their tips revealing a more elevated maximum for the copper tube. Using the latter as a stent equivalent may thus be a valid estimate for the broad spectrum of stent mesh geometries faced due to the different designs provided by the multitude of manufacturers. In further simulations, this similarity can be used to decrease the complexity of the model and simulation time. The results were obtained for a RF birdcage coil, especially designed for RF heating experiments, with the RF power exceeding clinical limits by a factor of seven. For all simulations and measurements, the stent or the tube was positioned in such a way that the long axis was parallel to the electric field lines in order to maximize the interaction [35]. Thermal convection and heat exchange due to blood perfusion in the vessel were neglected; these values can thus be seen as a worst-case approximation to the problem. Nevertheless, it was found that the additional heating caused by the stent only added another $\Delta T$ = 3K to the $\Delta T$ = 27K baseline heating of the empty phantom. These values were obtained using MR thermometry and fiber optic control measurements with the same setup as used for the simulations. This comparatively low local heating effect of the stent indicates that RF induced heating may not exceed the safety limits when the RF power is applied according to clinical limits.

Concept of this Study

The aim of this study is to further investigate various stent geometries, stent orientations with respect to the E-field vector and stent positions with regard to its EM induction effects as well as related temperature distributions. For this purpose, a multi-step analysis is performed, consisting of the investigation of different simulation setups and some measurements for validation. Values of interest are the E-field distribution, the SAR and the temperature increase in the tissue surrounding the stent equivalent. The different steps are as followed and will be further detailed in the upcoming subsections:

1. EMF simulations using a simple rectangular and homogeneous phantom, a single bow tie dipole antenna and various configurations for the stent equivalent

2. Temperature simulations in a homogeneous phantom and in the presence of a blood vessel and blood flow

3. EMF simulations using a single bow tie antenna and an ASTM-Phantom [6]

4. Validation measurements using an experimental setup (E-Field sensor measurements) which resembles the one used in the simulations

5. Thermal simulations of a homogeneous phantom with and without stent and validation measurements using the same setup (MR thermometry and fiber optic temperature measurement)

EMF Simulations

The main set of EMF simulations is designed to evaluate the influence of geometry and positioning of the stent equivalent on the field distribution and the induced SAR.

This part of the study is intended to simulate stent positioning close to clinical reality. Therefore, multiple coronary stent studies [7-9] were evaluated in regards of stent size (length and diameter) and the distribution of the lesions within the main coronary arteries affected by coronary lesions (Left Main Artery (LMA), Left Anterior Descending artery (LAD), Left Circumflex (LCX) and Right Coronary Artery (RCA)). Table 4.1 provides a survey on the clinical stent configurations.. Based on a coronary CT, an approximation for the location of the arteries LAD, LCX and RCA with respect to the torso surface was made and found to be d(LAD) = 5 cm, d(LCX) = 8 cm and d(RCA) = 12 cm.

Based on the stent configurations derived from literature and presented in Table 5.1, EMF simulations were conducted and the respective SAR values were calculated.

Thermal Simulations

Thermal simulations are conducted to quantify the temperature rise of the tissue during MRI caused by the RF pulses and the additional heating induced by the RF antenna effect in the presence of a coronary stent equivalent. First, EMF simulations are run in order to obtain the point SAR distribution then leading to a temperature increase in a further simulation. Yet another step towards the approximation of a clinical scenario is including a blood vessel in the simulation model. Based on a literature review [36], the values presented in Table 4.2 were assigned to the dielectric and thermal properties of blood and blood vessel wall, the arterial wall thickness and the blood flow in coronary arteries. The blood vessel diameter of coronary arteries was found to be in the range of 4 mm at the proximal segment, narrowing to about 2 mm at the distal segment [37]. In agreement with these findings, the reference stent equivalent size of 4 mm outer diameter (i.e. inner diameter of the blood vessel) was maintained for blood flow simulations. In order to represent the broad range of CAD severity and vessel occlusion [38] in patients undergoing CMR before or after stent placement, flow simulations were executed mimicking a stenosis of 20, 40, 60, 80, 90 and 100% of the vessel cross section by adjusting the diameter of the actual blood flow area, maintaining the same vessel flow rate.

ASTM - Phantom Field Validation Measurements

The second part of this study consists of validation measurements. First, the results of EMF simulations are to be compared with measurements to validate the qualitative and quantitative agreement using an ASTM - phantom [6]. This is an internationally acknowledged phantom approximating the human torso and head for (MR related) heating experiments, proposed by ASTM International (former American Society for Testing and Material) [6]. Validation measurements will be conducted using a single bow tie antenna and simulations will be run with the same setup.

Temperature Validation Measurements

The thermal simulation results will be validated in an experimental setup using a rectangular phantom (dimensions 20 cm x 30 cm x 12 cm) first in an empty phantom and secondly in the presence of a 4 cm stent (PRO-Kinetic Energy Cobalt Chromium Coronary Stent System, Biotronik, Bülach, CH). The experiments will be carried out using a single bow tie antenna. MR thermometry and optic fiber sensors will be used to validate the simulation results. Former MR thermometry experiments showed good qualitative agreement of the field distribution derived from simulations with the temperature distribution in the experimental setup [20]. A quantitative data comparison between simulations and experiment expects to show higher temperature values in the simulations because the losses within the antenna material and components are not taken into account in the simulations.

Simulation Studies

Electromagnetic Field (EMF) Simulations

Introduction and Simulation Model

Electromagnetic field simulations are being performed solving Maxwell's curl equations [47]:

$$\nabla \times \vec{H} = \frac{\partial}{\partial t}\varepsilon\vec{E} + \sigma\vec{E} \qquad (5.1)$$

$$\nabla \times \vec{E} = -\frac{\partial}{\partial t}\mu\vec{H} - \sigma_H\vec{H} \qquad (5.2)$$

where $\sigma$ and $\sigma_H$ are the electrical and magnetic losses. Several different techniques exist for the solution of these equations such as the Method of Moments (MOM), the

Finite Element Method (FEM), the Finite Difference Time Domain (FDTD) and Finite Integration Technique (FIT). The simulation software chosen for this project (SEMCAD X, SPEAG, Zurich, Switzerland) uses FDTD [48], the explanations in this section will thus be limited to this technique.

The FDTD solver is based on numerical solutions of Maxwell's equations using finite time steps of the length $\Delta t$; Maxwell's equations are then solved for finite differences within each voxel of the pre-defined mesh. After such spatial and temporal discretization, the electrical voltage on the edges of the voxel and the magnetic flux through its faces is being computed, as shown in Figure 5.1.

Since the values of the electric field are depending on a curl of magnetic field and vice versa, a single mesh is not sufficient and a dual mesh is introduced as illustrated in Figure 5.1. The second grid G has the same mesh size as G and is shifted half a space diagonal. As shown in Figure 5.1, this causes a match for the face centers of G with the middle of the edges of G, the fields can thus be calculated at the same point. According to the first proposal of this method, these cells are called Yee *cells* [49]. By using these two grids together, the electric and magnetic field can be calculated at every point in the model if a) the initial conditions for $\overline{E}$ and $\overline{B}$ are known at t = 0 and b) if the mesh size and time steps are small enough. The dependency between $\Delta t$ and the spatial resolution is given by [47]

$$\Delta t = \frac{1}{c\sqrt{\frac{1}{(\Delta x)^2}+\frac{1}{(\Delta y)^2}+\frac{1}{(\Delta z)^2}}}; \qquad (5.3)$$

a bisection of a cell in a uniform grid will thus increase the calculation time by a factor of 16 and the storage space by a factor of 8. In non-uniform grids, the impact on the storage requirements is not as high but the time step still has to be chosen accordingly to the smallest mesh step, overall simulation time is thus governed by the smallest cell in the model. The initial conditions are generally non-existing fields at t = 0 and a well-defined field distribution in the voxels assigned to the power source. The fields can then be calculated for every point and time step in the defined scenario.

Simulation Model

The simulation model used throughout this work consisted of a single bowtie electric dipole antenna immersed in high permittivity ($\varepsilon$ = 80) dielectric deionized water [20]. The RF antenna was operated at a frequency of 297 MHz and its characteristic E-field distribution was calculated and evaluated inside a tissue mimicking phantom. These results form the basis for $SAR_{1g}$ and $SAR_{10g}$ calculations as well as temperature simulations with and without stent equivalent. The phantom used for the simulations is a rectangular box with a surface area of 20 cm x 30 cm. The height was adjusted for the different depths positions of a copper tube within the phantom setup. Two configurations were chosen, a height of h = 8 cm (as depicted in Figure 5.2) for the first set of simulations regarding the stent equivalent's orientation, diameter and length and of h = 16 cm for the varying distance of the copper tube in relation to the transmitting antenna element.

From now on, these models will be referred to as "the 8 cm phantom" or "the 16 cm phantom" respectively. The shell of the phantom is modeled as Plexiglas with a thickness of 3 mm (Figure 5.2). The dielectric medium inside the phantom was assigned an electrical conductivity of $\sigma$ = 0.77 S/m, a relative permittivity of $\varepsilon_r$ = 58.2 and a density of

$\rho$ = 1090 kg/m$^3$. All parameters are matching the electrical properties of human muscle tissue [50].

EM simulations were performed with a resolution inside the phantom of 2.5 x 2.5 x 2.5 mm$^3$ while the copper tube was embedded in a mesh box with the size of 5 x 5 x 1cm$^3$. This box is designed to ensure an equidistant mesh size around the stent equivalent for reproducible calculations and data extraction patterns without being influenced by the copper tube length, diameter or orientation. To determine the mesh resolution around the copper tube, simulations were performed to find a good compromise between mesh resolution and computing time. The investigated mesh resolutions around the copper tube were $\Delta y$ = 0.5 mm along the copper tube and varying resolutions of $\Delta x$ = Az = [0.05; 0.1; 0.2] mm transversal to the copper tube. The results of the maximum induced field values in the copper tube as depicted in Figure 5.3 were obtained along an extraction line approximately 200 $\mu$m above the copper tube. No significant discrepancy in induced E-field peaks at the copper tube were found for the different resolutions of $\Delta x = \Delta z$ = 0.05 mm (blue) and $\Delta x = \Delta z$ = 0.2 mm (red) transversal to the stent equivalent for the lengths of l = 4 cm and l = 2 cm, highlighted by the almost perfect overlay of the field values along the extraction lines in Figure 5.3. In order to gain efficiency, a resolution of (0.2 mm)$^3$ was chosen for the mesh box, which decreases simulation time by a factor >6. Due to the continuous nature of gridlines, the fine resolution is sustained in the extension of the meshbox in the direction of the axes.

The boundary conditions of the model are set to "open" to allow for electromagnetic interactions between the different parts of the model and with the air. The size of the sensor recording the field distribution was adjusted to include a 5 cm margin around the setup.

Stent Geometries

Table 5.1 lists the configurations of the stent equivalent as set up for EMF simulations. Variable lengths and diameters are chosen according to the values found in literature (see Table 4.1) and given by the manufacturers of the provided CAD-model. Changing orientation and depth shall take individual differences in anatomy into account. The set of depth dependent simulation was performed in a phantom with the same properties and base but with a height of 16 cm. This allows performing simulations with stent equivalent placed as deep as 12 cm in the phantom, as found for the location of the RCA. The approximation was made on the basis of a coronary CT.

As aforementioned, the behavior of a stent and a copper tube of the same dimension are in good agreement when exposed to the RF pulse of interest. In order to downsize computing time, all simulations were therefore conducted with a copper tube with a wall thickness of t = 100 $\mu$m. Due to license constraints of the powerful GPU solver, the metal is modeled as a perfect electric conductor. If not being otherwise under investigation, default values for the tube's length and diameter were chosen corresponding to the CAD-model: l = 4 cm, $d_{out}$ = 4mm, d = 4 cm. When investigating the influence of length and diameter in the 8 cm phantom, the remaining geometrical values were set according to the reference model. The orientation dependence in the 8 cm phantom and the depth dependence in the 16 cm phantom were quantified for all tube lengths using the reference diameter.

RF Antenna

The RF antenna used for the simulations is a single $\lambda$/2 dipole bow tie antenna with a length of 7 cm, designed for a frequency of 297 MHz. The input power was set to an accepted input power at port of $P_{in}$ = 1W (peak amplitude). With this, a broadband pulse at f = 300 MHz with a bandwidth of $\Delta f$ = 100 MHz was applied and the simulation time set to $t_{sim}$ = 120 ns to obtain a steady state, as seen in Figure 5.4. The results were extracted for f = 297MHz.This value differs from the aforementioned frequency of 298.2 MHz. In fact, the latter is the calculated value for a field strength of exactly 7.0T, the 7T scanner at the B.U.F.F. exhibits a frequency of 297MHz.

Extracting Results

For the calculation of the normalized field as well as the point SAR and average SAR (1g and 10g) the implemented tools of SEMCAD X were used. The field data was exported and postprocessed in MatLabR2010a (MathWorks, MA, USA).

For the quantification of the antenna effect in presence of the stent equivalent, a plane parallel to the tube is selected in its vicinity from which the E-field and SAR values can be extracted. It is not possible to just extract the maximum E-field value in the phantom because the surface current induced in the tube itself generates higher field strength than what is being induced in the tissue. But since the heating is caused by the induced energy deposition, the field in the phantom medium needs to be evaluated. In SEMCAD X, the position of these evaluation planes are determined by the calculated voxels. In our case, a distance of 250 $\mu$m from the stent equivalent towards the antenna was chosen for the field evaluation. After using the averaging SAR calculation, the evaluation plane for SAR is located in the middle of the voxels. For SAR comparison, a plane at a distance of 150 $\mu$m was thus chosen.

Evaluation of Induced Antenna Effect

Preliminary Investigations

Since this study is the first project at our facility that uses SEMCAD X for RF heating simulations, a variety of preliminary investigations were conducted in order to verify the new simulation environment with the already established software CST Microwave Studio (CST Studio Suite 2011, CST GmbH, Darmstadt, Germany). Here for, a comparison study using the same setup and conditions was performed. Due to different grid generation options, the mesh is not exactly the same at the antenna. This results in different maximum field strength at the port itself but does not show major influence in the phantom, i.e. in the region of interest, as shown in Figure 5.5. Especially the parallelism of the field lines is again achieved. Please note that this is not the final version of the phantom as it was used for the actual simulations investigating the stent equivalent.

Figure 5.6 shows a slice view of the absolute value and the vector field view of the resulting electrical field in the part of the phantom underneath the antenna for a central slice of the phantom. In this view along the main axis of the antenna, one can see that the field lines are parallel over a rather large region of the phantom. This is the region where maximum interaction with the stent is expected when placing it parallel to the field lines. As this study aims at being a worst case approximation, this region was chosen to be the region of interest highlighted by a black box in Figure 5.5.

Field Simulations

The first simulation including a stent equivalent was the basic reference with the copper tube settings of $d_{out}$ = 4 mm, l = 4 cm, d = 40 mm and $\gamma$= 0°, as shown in Figure 5.7.

The antenna effect occurs at the tips of the tube just as expected. The droplet shape is symmetrical at both tips but slightly distorted with higher field strengths at the edge of the stent equivalent that is closer to the antenna. In the evaluation plane, a maximum field strength of $E_{max}$ = 288 V/m was found. Table 5.2 lists the maximum field values found for the individual configurations of varying stent length with reference diameter and position and for changing orientation and position for reference length and diameter. An input power amplitude of $P_{in}$ = 1 W accepted power at port was used.

In Figure 5.8, one can see that the high resolution meshbox around the copper tube was not sufficiently large to cover the entire extent of the induced RF field. To overcome this failure, another simulation with the same setup but a larger meshbox of the size of 5 x 5 x 2 $cm^3$ was conducted. A slightly lower field maximum of $E_{max}$ = 284 V/m was found in the evaluation plane, but the 1g avg SAR remained almost unchanged, as further discussed in 5.1.2. All simulations presented here were run with the smaller meshbox.

Stent length

The first comparison was made with respect to the copper tube length. Since the stent equivalent is parallel to the field lines, this means that the effective length of the conductor that can act as a passive antenna gets smaller, the antenna effect is thus expected to be less with decreasing length. For a stent equivalent length of l = 3 cm, l = 2 cm and l = 1 cm, maximum field values at 250 $\mu$m are found to be $E_{max}$(3cm) = 234 V/m, $E_{max}$(2cm) = 164 V/m and $E_{max}$ = 96 V/m respectively. As can be seen in Figure 5.9, the lower induction results in less radiation back into the phantom, the geometrical extend of the antenna effect also decreases with copper tube length, just as expected.

Stent orientation

The second set of simulations aimed to compare the antenna effect at different orientations of the copper tube with respect to the antenna middle axis. By this, the stent equivalent is not parallel with the field lines anymore, which means that the effective conducting length decreases as depicted in Figure 5.10 a. For an angle of $\gamma$ = 60°, we find $l_{eff}$ = cos 60°· 4cm = 2cm. A 4 cm 1 D wire rotating by 60° should thus give the same result as a 2 cm wire parallel to the field.

For the tube with finite dimensions, we find $E_{max}$(60°) = 156 V/m, which is very close to the maximum value $E_{max}$(2cm) = 164 V/m found for the 2 cm stent equivalent, confirming the expected behavior. The correlation between orientation and maximum field value is plotted in Figure 5.10 b.

Stent Diameter

The third investigated parameter was the stent diameter. Figfure 5.11 a shows the maximum induced E-field values at a distance of 250 $\mu$m from the stent equivalent. While varying the diameter of the stent equivalent, the upper

edge of the tube always remained at the same position with respect to the RF antenna. The results are shown in Figure 5.11 and demonstrate a decrease of peak E-field value with an increasing stent equivalent diameter. A decrease of 25% when moving from $d_{out}$ = 2 mm to $d_{out}$ = 4 mm was detected. Figure 5.11 b shows the E-field distribution in the evaluation plane for the wider tube. The droplet shape is not perfectly smooth as could be expected for a 1 D wire but exhibits a split-up of the maxima towards the tube wall with lower field values in the middle of the tube. The gap between the two maxima depends on the diameter, for narrower stent equivalents the maxima converge, leading to higher field values at the overlap all along the tube, as can be seen for the 2 mm stent equivalent in Figure 5.11 c. Higher peak values are registered (Figure 5.11a) as well as an extension of the region with high induced field along the tube's long axis (Fiure 5.11 b vs. c).

Stent Position

The last set of simulations focused on changes in the position of the stent equivalent within the phantom, i.e. the distance between the copper tube and the antenna. It is expected that the irradiated E-field decreases with increasing distance leading to an expected decrease in the induced field as well. The E-field distribution shows an exponential decay as expected from an evanescent EM wave evoked at the surface of the phantom. The simulation result for the depth of the stent equivalent, are presented in Figure 5.12. A decrease of the E-field peak value from $E_{max}$(2cm) = 836 V/m to $E_{max}$(12cm) = 59 V/m was observed.

SAR Evaluation

Based on the electric field distributions found in the above EMF simulations, the SAR values can be calculated using both averaging volumes of 1 g and 10g. Since no field is induced in a perfect electric conductor, no SAR values can be calculated in the copper tube. The averaging volume only consists of matter mimicking muscle tissue. The density is $\rho$ = 1090 kg/m$^3$, the averaging volume for 1g avg SAR is of the size of $V_1$ = 0.97x0.97x0.97 cm$^3$, whereas the size of the 10g averaging cube mounts up to $V_2$ = 2.09x2.09x2.09 cm$^3$. The induced E-field distribution as well as the 1g and 10g average SAR distribution with the averaging volume size in relation to stent equivalent with a length of 4cm are illustrated in Figure 5.13. Please note that this is a view through the center of the long axis of the stent equivalent. The voxels used for averaging are located in the center plane inside the tube. One can see that the averaging smoothes the shape of the E-field and peak SAR power deposition; the droplet shape of the antenna effect is no longer distinguishable. The size of the cube used for the 10g averaging not only conceals the high induction caused by the copper tube but also smears into the baseline SAR induction occurring at the surface of the phantom. With the latter being independent of the presence of the tube, this mix most likely impacts if not falsifies the values of induced SAR associated with the antenna effect.

Table 5.3 and Figure 5.14 show an overview over the maximum induced $SAR_{1g}$ and $SAR_{10g}$ values for all stent configurations and the empty 16 cm phantom (LocSAR).

$SAR_{10g}$ peak values are by a factor of >5 lower versus the $SAR_{1g}$ peak values. This discrepancy is caused by the artificial SAR dispersion in the large averaging volume. Using the 10g average SAR values only, as suggested by the IEC guidelines, holds the risk of underestimating local heating in the presence of small conductive implants. This indicates that the larger averaging volume is inappropriate to evaluate power absorption and estimate temperature elevations of implants as small as a coronary stent. For this reason, further inquiries in this project are based on the $SAR_{1g}$ values only.

The behavior of the $SAR_{1g}$ values confirms our hypothesis: the maximum value decreases when decreasing length (decrease of 82% comparing l = 4 cm to l = 1 cm, Figure 5.14 a), does not show significant deviations for different diameters (Figure 5.14 b), decreases when rotating the copper tube out of the homogeneous field (l = 4 cm: 86% for $\gamma$ = 90° vs. $\gamma$ = 0°, Figure 5.14 c) and strongly decreases by 62% with increasing distance to the antenna from d = 2 cm to d = 4 cm for a 4 cm stent equivalent. Comparing d = 2 cm to d = 12 cm shows a decrease of 99.3% (Figure 5.14 e).In this maximum interference setup, the surface SAR exceeded the SAR induced by a 4 cm stent equivalent for a depth of 5.2 cm or higher (green line in Figure 5.14 e). For shorter copper tubes, this level is reached earlier; for a tube length of 3, 2 and 1 cm at an approximate depth of 4.3 cm, 3.1 cm and 1.8 cm respectively. For these cases, stent equivalent induced SAR may not exceed safety limits, as long as the guidelines are fulfilled for surface SAR. Since the decay of the induced SAR depends on the exponential decay of the irradiated field with increasing depth, the $SAR_{1g}$ in the empty phantom was calculated (Figure 5.14 d) and the $SAR_{1g}$ induced by the stent equivalent was set in relation to the baseline $SAR_{1g}$ at the respective position (Figure 5.14 f). A linear dependence was found, confirming that the induced $SAR_{1g}$ in presence of the stent equivalent is directly proportional to the local baseline $SAR_{1g}$ caused by the radiated field only. The slope of the relation showed further dependence on the copper tube length, ranging between 8.1 for a 4 cm tube and 1.5 for l = 2 cm. This clear dependence lead to our new objective of making good use of the lessons learned from the inquiry by developing an analytical approximate for the induced $SAR_{1g}$ in presence of the stent knowing the pattern

of the baseline SAR together with stent position and geometry. Therefore all $SAR_{1g}$ values were fitted in order to quantify the dependence on the investigated parameter. While the influence of the copper tube diameter showed no significant effect and is considered negligible, the length dependence of the induced $SAR_{1g}$ can be very well approximated by a cubic polynomial fit ($R^2$=1, RMSE=0):

$$SAR_{1g}(l) = -0.045 \cdot l^3 + 0.477 \cdot l^2 - 0.643 \cdot l + 0.734 \qquad (5.4)$$

This fit predicts maximum interaction for a stent equivalent length of about 6.25 cm, in the range that could be expected from the wavelength of $\lambda \approx 13$ cm causing the antenna effect. The influence of the rotation angle $\gamma$ between the middle axis of the stent equivalent and the E-field vector orientation follows a cosine function, with its amplitude being dependent on the length of the stent equivalent, as can be seen in Figure 5.14 c:

$$SAR_{1g}(\gamma) = A \cdot \cos(2\gamma) + B \qquad (5.5)$$

Table 5.4 summarizes the length dependent normalized coefficients A and B together with the induced SAR vs. local SAR slope and the respective Goodness of Fit.

All results can be summarized in a single equation enabling the estimation of induced SAR in the presence of a stent placed in a given SAR distribution, adaptable for stent length l and orientation$\gamma$:

$$SAR_{stent}(l, \gamma) = 1.71 \cdot SAR_{loc} \cdot (A\cos 2\gamma + B) \cdot (-0.14\, l^3 + 1.38\, l^2 - 1.7\, l + 2) \qquad (5.6)$$

where $SAR_{loc}$ is the baseline $SAR_{1g}$ at the assumed stent position. This equation can now be used to estimate the induced $SAR_{1g}$ values for individual scenarios with i.e. local RF multichannel transmit/receive coil arrays and a specific stent position in the EM field. This approximation holds two safety margins within its results. First, this approximation is based on simulations of the copper tube stent equivalent, which shows an overestimation of the E-field peak value of the antenna effect of a real stent [4]. Secondly, a factor of 1.71 was introduced, including the possibility of the stent being surrounded by blood only, i.e. radiating in a tissue exhibiting a significantly higher electric conductivity of $\sigma$ = 1.32 S/m (vs. $\sigma$ = 0.77 S/m for the simulated myocardial tissue).

Thermal Simulations

Introduction and Simulation Model

The SEMCAD X simulation platform is equipped with a thermal solver. It is designed for temperature simulations in a biological context [47] and provides a multitude of adjustable parameters in order to match reality either for a simple, homogeneous phantom or for a complex anatomical model. Once the parameter set is defined, three solvers are available: A steady-state solver, a stepwise calculation of an FDTD solver calculating the temperature evolution over time and the Discreet Vasculature - Thin Wire - Solver (DIVA), specialized in models containing blood vessels or almost one-dimensional highly conductive structures [47]. Even though these three methods are suitable for complementary demands, they all request the same basis: the solution of the Pennes Bioheat equation:

$$\rho \cdot c \cdot \frac{\partial T}{\partial t} = \nabla \cdot (k \cdot \nabla T) + \rho \cdot Q + \rho \cdot SAR - \rho_b \cdot c_b \cdot \rho \cdot \omega \cdot (T - T_b) \qquad (5.7)$$

The temperature is calculated point wise in a medium with the density $\rho$ and a specific heat capacity c, while heat sources can be defined by a metabolic heat generation rate Q or by the specific absorption rate SAR. Blood circulation can be integrated in the model with a blood density $\rho_b$, a specific heat capacity $c_b$, a temperature $T_b$ and a perfusion rate $\omega$. The heat diffusion is governed by the thermal conductivity k of the medium.

This basic equation can be further improved in order to map reality more closely. An anisotropic thermal conductivity (along the gridlines) can be set for every solid. Linear temperature dependence can be assigned to the perfusion, the heat generation rate and also the electrical conductivity $\sigma$. The latter allows taking the changes of SAR with temperature into account without recalculating the EMF simulations. Other options exist to create a model as close to reality as possible. In addition, boundary conditions (uni- or bidirectional) and initial temperatures can be set for every object in

the model to properly reflect heat exchange.

For the FDTD solver, a maximal time step can be defined to guarantee stability. For uniform meshes, it can be approximated by

$$\Delta t \leq -\frac{2}{\left(B-\frac{4A}{(\Delta x)^2}\right)} \quad \text{with} \quad A = \frac{k}{\rho c} \qquad (5.8)$$

and

$$B = \frac{\rho_b c_b \omega}{c} \qquad (5.9)$$

neglecting more complicated structures such as inhomogeneous-interfaces or boundary conditions.

The DIVA solver used for the simulation of thin highly conductive wires and convective blood flow in a discrete vessel system uses the temperature in voxels close to the streamed region to estimate the flux through the object boundary using analytical models of the temperature behavior in that region. The interaction between the thin structure and its vicinity can thereby be considered at every time step [47].

Thermal simulations were conducted using the 8 cm phantom as used in the EMF simulations. First simulations were run with a homogeneous phantom ($\varepsilon$ = 58.2, $\sigma$ = 0.77 S/m, p = 1041 kg/m$^3$, c = 3546 J/(kg·K), k = 0.53 W/(m·K)) in order to investigate baseline heating of the phantom when applying 1 W accepted input power (peak amplitude) at port for a heating time of 360 s. At the targeted stent equivalent position at a depth of 4 cm centered underneath the antenna, a baseline heating of $\Delta T$ = 0.003 K was observed.

In order to improve the simulation model to a more realistic scenario, where a stent is placed in a coronary artery, blood vessel and blood flow were included in the simulations. The impact of blood vessels and blood flow on the simulation results was investigated. The high differences in electric properties at 300 MHz ($B_0$ = 7.0T) of muscle tissue ($\sigma$ = 0.77 V/m, $\varepsilon$ = 58.2, [36]), blood vessel wall ($\sigma$ = 0.537 V/m, $\varepsilon$ = 45.3, [36]) and blood ($\sigma$ = 1.3 V/m, $\varepsilon$ = 65.7, [36]) suggest to implement these regions in the EMF simulations in order to obtain proper SAR distributions for the thermal simulations. For this, a 15 cm long, straight vessel with an inner diameter of $d_{in}$ = 3.8 mm [37], matching the reference stent equivalent diameter of $d_{out}$ = 4 mm and $d_{in}$ = 3.8 mm, was implemented in a distance of 4 cm between the vessel middle axis and the RF antenna as shown in Figure 5.15. The blood flow rate was set to v = 4, $10^{-6}$ m$^3$/s [38-44] and a laminar flow along smooth vessel walls was assumed; the temperature of the inflowing blood was held constant at the initial temperature. In order to gain higher accuracy when simulation small temperature changes, the initial temperature was set to 0°C [47].

The resulting influence of modeling blood and blood vessel wall electromagnetically is illustrated in Figure 5.16. While the voxel-wise calculated point SAR distribution shows the expected behavior with higher SAR values in the region of higher electric conductivity (Figure 5.16 a+c), the difference in temperature increase is much more moderate due to the temperature dissipation in the tissue (Figure 5.16b+d). Both temperature distributions still exhibit the (smeared) outlines of the underlying antenna effect.

For the simulations with and without the blood vessel, a maximum temperature increase of 0.132 K at the stent equivalent tip (Sensor 4) was detected. Notwithstanding these minor temperature effects, further thermal simulations included blood and blood vessel wall parameters. Furthermore several thermal point sensors were placed in the phantom in order to register the temperature increase during the heating period at specific points in time within the phantom, as shown in Figure 5.17. A surface sensor (Sensor1) was placed directly below the RF antenna at the location of the highest expected temperature, while Sensor 2 and Sensor 3 were positioned slightly above the stent equivalent middle axis above the tube tips. Sensors 4 is aligned with the upper edge of the copper tube, while Sensor 5 records values in the tube middle axis, where the blood flow is expected (Table 5.5).

Moreover the blood flow simulations were extended to simulate the influences of a reduced blood flow, as in the case of restenosis. Here for the actually streamed cross-sectional area of the blood vessel was reduced about 0% (no restenosis) to 20, 40, 60, 80 and 90% (Figure 5.17) while the blood flow was held at a constant flow rate through the middle of the vessel. Complete occlusion of the vessel was simulated by setting the flow rate to v = 0 m$^3$/s.

Evaluation of RF Stent Heating

MR safety guidelines of the International Electrotechnical Commission state, that the input power of the RF coil should be limited in such a way that the temperature increase within a time frame of 6 minutes does not exceed $\Delta T$ = 1

K [3]. In order to determine the SAR levels caused by the presence of a stent equivalent to result in such temperature increase, EM and thermal simulations were conducted. The simulation results presented are scaled to an input power of $P_{in}$ = 1 W applied for a simulation time of $t_{sim}$ = 360 s. To afford reasonable simulation durations, the influence of the copper tube's high thermal conductivity of $k_{Cu}$ = 401 W/(m·K) was investigated. High differences in the thermal conductivity of neighboring tissues lead to a significant increase of simulation time [47]. While the phantom material is assigned a thermal conductivity of $k_{Phantom}$ = 0.53 W/(m·K), the suggested approach was to set the thermal conductivity of the metal to $k_{Cu}$ = 1 W/(m·K), leading to a temperature increase of $\Delta T$ = 0.132 K at Sensor 4 at the tip of the tube after 6 min of RF heating with $P_{in}$ = 1W. Comparison identified an overestimation of 30% vs. the maximum heating of $\Delta T$ = 0.1 K recorded for the highly conductive tube. The lower thermal conductivity delays the heat dissipation along the metal, a larger proportion of the heating accumulates in the surrounding tissue, leading to a temperature increase overestimation at the tips of the copper tube and an underestimation at the middle of the tube. Considering an overestimation of the temperature increase as a safety margin, further simulations were run using the setting of $k_{Cu}$ = 1 W/(m·K) in order to downsize simulation time from 21 hours to less than 10 minutes.

The final simulation setup revealed that a maximum temperature increase of $\Delta T$ = 1 K was recorded at the surface of the phantom right underneath the RF antenna for an input power of $P_{in}$ = 4.9 W applied over a duration of t = 360 s. This temperature increase was induced by a surface $SAR_{1g}$ value of 1.4 W/kg. At the same time the tips of the stent equivalent, which are located 4cm below the RF antenna, show $SAR_{1g}$ values of 2.88 W/kg, which lead to a temperature increase of only $\Delta T$ = 0.65 K without bloodflow.

Figure 5.18 shows the temperature evolution registered at the five sensors in the blood vessel simulation (without blood flow) scaled to an input power of 1W.

The temperature increase at the surface (Sensor1) and in a sufficient distance from the stent equivalent (Sensor 2) follows a close to linear time dependency suggesting that a fixed SAR value provides sufficient estimations for a given temperature increase. At the tube tip the situation is slightly more complex. The recordings at Sensors 3, 4 and 5 exhibit a saturation curve, caused by the high SAR around the tips due to the antenna effect. The position of Sensor 3 3mm above the upper edge of the stent equivalent causes the temperature increase to be mainly influenced by the antenna effect. Sensor 2, which is positioned 7mm above the stent equivalent and closer to the RF antenna, is dominated by the radiated field of the RF antenna. Sensors 4 and 5, which are in direct vicinity of the copper tube, show that only during the first period of RF heating (~ 153 s), the temperature increase at the stent equivalent exceeds the surface temperature values indicated by Sensor 1. This implies that for a continuous 6 min RF heating, the maximum overall temperature increase is due to the surface heating caused by the irradiated EM field of the dipole antenna. In an empty phantom, this is also the case if the total input power is applied through a short pulse followed by the remaining time frame with zero irradiated EM field. In the investigated presence of a stent equivalent, where heating is dominated by the induced antenna effect for t < 153 s, this is not the case. Applying the total input power within this first time frame but according to safety guidelines based on the 6 min findings can cause severe underestimation of the induced heating in vicinity of the stent and temperature increase above current guidelines.

En route to approaching a clinical scenario blood flow through the vessel was implemented. This is expected to counteract and offset the heating caused by the stent through dissipation of the heat with the flowing blood. Due to the unknown factor of individual differences in the incorporation of the stent equivalent into the vessel wall, a perfect stent placement was assumed, yielding a perfectly smooth vessel wall and laminar blood flow. The coronary flow rate was set to $v = 4 \cdot 10^{-6}$ $m^3/s$ [38-44], flowing from the left to the right in all figures, yielding a sensors positioning at the distal and thus warmer tip of the stent equivalent. The temperature of the inflowing blood was constantly held at the initial temperature. Figure 5.19 a shows the resulting temperature distribution.

While the surface heating is unaffected by the cooling mechanism of the blood, the temperature distribution reveals only small temperature increase at the tips of stent equivalent (Figure 5.19 a), confirming our hypothesis as indicated by the evolution curves in Figure 5.19 b. The temperature increase at the tube's tip (Sensor 4) decreases by more than 50% versus the absence of blood flow. A temperature rise of $\Delta T$ = 0.06 K only was found after 6 min. The drop of 60% for Sensor 5 (Figure 5.19 b) is even more prominent, due to its location in the middle of the blood vessel and thus in the middle of the cooling blood flow. The fact that the temperature evolution at Sensor 3 is also affected by the blood flow but shows a drop of only 30 % and hence is less pronounced than the sensors directly next to the stent equivalent emphasizes the assumption that this region is subject to a superposition of the heating effects caused by the RF antenna and the RF heating of the stent equivalent. With a temperature rise of $\Delta T$ = 0.067 K and an intersection with the curves recorded at Sensor 4 and 5, the heating at Sensor 3 is even higher than at the tip of the copper tube. This indicates that the influence of the tube is smaller than the baseline heating even in the vicinity of the stent equivalent. While this state is reached after t = 187 s for the vessel wall (Sensor 4), the cooling in the flowing blood itself decreases this time to t = 135 s for Sensor 5. The curve evolution for Sensors 4 and 5 display a steep beginning as already seen in the previous simulations, but a much more prominent saturation effect is visible. Here the equilibrium between surface temperature and copper tube temperature is found already after 60 s, suggesting that surface temperature values are dominating the maximum temperature increase much earlier with blood flow than without blood flow (153 s).

Investigating the safety of coronary stents during CMR suggests that the patient is investigated for a heart disease which might possibly be linked to the stenosis in the coronary arteries. It is thus possible that restenosis has occurred after stent placement which hampers if not interrupts blood flow. Taking this into account, a set of simulations regarding different degrees of stenosis investigating the influence of the actual vessel cross section on the temperature increase caused by the stent equivalent was conducted. Table 5.6 lists the degrees of stenosis in area percentage of the vessel's cross section, the resulting diameter of the vessel, the recorded temperature increase at the stent equivalent tip and the relative cooling effect compared to the temperature increase without blood flow together with the time point of surface temperature increase exceeding copper tube heating. Up to now, the reduced vessel cross section was set for the entire vessel length of 15 cm and not only in the region of the stent equivalent $l_{Stenosis}$ <= 4 cm.

Figure 5.20 a shows the temperature evolution at Sensor 4 for all simulations together with the curve recorded at the surface. The intersection of the latter with the respective temperature rise profile indicates the time from which on surface heating exceeds stent heating. The dependency of this parameter on the degree of stenosis is visualized in Figure 5.20 b. As expected, a stronger blood flow leads to an earlier transition.

Experimental Validation of Simulation Results

EMF Validation

Electrical Field Probe Measurements

The field sensor used for the E-field measurements is a 3D sensor using a lithium niobate ($LiNbO_3$) crystal in an optical modulator for the field detection and optical fibers for signal transfer (OEFS-S1B, Seikoh Giken Co., Ltd.). The main advantage of using optical fibers instead of coaxial cables in order to eliminate the influence of the cable [51] is that the laser and the photodetector can be placed outside the scanner room without increasing the cable losses due to a large cable length. By this means, probe sensor measurements can be done during MR scans. Figure 6.1 a) [51] gives a schematic display of the sensor's setup.

The signal provided from a laser propagates to one of the a LiNbO3 crystal with two branches of which one is surrounded by an antenna structure that is sensitive to the external electric field, as presented in Figure 6.1 b) [52]. The external field is translated into a voltage applied across the gap in which the crystal is embedded and this leads to a change of the optical length of the crystal. In the other tip, the signal propagation is undisturbed. Both signals are reflected at the end of the tips and the interference signal is transferred to the photodectector. Here, the strength of the electric field can be deducted from the interference pattern.

The sensor is equipped with three chips tilted by 120° with respect to another, as shown in Figure 6.2 a. In addition, the antenna structures are oblique in such angle to form an orthogonal reference system (see Figure 6.2 b, [53]), allowing the measurement of the electric field strength in three directions of space.

The sensor has a frequency range from 100 kHz to 3 GHz and a measurement range from 1 V/m up to 3000 V/m in air with a temporal resolution in the range of picoseconds [52].

ASTM-Phantom - Simulated and Experimental Setup

This phantom is in compliance with the standards given by ASTM International [6]. It was designed for high reproducibility of RF induced heating measurements on or near passive implants during MRI. Its shape (Figure 6.3 a) is devoted to create a measuring environment similar to the dimensions of the human torso and head. The dielectric solution in the phantom can be exchanged so that the medium and its relative permittivity. and electric conductivity can be adjusted according to the region of the human body where the investigated implants will be found. It is equipped with five lockable bore holes through which Plexiglas tubes can be placed in the phantom in order to create measuring channels for the use of a field or temperature probe. Their position and dimensions can be seen in Figure 6.3 b). The number and position of the introduced tubes is chosen with respect to the targeted measurements. Please note that contrary to the indication on the drawing, the phantom thickness in our case is 17.8 cm. The filling medium used here is called Tween20 and its electrical properties are $\varepsilon = 59.6 \pm 1.6$ and $\sigma = (0.89 \pm 0.04)$ S/m. In our case, only the upper right bore hole will be used for positioning a measuring tube.

This model was constructed virtually in SEMCAD X for simulations. It was important to make sure that the air in the tube and also below the cover of the phantom is respected in the simulation due to its influence on the field pattern, which might falsify prospective validation measurements using field probes.

For simulations, a copper tube was implemented atop the measuring channel. A gradual grid option was chosen for the mesh to achieve refined gridlines for the copper tube, while outer regions that require less accuracy exhibit coarser meshlines. This allows a fine mesh in a volume slightly larger than the object itself so that higher resolution can still be obtained in its vicinity. Figure 6.4 shows a comparison between the regular and the gradual grid. The mesh was set to

$(0.2\ mm)^3$ for the stent equivalent and to $(2.5\ mm)^3$ in the medium.

In addition, the air tube for E-field sensor positioning below the stent equivalent was refined to a mesh resolution of 0.2 x 0.2 x 0.2) $mm^3$ to enable sufficient accuracy for the selection of the extraction line and measuring points depending on the sensor position used during the E-field measurement.

For excitation, the same bow tie as aforementioned was used for simulation and measurement and was centered above of the Plexiglas tube, see Figure 6.5. Excitation was done with a broadband RF pulse of f = 300 ± 50 MHz and the simulation time was set to $t_{sim}$ = 120 ns to reach steady state. In order to downsize simulation time, the field distribution was not calculated over the entire phantom. A sensor recording the electric field of similar dimensions as used for the previous stent equivalent simulations (30 x 32 x 40 $cm^3$) was placed around the copper tube and the antenna rather than around the entire phantom. A copper tube of the dimensions l = 4 cm, $d_{out}$ = 4mm and t = 500 μm was placed at a distance of 2 mm above the measuring channel, atop of the CAD model of a holder that was built for the experimental setup. Several holder designs were investigated in order to find a design with negligible influence on the E-field pattern. Figure 6.5 a) shows the E-field distribution with the entire phantom; Figure 6.5 b) depicts the zoomed view of the field distribution around the stent equivalent. One can see that the upper half of the induced electric field around the stent equivalent shows the same pattern as seen in the rectangular phantom. The distribution on the bottom half on the other hand is slightly distorted by the interfaces tissue mimicking medium - Plexiglas and Plexiglas - air. However, the induced E-field is still measurable and the droplet shape distinguishable.

Figure 6.6 shows the electric field along three extraction lines in the upper half of the measuring tube with increasing distance to the copper tube. Compared to the simulation results without a probe holder tube, the peaks are broadened and not as high but still visible at the tips. With more distance, the line flattens and the maxima at the tips as well as the minimum in the middle approach the baseline E-field. The slight decrease in field strength below baseline in the middle of the lowest profile (black line in Figure 6.6) can possibly be assigned to a shielding effect of the region below the copper tube but beyond the region of field induction.

ASTM-Phantom - Measurement Results

The E-field validation measurements were performed at the Physikalisch Technische Bundesanstalt (PTB, Berlin, Germany) and conducted using the setup as implemented for the simulations (see Figure 6.7 a-c). The 297 MHz RF pulses are generated in an RF network analyzer (NWA) with an output power of 10 μW and amplified by a RF power amplifier with a maximum output power of 5W. The uncertainty of the exact output power and the not yet measured cable losses was overcome by including both in the calibration of the E-field probe sensor in a TEM cell to an accepted input power of 1W [54]. The cell, as shown in Figure 6.7 d, consists of three parallel copper plates with a well-known distance of 3 cm. Assuming a power of $P_{in}$ = 1 W with the system's impedance of Z = 50 Ω, the voltage in the circuit is

$$U = \sqrt{P \cdot R} = \sqrt{1W \cdot 50\Omega} = 7.07\ V. \tag{6.1}$$

The field strength in the TEM cell should thus mount up to

$$E = U \cdot d = 7.07\ V \cdot 0.03\ m = 235.7\ V/m\ . \tag{6.2}$$

Knowing that the absolute value of the signal of all three sensor chips ($E_1$, $E_2$,$E_3$) equals the absolute value of the measured E-field [53] enables the link between the arbitrary units at the NWA output and the well-known field strength in the TEM cell ($E_x$, $E_y$, $E_z$):

$$E_1^2 + E_2^2 + E_3^2 = E_x^2 + E_y^2 + E_z^2 \tag{6.3}$$

One of the three sensor chips was malfunctioning so that the data acquisition was done using one channel only and rotating the probe by 120°.

The measurements of the E-field components inside the tube pose an additional challenge, since the individual sensor chip locations change with each rotation, as indicated in Figure 6.8. It was certain that one chip needs to be vertical when the probe is fixed at the indicated rotation of "0°" [53]. The positioning of the other two sensors chips within the probe head holds an ambiguity caused by the horizontal symmetry shown in Figure 6.8 a. This ambiguity can be offset by exploiting the symmetry of the investigated scenario. In the measurements, this was achieved by registering two data sets composed of the sensor positions "0°, 120°, 240°" and "60°, 180°, 300°" respectively, covering all six

possible sensor positions. The absolute value (amplitude) of the field is calculated separately and then averaged over both sets.

A second challenge was the field decay inherent to the probe rotation. In an empty phantom the E-field strength drops by 11 V/m along the air tube (Figure 6.8 b), where the E-field sensor is positioned leading to altered absolute E-field strengths at different sensor rotations. With a stent equivalent the E-field alterations along the tube are even more pronounced varying with up to 80% (Figure 6.8 c). It is of high relevance to take this effect into account when extracting the electric field from the simulation. This was done by extracting and averaging the absolute E-field amplitude profile along the probe holder tube at the supposed chip position for all six angles. Figure 6.9 a - f shows the E-field profile along the probe holder at the assumed sensor positions, emphasizing the need of averaging the simulation results in order to match the measuring results. Figure 6.9 g presents the two registered data sets together with the average extracted from simulation.

The horizontal symmetry of the induced field distribution is clearly at hand for the simulation results, yielding highly correlating E-field profiles for the sensor positions of both data sets at the same distance of the copper tube regardless the horizontal position (0° vs. 180°, 120° vs. 60°, 240° vs. 300°). The measurement results however show a bias due to the predominant direction of the sensor's sensitivity due to the tilting of the antenna on the sensor chip. This effect is opposite for the two data sets and mostly evened out by the average, as depicted in Figure 6.10.

Measurements were conducted in the empty phantom, in the presence of a 4 cm copper tube with a wall thickness of t = 500 $\mu$m and in the presence of several stents (l= [1.6, 4, 6] cm). The comparison between the simulated and measured fields in the empty phantom as depicted in Figure 6.11 shows a good qualitative agreement between the two profiles and a quantitative deviation of only 12.7 $\pm$ 6.7%. An overestimation of the E-field in the simulation environment was expected, due to the lack of incorporated antenna losses in the EM simulation. E.g. the limitations of the simulation software licensing, forced the modeling of the antenna using perfect electric conductors. Furthermore the matching and tuning network of the antenna and the cable trap for protection against stray radiation, which are both part of the RF circuit in reality and exhibit RF losses, were neglected in the simulation.

Figure 6.11 b depicts the simulated (green) and measured (red) results for the copper tube and the measured profile along the reference stent of l = 4 cm and $d_{out}$ = 4 mm (blue). Please note that the length of the acquired profile in the presence of stent and copper tube is shorter than in the empty phantom, the severe drop of the E-field sideways of the antenna is not depicted in this image section. According to the previous results, lower peak values at the tips were expected for the stent when compared to the copper tube [4]. The measurements revealed an overall reduction of measured electric field strength using a stent in comparison to a copper tube. EM simulations showed, that even though the electrical conductivity of copper ($\sigma = 58 \cdot 10^6$ S/m) is by an order of magnitude higher than the electrical conductivity of the stent material ($\sigma = 1.13 \cdot 10^6$ S/m) the materials influence on the antenna effect is negligible. It is assumed, that the particular fine mesh structure of the stent is responsible for the slight mismatch, which would imply that stent design and mesh architecture is able to reduce RF induction. For the copper tube however, the quantitative agreement of measurements and simulations is within the range of -25.3 $\pm$ 11.8 % while the qualitative agreement as revealed by the comparison of the normalized profiles in Figure 6.11 c shows a good correlation between measurements and simulations.

Thermal Validation

Fiber Optic Thermometry and MR Thermometry (MRTh)

MR Thermometry (MRTh)

Several parameters intrinsic to MRI such as the proton density, the spin relaxation times, the diffusion coefficient and the proton resonance frequency exhibit a temperature dependent behavior [55]. The technique used for our temperature measurements is so called proton resonance frequency (PRF) shift [56]. According to Lenz's law, a magnetic flux always induces an opponent current. The local magnetic field that acts upon the targeted nuclei is reduced by the shielding effect:

$$B_{loc} = B_0 - B_{0s} = (1 - \sigma)B_0 \ , \qquad (6.4)$$

where $\sigma$ is the shielding constant. The extent of this shielding depends on the mobility of the electrons in the surrounding molecules. If the electrons are strongly bound - in MRI relevant scenarios investigating $^1H$ protons in $H_2O$ molecules this is mostly due to hydrogen bonds - the shielding effect is very little. But with an increase in temperature, more and more hydrogen bonds break open; the electrons are free to enforce the screening effect. The temperature dependence of the shielding constant is linear:

$$\sigma = \sigma_0 + \sigma_T(T) \; . \tag{6.5}$$

If the temperature independent part is accounted to be part of the regular behavior, this leaves the temperature dependency of the frequency to be

$$\omega = \gamma(1 - \sigma_T(T))B_0 \; . \tag{6.6}$$

This change in frequency of the proton results in a phase offset after a certain period of time. With data acquisition at t = $t_E$ (echo time), the phase is

$$\phi = \omega t_E = \phi_0 + \phi(T) \; . \tag{6.7}$$

The temperature dependence of this phase offset can be exploited to calculate temperature difference maps with respect to a phase reference measurement $\varphi_0$ acquired prior to the heating or cooling:

$$\Delta\phi = \phi(T) - \phi_0 \tag{6.8}$$

$$\Delta T = \frac{\Delta\phi}{\vartheta B_0 \gamma t_E} \tag{6.9}$$

where $\vartheta$ is the temperature dependence of the chemical shift of the water protons and typically very small: $\vartheta$(T) = -0.01 ppm/K [55].

To overcome the difficulties linked with small temperature changes, heating experiments are typically conducted with an input power exceeding the values used for MRI by far. Another source of possible errors is due to small changes in $B_0$ over time, which are unrelated to temperature events. The extent of these inconsistencies can be estimated by using a reference that shows negligible temperature dependence. Thanks to the lack of hydrogen bonds, this can be assumed for lipids. Small simple lipid probes (olive oil was used throughout this study) next to the phantom can thus be used to determine the changes in $B_0$ so that these deviations can be correctly deducted. With this, an accuracy of ±1 K can be obtained [4].

Fiber Optic Temperature Measurement

Further validation measurements are conducted using an optoelectronic measuring system (OTP-M, OpSens inc., Québec, Canada). This technique is based on white light interferometry and uses the short coherence length of white light. In this point wise measuring technique, an optical fiber is placed in the phantom. At the end of the fiber, the light is reflected by a birefringent crystal whose thickness is temperature dependent. The big advantage of this approach is the high accuracy (±0.15 K)[4] and the independence of the electrical and magnetic fields in the scanner. The big drawback of this measurement technique is the fact, that a continuous measurement throughout the entire phantom is hardly feasible because the sensor cannot be moved randomly. Typically, probe holders such as Teflon (PTFE) tubes are integrated in the phantom so that the sensors can be moved along these pipes, allowing rather precise sensor positioning. However, this limited coverage is the reason why this precise and seemingly uncomplicated temperature measurement is only used for further point wise validation.

Phantom Preparation and Experimental Setup

In order to validate thermal simulations against measurements, RF heating experiments were conducted with an input power far beyond the MRI safety limits for a heating period of t = 10 min. After 120 s, the heating was interrupted for MRTh data acquisition. A RF signal generator (f = 297 MHz) was connected to a RF power amplifier (RFPA) (Physikalisch Technische Bundesanstalt, Berlin, Germany), generating an output power of 123 W. This output value was set after a calibration procedure to generate 100W transmit power at the end of the coaxial cable being connected to the RF antenna in order to account for cable and other RF losses. RF antenna losses, which can be estimated from ASTM phantom E-field measurements, were accounted for in the temperature simulations. With a measured E-field strength

of only 86% compared to the simulation and SAR scaling with the E-field to the power of two, thermal simulations were run using an accepted input at port of $P_{in} = 0.87^2 \cdot 100$ W = 76 W. The phantom built for these thermal validation measurements was a PMMA box with the outer dimensions of (20 x 30 x 12) $cm^3$ and a 3 mm PMMA wall thickness. The filling was mixed using distilled water (7.5 l), agarose ($C_{12}H_{18}O_9$), copper sulfate (Cu(II)-$SO_4$) and sodium chloride (NaCl). The amount of NaCl added governs the electric conductivity while the $CuSO_4$ to reduce $T_1$ times of the phantom. Since SAR mostly depends on the electric conductivity of the irradiated medium, the main focus was to adjust the concentration of NaCl in order to match the electric conductivity of the simulated tissue ($\sigma$ = 0.77 S/m). Heating the phantom medium up to about 80°C before filling the box causes the agarose to gel when cooling down. This is done for RF heating experiment phantoms in order to avoid temperature exchange in the phantom caused by thermal convection. If not suppressed, the flow of the phantom fluid would augment with increasing temperature and falsify the temperature distribution recorded by MRTh [6]. Two phantoms were built. One homogeneous phantom without stent and without Teflon probe holders (PTFE tubes) and a second phantom including two PTFE tubes along the phantom's long axis at the depth of $d_1$ = 2 cm and $d_2$ = 5 cm and a 4 cm stent was placed around the lower PTFE tube at its middle, as depicted in Figure 6.12. The phantoms will be further referred to as 'empty phantom' and 'stent phantom' respectively.

Table 6.1 indicates the amount of each component of the phantom filling and the measured values for the dielectric properties of the phantom medium for both phantoms.

Both phantoms were implemented in the simulation software with the dielectric properties as measured. The thermal properties of the phantom were set to c = 3546 W/(kg·K) and k = 0.53W/(m·K) with a density of $\rho$ = 1041 kg/$m^3$, based on empirical data.

The MR images used for MR thermometry were acquired using a standard volume resonator (Basic Coil, Siemens Healthcare, Erlangen, Germany). First localizer images were acquired, confirming the correct setup of the experiment. Slice selective $B_0$-shimming was performed for a better $B_0$ homogeneity. Further on, the slice positions used for MRTh evaluation were also used for image acquisition between the 120s heating periods.

Thermal Measurements and Simulations

Empty Phantom

First heating experiments were done using the empty phantom. Due to the lack of a Teflon tube for the positioning of the fiber optic sensor, a hole was drilled in the phantom shell at a depth of d = 4 cm and a straight stick was used for creating a guide for the sensor in the phantom. The sensor was then inserted 15 cm into the phantom, yielding a placement centered underneath the antenna at a depth of d = 4 cm. A reference sensor was placed in a water probe placed outside the scanner bore to detect possible background heating. MR data was acquired in an axial slice through the middle of the phantom along the short axis and in a centered sagittal slice along the long axis.

Figure 6.13 shows a comparison of the temperature evolution recorded with the optic fiber sensor (blue) and extracted from simulation at the estimated sensor position (green). Both curves show a clear distinction between the heating periods with a linear temperature increase and the periods used for MRTh data acquisition with no change in temperature. The suppression of heat dissipation and cooling as soon as the heating is turned off is anticipated in the choice of phantom filling with a high specific heat capacity and no convection. This enables MRTh data acquisition throughout the necessary time frame (here < 30 s) with negligible temperature decrease.

After approximately seven minutes of heating, the measured temperature oscillated by 0.3 K for 1 minute approximately and then settled at the increased temperature. This behavior is inherent to the optical temperature sensors used and was subtracted for quantitative comparison. The total measured temperature increase after ten minutes of heating amounts to $\Delta T$ = 5.1 K at a depth of 4 cm, while a maximum temperature increase of $\Delta T \approx$ 21 K at the surface of the phantom can be estimated. In the simulations, the superficial temperature increase is found to be $\Delta T$ = 25.2 K while the temperature at 5 cm within the phantom rises by $\Delta T$ = 6.6 K. At sensor position, a discrepancy of only $\delta T$ = 1.5 K is found with the accuracy of MRTh being $\pm$ 1 K [4]. The results of the MRTh measurements are presented in Figure 6.14 as compared to the simulated temperature distribution.

Please note that the high temperature values on the right hand side in Figure 0.1 a are artifacts called phase wraps and appear in the image when the phase difference is larger than $2\pi$. The periodicity of the phase causes $\Delta\varphi$ to be assigned to $\Delta T(\Delta\varphi - 2\pi)$. Misleadingly high phase differences can be caused by $B_0$-inhomogeneities and insufficient $B_0$-shimming.

A good qualitative agreement is visible between the isotropic temperature distribution pattern recorded in simulations and MR thermometry. The extent of the heated region in the phantom is larger in the simulation, following the higher overall temperature increase. For a comparison between MR thermometry and the fiber optic measurement, the temperatures recorded by MRTh was averaged over 7 pixels around the sensor position. A discrepancy of less than $\delta T$ = 1 K was found, being in the range of MRTh accuracy.

Stent Phantom

Stent heating experiments were conducted using MRTh and four fiber optic sensors; the positions are outlined in Table 6.2.

First localizer MR images acquired to confirm the correct setup of the experiment showed that the stent was not located in the middle of the phantom but shifted along the Teflon tube by approximately 1.5 cm. This is most probably due to the fact that the PFTE tubes expand when surrounded by the warm phantom filling and hence need to be clamped in order to ensure the horizontal alignment of the tube. With the stent being mounted to the tube, the stretching of the warm Teflon lead to a displacement of the stent out of its original position. The new position of the stent was estimated using the MR images. The position of the antenna was corrected so that the stent was centered underneath the antenna. The sensors placed in the phantom according to the new positioning information. The sensors are not only MR compatible but also not visible on the localizer MRI. The sensor position was adjusted utilizing the knowledge about the stent location of the scout scans but without means of verification. For this setup, multiple slices were defined for MRTh data acquisition. One sagittal slice was placed in the middle of the phantom i.e. and aligned with the long axis of the stent. Two axial slices were placed at the middle of the stent and at its tip. Three coronary slices were selected, one right above the stent (slice b) and two at the position of the PTFE tubes (slices a+c), as illustrated in Figure 6.16. MR temperature mapping was performed with a double-echo gradient echo technique [57] and the following imaging parameters: spatial resolution (1.6x1.6x4) $mm^3$, repetition time TR = 61 ms, echo times (TE) TE1/TE2 = 2.26/6.34, receive bandwidth = 898Hz/Px, nominal flip angle = 30°, reference voltage 400V.

Figure 6.17 shows the temperature distribution after 2, 4, 6 and 8 minutes of heating. Due to a problem with the RFPA throughout the last heating period, the MRTh data obtained at the end of the experiments (10 minutes) was discarded.

For t = 2 min, the heating is most prominent in slice a (Figure 6.17a) positioned in closest distance to the antenna with maximum temperature changes of 3.2K. The heating seems uniform and only influenced by the RF antenna, following the same heating pattern as the empty phantom. In slices 2 (Figure 6.17b) and 3 (Figure 6.17c) however, the heating pattern exhibits hot spots at the stent tips due to the antenna effect while the baseline heating in the rest of the slice and most importantly also in the center of the stent is much lower. While the evolution of the temperature increase in slice a is much stronger and keeps exhibiting the isotropic distribution throughout the phantom, the effects are more interesting for slices b and c. For t = 2 min and t = 4 min, the antenna effect is very well visible, after the third heating period however, the heat flux along the stent, i.e. along the higher thermally conductive material, and heat dissipation has caused heating all along the stent. The hot spots at the stent tips are no longer distinguishable and support the results found in the temperature simulations for the saturation effect. Figure 6.18 illustrates the temperature evolution recorded by the fiber optic sensors recorded during the whole RF heating period as well as the discrete MR thermometry recordings at the mentioned time points

These saturation and heat dissipation effects are visible in the fiber optic measurements of Channel 4, which was located at the stent tip and demonstrates a saturation curve at each heating interval (Figure 6.18). At the same time surface regions show a linear increase in temperature. This behavior was deduced from the recordings of Channel 2 and was also demonstrated in the results of the temperature simulations (Figure 6.19). The almost constant temperature recordings after the RF heating intervals indicate an interruption of RF heating during MR image acquisition with negligible temperature decrease evoked by the high specific heat capacity of the phantom material. Fiber optic measurements correlate well with the temperature estimations recorded with MR thermometry as can be seen in comparison to Channel 2 and Channel 4 in Figure 6.18. The MRTh data associated with slice a and slice c is in good agreement with the temperatures recorded by the fiber optic sensors, e.g. after 8 minutes of RF heating MRTh shows a temperature increase to 34.3 K in slice a and to 24.2K at the stent tip in slice c, while fiber optic sensor measurements show an increase of 33.6 K and 23.7 K. For short heating time, estimating the punctual temperature increase by MRTh at the sensor positions near the stent is hampered by the induced image artefacts, transferring to MRTh. During MR data acquisition, when the RF power input is turned off, a heat dissipation was visible in Channel 4 with a temperature drop of $\Delta T \approx 0.8$ K as demonstrated in Figure 6.18. This at first surprising effect could be reproduced in temperature simulations as shown in Figure 6.19.

Since a uniform phantom was used in simulation neglecting the PTFE tube and the air within, cooling due to small airflow in the tube could be excluded as a possible reason. This is backed by the fact that Channel 3, which was placed in the same PTFE tube during measurement, did not exhibit such effect. A possible explanation is the good heat conductivity of the stent equivalent, which during pauses to the RF heating seeks equilibrium with the cooler regions at the center of the stent, as well as surrounding tissue.

Discussion & Conclusion

This work was designed to detail RF heating induced by coronary stents at 7.0T. For this purpose EMF and

temperature simulations, E-field measurements, RF heating paradigms, MR thermometry and fiber optic temperature measurements were performed. Contrary to prior investigations [4], the formulation of generalized simulation models enabled us to make statements about the behavior of more than one specific stent design. In particular the electromagnetic induction was carefully investigated for various stent geometries (length, diameter) and positioning (distance to RF antenna, orientation with respect to the E-field vector). A multi-parametric dependence of the induced $SAR_{1g}$ levels in each configuration of the stent analog was found. Using curve fitting algorithms, this in its detail and structure unique approach enabled the arranging of an analytical equation. Its universal approach describes the induced stent $SAR_{1g}$ based only on a priori knowledge of E-field and $SAR_{1g}$ distributions of an arbitrary RF coil.

To validate my findings, E-field measurements were performed in an ASTM phantom. The results showed good qualitative agreement of the E-fields derived from the experiments versus simulations for an empty ASTM phantom and in the presence of a 4 cm stent equivalent. The absolute E-fields differed by only -13 % in the empty phantom. This deviation is due to the antenna losses which were neglected in the EM simulations. For the stent equivalent, a lower electric field strength was measured, showing a discrepancy of ~-25 % versus the simulations. This deviation is in the range of previously reported accuracy [58].

Thermal simulations were performed using the SAR distribution derived from the EMF simulations. The estimation of the antenna losses based on the E-field validation measurements in the empty phantom were used to adjust the power input in the thermal simulations. Compared to fiber optic sensor measurements, the simulations showed a difference of $\delta T = +1.5$ K in the temperature increase at a depth of 4 cm underneath the center of the RF antenna. MR thermometry correlates well with this finding, recording a total temperature increase of $\Delta T = 5.3$ K in the empty phantom. A good qualitative agreement between simulated and measured temperature profiles in presence of a stent was obtained in thermal simulations, fiber optic temperature measurements as well as MR thermometry data acquired at different time points. A saturation effect of the temperature increase was observed, underlying the importance of multi-modal measurements to back up physical claims. After 360s of continuous heating, the maximum temperature increase was always found close to the surface of the phantom. A critical time point from which on surface $SAR_{1g}$ values dominated the temperature increase over the induced stent equivalent $SAR_{1g}$ values was observed in simulation and measurement. For our experimental setup the temperature increase in a slice 2 cm below the RF antenna dominated the maximal temperature increase from ~96 s onwards. Prior to this time point, temperature increase at the tip of the stent equivalent showed maximal values. These findings are of high importance with regards to current safety guidelines that limit RF power based on a 6 minutes average. In the presence of the stent, the same total RF power can yield different temperature evolution. In MRI, the power input is often not continuous over the 6 min time period. Very short bursts of high peak power RF pulses are followed by scan interrupt e.g. for image technique preparation or postprocessing. The temperature increase dominated by the stent $SAR_{1g}$ may thus exceed safe exposure limits. More restrictive guidelines with shorter time averages e.g. 1 minute or 10s average might relax this condition.

Blood vessel and blood flow were included in the thermal simulation model to approach the realistic scenario of stent placement. Blood flow impacts the temperature increase by a cooling effect, reducing its maximal value resulting in enhanced temperature saturation effects. Our simulation models without blood flow showed that surface temperature values exceed stent equivalent temperature values from ~153s onwards. This transition prevails after only ~60s with a blood flow of $4 \cdot 10^{-6}$ $m^3/s$ [38-44]. It could further be demonstrated that restenosis delays this equilibrium. A perfect blood flow in the vessel is able to decrease induced temperature values at the tip of the stent equivalent by over 50%, while a stenosis of 90%, leaving only 10% of the vessel's cross section open to blood flow, invoked a reduction of 35% in temperature increase.

En route to a more realistic UHF CMR investigation at 7.0T, the presented results obtained throughout this study need to be validated in human voxel model simulations using customized cardiac RF coils developed for UHF CMR at 7.0T. Here various RF coil designs exist with loop [18, 21], stripline [59] or dipole antenna elements [20, 60] using a varying number of RF channels. For parallel transmission with arbitrary RF pulses played out by each transmit channel the RF field distribution can vary significantly. Notwithstanding the complexity of such scenario, one could imagine that the results on SAR estimation presented in this study could be included in safety models like the virtual observation points [61] or Q-matrices [62], to give an on-the-fly SAR estimation induced by coronary stents with arbitrary RF phase settings.

To summarize, both simulation and measurement results elaborate the electrodynamic interactions of coronary stents with RF fields used for UHF CMR at 7.0T. These results, while consistently reproduced through multi-modal measurement techniques, present an important precursor to investigate and define safe RF exposure limits in research and clinical CMR examinations.

Our achievements in this project will be presented during my talk at the 2014 annual meeting of the International Society of Magnetic Resonance in Medicine (ISMRM) in Milan.

En Route to Ultrahigh Field Cardiac MR in Patients: RF Safety Assessment of Intracoronary Stents at 7.0 T Using Numerical Simulations and E-Field Measurements

Eva Oberacker[1], Lukas Winter[1], Frank Seifert[2], Jaroslav Marek[1], Gerd Weidemann[2], Eugen Hofmann[3], and

Thoralf Niendorf[1,4]

[1]Berlin Ultrahigh Field Facility (B.U.F.F.), Max Delbrück Center for Molecular Medicine, Berlin, Berlin, Germany,

[2]Physikalisch Technische Bundesanstalt, Berlin, Germany,

[3]Biotronik AG, Bülach, Switzerland,

[4]Experimental and Clinical Research Center, a cooperation of the Charité Medical Faculty and the Max Delbrück Center for Molecular Medicine, Berlin, Germany

Target audience: Basic researchers and clinical scientists interested in MR safety considerations for scanning subjects with intracoronary stents at ultrahigh fields Purpose: A growing number of reports eloquently speak about explorations into cardiac magnetic resonance (CMR) at ultrahigh magnetic fields (UHF, $B_0 \geq 7.0$ T) [1]. Practical concerns are driving the notion that intracoronary stents are considered to be contraindications per se for UHF-CMR. Arguably, this notion is somewhat premature as is an a priori statement which declares stents to be safe at 7.0 T. To respond to the relative lack of data this work performs a careful safety evaluation of RF induced heating of coronary stents. For this purpose electromagnetic field coupling is investigated depending on stent geometry (length, location, orientation), vessel diameter and RF coil used. To meet this goal numerical electromagnetic (EM) and thermal simulations are performed in phantoms and in human voxel models. Simulations were validated by calibrated field probe measurements using an ASTM like phantom together with intracoronary stents common in clinical practice [2].

Methods: E-field coupling was investigated for clinically relevant stent lengths (l < 4 cm), coronary vessel diameters (d < 4 mm) and stent orientations ($\alpha$ = 0-90°) with regard to the E-field vector [3-4]. Stent locations were evaluated up to 12 cm depth which is common for LAD, LCX and RCA stenting [4]. EMF and thermal simulations were conducted with SEMCAD (SPEAG, Zurich, Switzerland) and CST Microwave Studio (CST GmbH, Darmstadt, Germany). For the EMF simulations a stent equivalent (Cu-tube), which provides a reasonable approximation of a coronary stent [5], was used for the sake of simulation time shortening. For the experiments coronary stents (l = 16, 40 and 60 mm, PRO-Kinetic Energy Cobalt Chromium Coronary Stent System, Biotronik, Bülach, Switzerland) were employed (Fig. 7.1A). A bowtie electric dipole antenna was used for RF transmission in simulations and experiments [6] (Fig. 7.1B) since this approach generates E-fields such that the Poynting vector is oriented perpendicular to the main axis of the dipole antenna (size: 15 cm) and hence affords defined E-field vectors in relation to the stent. Simulations were performed in materials mimicking myocardial tissue ($\varepsilon_1$ = 58.2, $\sigma_1$ = 0.77 S/m). E-field measurements were conducted using an E-field sensor (OEFS-S1B, Seikoh Giken, Japan) in an ASTM like phantom filled with a TWEEN20 water mixture ($\varepsilon_2$ = 59.6, $\sigma_2$ = 0.89 S/m) together with a previously proposed calibration method [7]. SAR was evaluated for 1 g mass averages resulting in cubes of $V_1$ = 1.3 $cm^3$ (Fig. 7.1C-D). Thermal simulations (mesh = (60x60x60) $\mu m^3$) were calculated with a CAD model of a stent. SAR assessment was conducted in human voxel models (ITIS Foundation, Zurich, Switzerland) using a TX/RX coil array tailored for CMR at 7 T [8].

Results: The results of max $SAR_{1g}$ and max $SAR_{10g}$ ($P_{in}$ = 1 W rms) of the stent configurations are shown in Fig. 7.2. $SAR_{10g}$ results (Fig. 7.2A-D) average out peak SAR values due to the sheer 10 g volume $V_2$ = 9.3 $cm^3$ versus the 1 g volume $V_1$ as indicated in Fig. 7.1C, D. The more realistic 1 g SAR values were found to be proportional with the power of 2 of the stent length ($R^2$ = 1) (Fig. 7.2A). Max $SAR_{1g}$ as a function of stent rotation follows a cosine ($R^2$ = 1) (Fig. 7.2B), while a change in stent diameter is not affecting max $SAR_{1g}$ significantly (Fig. 7.2C). An increase in the distance between the stent and the dipole antenna results in an exponential decay ($R^2$ = 1) of max $SAR_{1g}$ (Fig. 7.2D). For a single dipole antenna $SAR_{1g}$ values at the tip of the stent equivalent exceeded surface SAR values for a distance between the dipole and the stent of up to 5.1 cm (Fig. 7.2D). A linear correlation was found for the induced $SAR_{1g}$ peaks around the stent vs. the baseline SAR distribution w/o stent (Fig. 7.2D-F). Temperature simulations showed a saturation curve and revealed no local temperature peaks for the stent structure with the exception of the antenna effect at the tip of the stent (Fig. 7.2G-H). The absolute E-field simulation, measurement and calibration setup is shown in Fig. 7.3A-C. E-field probe measurements in the ASTM like phantom provided absolute E-fields which were about 12 % inferior to simulations (Fig. 7.3D) for the baseline (w/o stent), which is due to neglected losses of the dipole antenna. With the stent equivalent, the deviation of the measured E-field at the tip of the stent equivalent was $\Delta|\vec{E}|$ = -26 % vs. the simulations (Fig. 7.3E). Notwithstanding this deviation the normalized curves demonstrate a very good qualitative agreement between the simulations and the E-field measurements (Fig. 7.3F). E-field measurements of a stent (l = 4 cm) showed the antenna effect however with lower peak E-field values vs. Cu-tube (Fig. 7.3E). SAR evaluations in the human voxel model "Duke" using a stent equivalent placed in close proximity (x = 2 cm) to a 4 channel loop coil revealed a factor of $\Delta SAR_{max}$ > 4 when comparing $SAR_{1g}$ vs. $SAR_{10g}$.

Discussion: Our results show an overall agreement between E-field simulations and E-field measurements. Although our considerations are conservative since thermal heat sinks like blood flow were not included in our model, extra care is required for SAR considerations and RF coil power settings used in patients equipped with coronary stents at 7.0 T. Indeed, our results indicate that $SAR_{10g}$ estimates might severely underestimate local hotspots and temperature

changes induced by coronary stents. We anticipate extending our numerical simulations and E-field measurements to TX arrays other than bow tie dipole antennas. These efforts shall include a broad range of RF shim settings to validate and generalize the observations made in this study en route to UHF-MR in patients with intracoronary stents.

Conclusion: Our simulations and measurements provide guidance for the safety assessment of UHF-CMR of patients with intracoronary stents. The approach proposed here can be transferred to a broad range of RF coil designs, stent types and stent configurations including vascular stents, which would be of tremendous help to determine safe RF exposure levels for SAR personalized UHF-MR exams.

References: [1] Niendorf T, et al., JMR, 2012 [2] ASTM F2182-11 [3] Christiansen E, et al., The Lancet, 2013 [4] Bakhai A, et al., Int J. Cardiol.,2004 [5] Santoro D, et al., PLOS ONE, 2012 [6] Winter L, et al., PLOS ONE, 2013 [7] Seifert F, et al., ISMRM Proc., 2011 [8] Dieringer M, et al., JMRI, 2011

Acknowledgements: This work was supported by EMRP grant HLT06. The EMRP is jointly funded by the EMRP participating countries within EURAMET and the European Union.

Glossary

| | |
|---|---|
| ASTM | American Society for Testing and Material |
| B.U.F.F. | Berlin Ultrahigh Field Facility |
| $B_1^+$ | Transmit magnetic field for spin excitation |
| CAD | Coronary Artery Disease OR Computer Aided Design |
| CMR | Cardiac Magnetic Resonance Imaging |
| CNR | Contrast to Noise Ratio |
| CSF | Cerebrospinal Fluid |
| DIVA | Discreet Vasculature - Thin Wire |
| EMF | Electro Magnetic Field |
| FDTD | Finite Difference Time Domain |
| FEM | Finite Element Method |
| FIT | Finite Integration Technique |
| FOV | Field of View |
| IEC | International Electrotechnical Commission |
| LAD | Left Anterior Descending |
| LCX | Left Circumflex |
| MOM | Method of Moments |
| MR | Magnetic Resonance |
| MRI | Magnetic Resonance Imaging |
| MRTh | Magnetic Resonance Thermometry |
| NMR | Nuclear Magnetic Resonance |
| NWA | Networkanalyzer |
| PRF | Proton Resonance Frequency |
| PTB | Physikalisch Technische Bundesanstalt |
| PTFE | Polytetrafluoroethylene (Teflon) |
| RCA | Right Coronary Artery |
| RF | Radiofrequency |
| RFPA | Radiofrequency Power Amplifier |
| SAR | Specific Absorption Rate |
| SNR | Signal to Noise Ratio |
| S-parameter, $S_{11}$ | Scatter Parameter, send from and reflected to port 1 |
| UHF | Ultrahigh Field |

Tables

Table 1.1: Survey of the stent length and stent diameter commonly used for intracoronary stent implementation in the main coronary arteries (LMA: left main artery, LAD: left anterior descending artery, LCX: left circumflex, RCA: right coronary artery).

| # stented segments | LMA [%] | LAD [%] | LCX [%] | RCA [%] | stent length [mm] | | | vessel diameter [mm] | | |
|---|---|---|---|---|---|---|---|---|---|---|
| | | | | | Mean | Min | Max | Mean | Min | Max |
| 1433 (27) | 1.4 | 43.7 | 20.2 | 29.7 | 21.9±14.9 | | | 2.92±0.52 | | |
| 2796 (27) | 2.2 | 38.6 | 18.7 | 34.9 | 18.6±12.0 | | | 3.12±0.52 | | |
| 1229 (29) | 1.4 | 40.7 | 23.2 | 33.2 | 15 | 10 | 20 | 3.2 | 3 | 3.5 |
| 1239 (29) | 1.4 | 40.9 | 22.5 | 34.4 | 15 | 10 | 20 | 3.3 | 3 | 3.6 |
| 150 (28) | | 38 | 37 | 25 | 10; 18 | | | 2.2±0.4 | | |

Table 1.2: Summary of the stent length dependent normalized coefficients A and B which were derived from fitting equation (3) to the stent orientation dependent maximum $SAR_{1g}$ induction at the tip of the stent equivalent. Maximum $SAR_{1g}$ as a function of the rotation angle $\gamma$ between the long axis of the stent equivalent and the E-field vector was derived from numerical EMF simulations. The corresponding coefficient of determination ($R^2$) and the root mean square error (RMSE) represent the accuracy of the fit.

| stent length [cm] | coefficient A | coefficient B | $R^2$ | RMSE |
|---|---|---|---|---|
| 1 | 0.11 | 0.89 | 0.999 | 0.002 |
| 2 | 0.29 | 0.71 | 0.997 | 0.02 |
| 3 | 0.39 | 0.61 | 0.999 | 0.02 |
| 4 | 0.43 | 0.57 | 1 | 0.01 |

| | Phase Setting | Ch1 | Ch2 | Ch3 | CH4 | Ch5 | Ch6 | Ch7 | Ch8 |
|---|---|---|---|---|---|---|---|---|---|
| 4-channel Loop Coil | $PS_{B1+\ opt}$ | 144 | 180 | 161 | 88 | - | - | - | - |
| | PS1 | 320 | 344 | 196 | 50 | - | - | - | - |
| | PS2 | 54 | 92 | 302 | 91 | - | - | - | - |
| | PS3 | 292 | 87 | 334 | 126 | - | - | - | - |
| | PS4 | 71 | 90 | 221 | 170 | - | - | - | - |
| | PS5 | 126 | 298 | 210 | 197 | - | - | - | - |
| | PS6 | 329 | 103 | 272 | 271 | - | - | - | - |
| | PS7 | 137 | 204 | 27 | 19 | | | | |
| | PS8 | 191 | 280 | 335 | 47 | - | - | - | - |
| 8-channel Bow tie Array | $PS_{B1+\ opt}$ | 120 | 160 | 0 | 183 | 57 | 293 | 123 | 230 |
| | PS1 | 292 | 325 | 46 | 328 | 227 | 35 | 100 | 196 |
| | PS2 | 344 | 346 | 57 | 348 | 344 | 174 | 287 | 51 |
| | PS3 | 151 | 329 | 284 | 344 | 235 | 13 | 305 | 335 |
| | PS4 | 244 | 272 | 267 | 141 | 235 | 61 | 253 | 11 |
| | PS5 | 99 | 17 | 35 | 296 | 249 | 114 | 341 | 12 |
| | PS6 | 158 | 137 | 275 | 285 | 67 | 176 | 160 | 232 |
| | PS7 | 255 | 271 | 99 | 244 | 235 | 58 | 43 | 179 |
| | PS8 | 345 | 122 | 210 | 80 | 270 | 92 | 182 | 251 |

Table 1.3: Summary of the iphase settings used for a 4-channel loop coil and an 8-channel bow tie array. In addition to a phase setting ($PS_{B1+\ opt}$) optimized for $B_1$+ uniformity across the heart, eight randomly generated phase settings were included to evaluate peak $SAR_{1g}$ values using numerical EMF simulations and the analytical estimation given by equation 3.

Table 2.1: Gyromagnetic ratio and resonance frequency for common MRI nuclei at 1.5T, 3T and 7T.

| Nucleus | $\gamma^* = \gamma/2\pi$[MHz/T] | $f_0$(1.5T)[MHz] | $f_0$(3T)[MHz] | $f_0$(7T)[MHz] |
|---|---|---|---|---|
| $^1H$ | 42.6 | 63.9 | 127.8 | 298.2 |
| $^{13}C$ | 10.8 | 16.2 | 32.4 | 75.6 |
| $^{19}F$ | 40 | 60 | 120 | 280 |
| $^{23}Na$ | 11.3 | 16.95 | 33.9 | 79.1 |

Table 3.1: IEC limits for local SAR, partial body SAR and whole body SAR [3].

| SAR Limit → Operating Mode ↓ | Local SAR (Trunk) [W/kg] | Partial Body SAR [W/kg] | Whole Body SAR [W/kg] |
|---|---|---|---|
| Normal | 10 | $10 - 8 \cdot a$ | 2 |
| First Level Controlled | 20 | $10 - 6 \cdot a$ | 4 |

with the dynamic scaling factor $a = \frac{\text{exposed patient mass}}{\text{patient mass}}$.

Table 4.1: Relative frequency of the main coronary arteries affected by lesions requiring stenting together with length and diameter of the placed stent.

| # stented segments | LMA [%] | LAD [%] | LCX [%] | RCA [%] | Stent length [mm] | | | Vessel diameter | | [mm] |
|---|---|---|---|---|---|---|---|---|---|---|
| | | | | | Mean | Min | Max | Mean | Min | Max |
| 1433[7] | 1.4 | 43.7 | 20.2 | 29.7 | 21.9±14.9 | | | 2.92± 0.52 | | |
| 2796 [7] | 2.2 | 38.6 | 18.7 | 34.9 | 18.6±12.0 | | | 3.12±0.52 | | |
| 1229[8] | 1.4 | 40.7 | 23.2 | 33.2 | 15 | 10 | 20 | 3.2 | 3 | 3.5 |
| 1239 [8] | 1.4 | 40.9 | 22.5 | 34.4 | 15 | 10 | 20 | 3.3 | 3 | 3.6 |
| 150 [9] | | 38 | 37 | 25 | 10; 18 | | | 2.2 ± 0.4 | | |

Table 4.2: Dielectric, thermal and anatomical properties of blood and blood vessel wall used for temperature simulations as taken from literature [35, 37-45].

| | ρ [kg/m$^3$] | σ [S/m] | $\varepsilon_r$ | c [J/(kg·K)] | k [W/(K·m)] | |
|---|---|---|---|---|---|---|
| Blood | 1050 | 1.3 | 65.7 | 3617 | 0.52 | flow rate [m$^3$/s] |
| | | | | | | $4.10^{-6}$[38-44] |
| Vessel wall | 1102 | 0.537 | 48.3 | 3306 | 0.46 | wall thickness [mm] |
| | | | | | | [45,46] |
| | [36] | [36] | [36] | [36] | [36] | |

Table 5.1: Copper tube configurations used for EMF simulations in a rectangular phantom (20x30x8)cm$^3$ or (20x30x16)cm$^3$. The variable geometry and position should take individual anatomy and lesion size and location into account. The default values, if not being under investigation, are l = 4 cm, $d_{out}$ = 4.

| Length [cm] | Diameter [mm] | Orientation [°] | Depth [cm] |
|---|---|---|---|
| 1 | 2 | 0 | 2 |
| 2 | 3 | 30 | 4 |
| 3 | 4 | 60 | 6 |
| 4 | | 90 | 8 |
| | | | 10 |
| | | | 12 |

Table 5.2: Peak absolute E-field values induced by the antenna effect found in the evaluation plane parallel to the stent equivalent at 250 μm towards the antenna for the investigated stent configurations: varying length for reference diameter and position and varying orientation and position for reference length and diameter.

| l [cm] | $E_{max}$ [V/m] | γ [°] | $E_{max}$ [V/m] | $d_{out}$ [mm] | $E_{max}$ [V/m] | d [cm] | $E_{max}$ [V/m] |
|---|---|---|---|---|---|---|---|
| 1 | 96 | 0 | 288 | 2 | 361 | 2 | 837 |
| 2 | 164 | 30 | 261 | 3 | 319 | 4 | 519 |
| 3 | 234 | 60 | 156 | 4 | 288 | 6 | 312 |
| 4 | 288 | 90 | 39 | | | 8 | 123 |
| | | | | | | 10 | 135 |
| | | | | | | 12 | 59 |

Table 5.3: 1 g and 10g average SAR values on the evaluation plane at 150 μm for all copper tube configurations.

| l [cm] | $SAR_{1g}$ [W/kg] | $SAR_{10g}$ [W/kg] | $d_{out}$ [mm] | $SAR_{1g}$ [W/kg] | $SAR_{10g}$ [W/kg] | d [cm] | $LocSAR_{1g}$ [W/kg] | $LocSAR_{10g}$ [W/kg] |
|---|---|---|---|---|---|---|---|---|
| 1 | 0.52 | 0.40 | 2 | 2.93 | 0.73 | 2 | 1.36 | 1.34 |
| 2 | 0.99 | 0.47 | 3 | 2.98 | 0.76 | 4 | 0.48 | 0.49 |
| 3 | 1.87 | 0.61 | 4 | 2.88 | 0.78 | 6 | 0.16 | 0.17 |
| 4 | 2.88 | 0.78 | | | | 8 | 0.06 | 0.07 |
| | | | | | | 10 | 0.03 | 0.03 |
| | | | | | | 12 | 0.01 | 0.01 |

| | l = 1 cm | | l = 2 cm | | l = 3 cm | | l = 4 cm | |
|---|---|---|---|---|---|---|---|---|
| γ[°] | $SAR_{1g}$ [W/kg] | $SAR_{10g}$ [W/kg] | $SAR_{1g}$ [W/kg] | $SAR_{10g}$ [W/kg] | $SAR_{1g}$ [W/kg] | $SAR_{10g}$ [W/kg] | $SAR_{1g}$ [W/kg] | $SAR_{10g}$ [W/kg] |
| 0 | 0.52 | 0.40 | 0.99 | 0.47 | 1.87 | 0.61 | 2.88 | 0.78 |
| 30 | 0.49 | 0.40 | 0.86 | 0.45 | 1.52 | 0.56 | 2.27 | 0.68 |
| 60 | 0.44 | 0.39 | 0.58 | 0.41 | 0.81 | 0.45 | 1.03 | 0.49 |
| 90 | 0.41 | 0.39 | 0.41 | 0.39 | 0.40 | 0.39 | 0.40 | 0.39 |

| | l = 1 cm | | l = 2 cm | | l = 3 cm | | l = 4 cm | |
|---|---|---|---|---|---|---|---|---|
| d [cm] | $SAR_{1g}$ [W/kg] | $SAR_{10g}$ [W/kg] | $SAR_{1g}$ [W/kg] | $SAR_{10g}$ [W/kg] | $SAR_{1g}$ [W/kg] | $SAR_{10g}$ [W/kg] | $SAR_{1g}$ [W/kg] | $SAR_{10g}$ [W/kg] |
| 2 | 2.09 | 1.43 | 4.03 | 1.71 | 7.39 | 2.23 | 11.04 | 2.96 |
| 4 | 0.75 | 0.53 | 1.47 | 0.92 | 2.77 | 0.83 | 4.24 | 1.08 |
| 6 | 0.25 | 0.18 | 0.48 | 0.21 | 0.91 | 0.28 | 1.40 | 0.36 |
| 8 | 0.10 | 0.07 | 0.20 | 0.08 | 0.37 | 0.11 | 0.57 | 0.15 |
| 10 | 0.05 | 0.03 | 0.09 | 0.04 | 0.17 | 0.05 | 0.27 | 0.07 |
| 12 | 0.01 | 0.01 | 0.03 | 0.01 | 0.05 | 0.02 | 0.08 | 0.02 |

Table 5.4: Fitting coefficient and goodness of fit ($R^2$, RMSE) for cosine fit of orientation dependence and the slope of length dependence of induced SAR vs. baseline SAR.

| Stent Length [cm] | Coeff. A | Coeff. B | $R^2$ | RMSE | Slope a | $R^2$ | RMSE |
|---|---|---|---|---|---|---|---|
| 1 | 0.11 | 0.89 | 0.999 | 0.002 | 1.54 | 1 | 0.003 |
| 2 | 0.29 | 0.71 | 0.997 | 0.02 | 2.97 | 0.999 | 0.019 |
| 3 | 0.39 | 0.61 | 0.999 | 0.02 | 5.44 | 0.999 | 0.066 |
| 4 | 0.43 | 0.57 | 1 | 0.01 | 8.09 | 0.999 | 0.154 |

Table 5.5: Sensor positioning for temperature recording at a distance d from the phantom surface, where the RF antenna building block is positioned and the distance y from the isocenter of the RF antenna in parallel to the phantom surface for a tube length of l = 4 cm.

| | | |
|---|---|---|
| Sensor 1 | d = 0.25 cm<br>y = 0 | Surface sensor; positioned where the highest temperature increase was detected |

(continued)

| | | |
|---|---|---|
| Sensor 2 | d = 3 cm<br>y = 2.05 cm | Placed 1 cm above the copper tube middle axis (i.e. 7 mm above the upper tube edge) |
| Sensor 3 | d = 3.5 cm<br>y = 2.05 cm | Placed 0.5 cm above the copper tube middle axis (i.e. 3 mm above the upper tube edge) |
| Sensor 4 | d = 3.8 cm<br>y = 2.05 cm | Placed aligned with the upper tube edge |
| Sensor 5 | d = 4 cm<br>y = 2.05 cm | Placed aligned with the copper tube middle axis |

Table 5.6: Investigating restenosis of diverse severity and resulting effective vessel diameter $d_{in}$ yielding diverse temperature increase values $\Delta T$ at the tip of the copper tube. $\delta T$ indicates the cooling effect of the remaining blood flow; t is duration of heating after which maximum temperature increase is found at the phantom surface rather than the tip of the stent equivalent.

| Sten [%] | $d_{in}$ [mm] | $\Delta T$ [K] | $\delta T$ [%] | t [s] |
|---|---|---|---|---|
| 0 | 3.8 | 0.0564 | -57 | 63 |
| 20 | 3.4 | 0.0607 | -54 | 67 |
| 40 | 2.94 | 0.0642 | -51 | 71 |
| 60 | 2.4 | 0.0698 | -47 | 78 |
| 80 | 1.7 | 0.0794 | -40 | 89 |
| 90 | 1.2 | 0.0857 | -35 | 97 |
| 100 | No flow | 0.1321 | 0 | 152 |
| surface | | 0.203 | | |

Table 6.1: Amount of each component used for phantom filling preparation and resulting measured dielectric properties.

| | Water [l] | Agarose [g] | NaCl [g] | $CuSO_4$ [g] | $\sigma$ [S/m] | $\varepsilon$ |
|---|---|---|---|---|---|---|
| Empty phantom | 7.5 | 151.5 | 37.5 | 5.3 | 0.75 | 78.1 |
| Stent phantom | 7.5 | 151.5 | 37.5 | 5.3 | 0.8 | 79 |

Table 6.2: Sensor positioning for fiber optic temperature measurement during RF stent heating.

| | Depth [cm] | Position |
|---|---|---|
| Channel 1 | 2 | Centered underneath the antenna; upper PTFE tube |
| Channel 2 | 5 | Centered underneath the antenna, i.e. positioned at stent middle; lower PTFE tube |
| Channel 3 | 5 | Positioned at stent tip; lower PTFE tube |
| Channel 4 | ≈ 1.5 cm | Reference Sensor, positioned in an upper corner of the phantom with no expected temperature increase as a reference |

Figure Captions

Figure 1.1: Overview of the virtual setup to investigate RF induction phenomena in intracoronary stent configurations with a) varying geometry and positions inside a phantom. Comparison of the antenna effect induced by a stent as calculated by numerical EMF simulations using b) a difference time-domain (FDTD) method (SEMCAD X, SPEAG, Zurich, Switzerland) and c) a finite integration technique (CST MWS, CST GmbH, Darmstadt, Germany) showing no

significant difference in $SAR_{1g}$. d) A bow tie electric dipole antenna tuned to 300MHz was placed on top of a phantom filled with dielectric material resembling muscle tissue properties at 7.0T. A copper tube mimicking a stent (marked in yellow) was positioned inside the phantom material. e-f) E-field vector simulations for a sagittal plane through the RF antenna and the phantom without (e) and with (f) high resolved EMF simulations of a CAD model of an intracoronary stent (PRO-Kinetic Energy Cobalt Chromium Coronary Stent System, Biotronik, Bülach, Germany) at the location of the stent tip. g) Absolute E-field vector simulations for the stent equivalent at a larger distance of 5cm below the RF antenna building block and the resulting SAR profiles for an averaging mass of h) 1g and i) 10g.

Figure 1.2: Overview of the experimental setup used for the E-field measurements and the temperature measurements. a) Schematic view of the simulation model, E-field distribution and antenna effect of a stent placed inside an ASTM like phantom. b) Experimental setup implemented for the E-field measurements, which comprises a bow tie electric dipole antenna (f=300MHz) positioned on top of the ASTM like phantom. c) Photograph of the bow tie antenna building block (35) d) Photograph of the custom built device holder used during the E-field measurements. The holder was used to accomplish a reproducible distance of 2mm between the tube accommodating the E-field probes and the device under investigation. e) Detailed view of the RF antenna, coronary stent and E-field sensor placement in the ASTM like phantom. f) Calibration setup using a TEM cell together with the E-field sensor placement (37). g) Picture photograph of the experimental setup used for RF heating, MR thermometry and fiber optic temperature measurements in a 7.0T whole body MR scanner. h) Sagittal view of a 2D gradient echo MR image of the agarose phantom together with the bow tie antenna placement and the position of the coronary stent. MR thermometry covered the coronal slices I, II and III, with slice I being positioned right at the surface (2cm distance to the RF antenna building block) of the agarose phantom, slice II being placed on top of the stent equivalent and slice III being centred along the long axis of the stent.

Figure 1.3: Summary of results derived from numerical EMF simulations using a range of stent configurations. The graphs show the induced maximum $SAR_{1g}$ and $SAR_{10g}$ values as a function of a) stent length, b) stent diameter and c) stent rotation with respect to the main E-field vector. Depth dependent $SAR_{1g}$ and $SAR_{10g}$ distribution for the rectangular phantom d) without the stent at its target position and e) with the stent being positioned at various depths inside the phantom. f) Relation between $SAR_{1g}$ peak levels without a stent ($SAR_{1g(w/o)}$) and maximum $SAR_{1g}$ levels with a stent ($SAR_{1g(/w)}$) at its target position (2-12cm distance between the stent and the RF antenna) using stent lengths ranging from 1cm to 4cm. g) To generalize our findings derived from the EMF simulations of discrete stent configurations we deduced an analytical estimation (equation 3) which was used to generate a 2D surface plot (g) of $SAR_{1g_{stent}}(x_l,\gamma)$ for $SAR_{1g(w/o)}$ of 0.5W/kg.

Figure 1.4: Synopsis of results derived from E-field measurements using the experimental setup shown in Figure 2 a) Absolute E-field values derived from simulations (green line) and E-field probe measurements (blue line) along the tube accommodating the E-field probes in the ASTM phantom. The distance between the E-field probes and the bow tie antenna building block was 56mm. The bow tie building block was calibrated to 1W input power prior to the E-field measurements. b) Absolute E-field measurements of a copper tube (l=4cm, d=4mm) (red line) and a coronary stent (l=4cm, d=4mm) (PRO-Kinetic Energy Cobalt Chromium Coronary Stent System, Biotronik, Bülach, Germany) (blue line) positioned in the ASTM like phantom. For comparison the green line represents the E-field distribution along the stent derived from numerical EMF simulations of a copper tube (l=4cm, d=4mm)). c) Qualitative comparison between E-fields along the copper tube (l= 4cm, d=4mm) deduced from EMF simulations (green line) and E-field measurements (red line).

Figure 1.5: Overview of the results derived from a) numerical thermal simulations and b) MR thermometry. The temperature maps were acquired for a coronal plane through a rectangular phantom $(20x20x12)cm^3$ filled with myocardial tissue mimicking material ($\varepsilon_r = 79$, $\sigma = 0.8 S/m$). The slice of interest (slice *I* in Figure 2f) was positioned 2cm below the RF antenna. Temperature maps were acquired at minute 2, 4, 6 and 8 of the RF heating paradigm. For RF heating an effective input power of 77 W was applied for the simulations and the experiments, with the latter taking RF losses at the coil into account. Temperature maps derived from MR thermometry using a coronal plane through the phantom with a position c) slightly above the stent (slice *II* in Figure 2f) and d) through the middle of the stent (slice *III* in Figure 2f). After 2min of RF heating the antenna effect is clearly visible at the stent tips. With the progression of the heating paradigm the antenna effect deteriorates due to the saturation effect and thermal conduction along the copper tube. Please note the use of different colour scales for slice *I* (a-b) as compared to slice *II* (c) and slice *III* (d). MRTh showed much higher temperatures in surface regions of the phantom which are not influenced by RF induced antenna effects of the intracoronary stent at all. Please note that for the thermal simulations the total RF input power was reduced to 77 W to compensate antenna power losses of ~23% which were determined in the E-field probe measurements.

Figure 1.6: Synopsis of RF heating induced temperature changes obtained from fiber optic temperature measurements and MRTh. RF heating paradigm included 8 min duration and an input power of 100 W. The reference temperature probe was located in a region without RF heating. The surface temperature probe was located 2cm below the RF antenna. Two temperature probes were positioned at the stent tip and at the stent centre. Immediately after onset of RF power transmission the maximum temperature elevations were found at the stent tip which showed a saturation effect. At t=80s the temperature increase at the stent fell behind surface temperatures at 2cm of the RF heating paradigm.

After 2 min of RF heating, the highest temperature elevation of $\Delta T_{Fiber}$=3.0C° was found for the surface temperature probe rather for the temperature probe positioned at the tip of the stent equivalent. At this time point, the stent tip exhibited a temperature increase of $\Delta T_{Fiber}$=1.8C°. With progression of the RF heating paradigm maximum temperature changes were still most pronounced for the surface temperature probe which showed a temperature increase of up to $\Delta T_{Fiber}$=15.2C° after 8min. In comparison, the tip of the stent equivalent exhibited a temperature increase of only $\Delta T_{Fiber}$=5.1 C°. For comparison temperature changes derived from MR thermometry are shown. Please note that during MR thermometry, the RF transmission for RF heating was temporarily interrupted to allow acquisition of MR data.

Figure 1.7: Summary of the numerical EMF simulations using the *in vivo* human voxel model "Duke" from the virtual family (32). Two RF coil configurations customized for cardiac MR at 7.0T were employed: a-d) a 4-channel transmit/receive loop RF coil array (43) and e-h) an 8-channel transmit/receive bow tie electric dipole array (35). a, e) Schematic views of the 3D positioning of the anterior elements of the loop RF coil and the bow tie RF antennas on the anterior chest of the in vivo human voxel model. b, f) 3D view of the maximum $SAR_{1g}$ hotspots of the RF loop coil (maximum $SAR_{1g}$=10.6W/kg) and the bow tie dipole array (maximum $SAR_{1g}$=13.4W/kg) for a phase setting ($PS_{B1+opt}$) optimized for $B_1^+$ uniformity across the heart without the stent equivalent being positioned at the target position in the upper torso. c,g) Sagittal view of $SAR_{1g}$ distribution for a plane through the target position of the stent with the stent being not present. d,h) Sagittal view of $SAR_{1g}$ distribution for a plane through the target position of the stent prior with the stent being present. i,j) Simulated max $SAR_{1g(w/o)}$ and $SAR_{1g(/w)}$ with the stent compared to the SAR estimation based on equation (3) for i) the 4-channel loop coil and j) the 8-channel bow tie array using eight randomly generated phase settings summarized in in Table 3. Please note that after positioning of the stent max $SAR_{1g}$ observed for the four channel RF loop coil array increased by a factor of >4 to 43W/kg for ($PS_{B1+opt}$) and was found to be above local SAR level limits (dashed red line) given by current safety guidelines (12) for 5 out of 8 randomly generated RF phase settings. Our SAR estimation using equation (3), while conservatively overestimating SAR, was able to predict these induced $SAR_{1g}$ levels without the need to perform extra EMF simulations with a stent being present in the simulation model.

Figure 2.1: Static (left) and rotating (right) frame in MRI.

Figure 2.2: Slice selective gradient: When applying a broadband RF pulse ($\omega_0 \pm$ °$\Delta\omega$/2) simultaneously to a field gradient in z-direction, the resonance conditions are only met for a slice at $z_s$ with the thickness □z.

Figure 2.3: Excitation of the spins out of their equilibrium in the static (left) and rotating (right) frame.

Figure 3.1: Signal void due to destructive interference of the transmit field $B_1^+$(left) and signal gain by applying a phase shift between the different transmit channels (right) for CMR at 7T.

Figure 3.2: Bow tie antenna building block: Two symmetrical triangles on a holder plate placed in dielectric medium inside a Plexiglas box [20] a) Bow tie building block with dimensions designed for 300 MHz b) picture photograph of a 300 MHz bow tie building block viewed from the bottom, top and side.

Figure 3.3: Magnitude plot [dB] of the scatter parameter S11 for 300 MHz bow tie antenna a) very good adjustment to a small frequency range and b) good adjustment to a broader frequency range around the center frequency of 297 MHz.

Figure 4.1: Up: Induced electric field distribution around a copper tube (left) and a coronary stent (right) of the same dimensions (l = 40 mm, dout= 4 mm, t = 100 µm) at 297MHz; Down: Magnitude of the E-Field along a line parallel to the long axis of the copper tube (cyan) and the stent (red) centered at a distance of 100 µm towards the antenna.

Figure 5.1: Field calculation in Yee cells, i.e. two cubic cells of the same size shifted by half a space diagonal. Calculating the magnetic flux H→ through the faces of G puts the point of calculation at the same place as calculating E→ on the edges of G~.

Figure 5.2: Side view of the 8 cm phantom as set up for EMF simulations. From top to bottom, one can see the port connected to the antenna by PEC wires, the antenna building bloc and the Plexiglas phantom filled with dielectric medium containing the stent analog copper tube in the high resolution meshbox.

Figure 5.3: Comparison of the induced E-field profiles obtained for the different meshbox resolutions transversal to the tube, extracted on a line parallel to the long axis of the tube approximately 200 □m above it (a and c) and at approximately 1 mm distance (b and d) for a tube of 4 cm length (a and b, resolution of □x = □z = [0.05; 0.1; 0.2] in blue, green and red respectively) and 2 cm length'(c and d, resolution of □x = □z = [0.05; 0.2] in blue and red). The agreement of the E-field profiles obtained for different resolutions results in an almost perfect overlay of the profiles found on the extraction lines.

Figure 5.4: Broadband pulse used for excitation in the EMF simulations. Center frequency: f0 = 300 MHz, bandwidth $\Delta$f = 100 MHz, simulation time tsim = 120 ns.

Figure 5.5: Comparison of the EMF simulation results (absolute value of electric field) obtained under the same circumstances with CST (left) and SEMCAD X (right) using a rectangular phantom and a bow tie antenna at 297 MHz with an input power of Pin = 1W accepted power at port. The region of interest for stent placement is highlighted by a black box.

Figure 5.6: Display of the electric field distribution (absolute value and vector field view) in the empty phantom underneath the antenna in the region of interest for stent placement in EMF simulations. Arrow length depends on the

field strength and arrow density on the resolution. Please note that the arrow color does not correspond to the color scale used for the E-field.

Figure 5.7: Induced electric field distribution in the reference setup (l = 4 cm, d = 4 cm, γ = 0° in the 8 cm phantom) with induced antenna effect at the tips of the stent equivalent.

Figure 5.8: Simulated E-field distribution around the stent equivalent caused by the antenna effect. The extent of the induced field exceeds the high resolution meshbox .

Figure 5.9: Left: Simulated E-field distribution in the 8 cm phantom around the tip of a stent equivalent of a) l = 1 cm, b) l = 2 cm, c) l = 3 cm and d) l = 4 cm. e) Peak values for the induced electric field strength extracted from the evaluation plane 250 □m above the stent equivalent.

Figure 5.10: a) Dependency of the effective antenna length on the orientation with respect to the field lines. b) Maximum E-field values in the extraction plane at 250 μm towards the antenna for different stent orientations in the 8 cm phantom.

Figure 5.11: Influence of the tube diameter on the induced E-field. a) Maximum absolute E-field values extracted in a plane 250μm above the stent equivalent b) E-field distribution in the evaluation plane for dout = 4 mm c) E-field distribution in the evaluation plane for dout = 2 mm.

Figure 5.12: Maximum values of the electric field strength in the 16 cm phantom in the evaluation plane at 250 □m above the stent equivalent, induced by the antenna effect of a l = 4cm, dout = 4mm copper tube at different distances between the tube and the antenna with an exponential fit ($R^2$ = 0.98).

Figure 5.13: a) E-Field distribution, b) 1g SAR distribution with averaging volume and c) 10g SAR distribution with averaging volume for the induced RF antenna effect for a l = 4 cm, dout = 4 mm stent equivalent at 4 cm in the 8 cm phantom.

Figure 5.14: Overview over the 1 g and 10g avg SAR values for all simulation setups a) length dependence b) influence of diameter c) normalized orientation dependence d) depth dependence of baseline SAR in empty phantom e) depth dependence of induced SAR for a 4 cm stent equivalent f) induced 1 g avg SAR vs. baseline 1 g avg SAR for all tube lengths.

Figure 5.15: Depiction of the 8 cm simulation model used for blood flow investigations, including blood, vessel wall and tube together with the stent equivalent in the high resolution meshbox and pointwise temperature sensors embedded in dielectric medium.

Figure 5.16: Influence of blood and blood vessel wall embedded in the EMF and thermal simulations on the induced antenna effect and the evoked heating. Point SAR (a) and temperature (b) distribution in the homogeneous phantom and in the presence of a blood vessel (c+d).

Figure 5.17: a) Positioning with respect to the stent and enumeration of the sensors recording the temperature evolution. b) Section of the blood vessel illustrating vessel wall thickness, stent thickness and vessel cross section for restenosis of 0%, 40% and 90%.

Figure 5.18: Temperature evolution recorded by the five sensors in presence of a blood vessel without bloodflow 4 cm underneath the antenna, an input power of Pin = 1W and a simulation time of 360 s in the 8 cm phantom.

Figure 5.19: a) Zoom in the center slice through the stent equivalent in the 8 cm phantom depicting the temperature distribution in presence of a blood vessel and blood flow 4 cm underneath the antenna for an input power of Pin = 1 W and a simulation time of 360 s. Maximum temperature increase is recorded close to the phantom surface marked by a green dot and b) Temperature evolution recorded by the five point sensors.

Figure 5.20: Influence of restenosis (in percentage of the vessel's cross section) a) on the maximum temperature increase at the tip of the stent equivalent and b) on the time point at which surface heating exceeds heating caused by the stent equivalent.

Figure 6.1: a) Schematic setup of the optical electric field sensor used for this study [51], b) Schematic view of an older setup detailing the antenna structure of the optical modulator.

Figure 6.2: E-Field probe sensor a) without the probe shell, revealing the positioning of the sensor chips b) Antenna orientation on the three sensor chips when placed in the position '0°'.

Figure 6.3: Outer (a) and inner (b) dimensions of the ASTM like phantom used for electric field validation measurements and the according simulations.

Figure 6.4: Difference between the a) regular gridder with high resolution in the meshbox and its projection along the axes and lower resolution in the phantom and b) gradual grid generator: The mesh was refined for the stent equivalent and the narrow gridlines flow out with increasing distance to the object until reaching the settings for the phantom material

Figure 6.5: E-field distribution in the ASTM phantom induced by a 4 cm copper tube placed on a holder atop of the probe holder for E-field sensor positioning a) depicted with the entire phantom and the field sensor for recording of the simulation results and b) zoomed view of the E-field around the stent equivalent extracted from the field distribution in a)

Figure 6.6: E-field profiles along multiple extraction lines parallel to and centered underneath the stent equivalent

in a) the upper and b) the lower half of the probe holder.

Figure 6.7: Experimental setup used for the E-Field validation measurements. a) 1.6 cm coronary stent placed on the holder designed for this purpose. b) Setup of a bow tie electric dipole antenna matched to 297 MHz on the ASTM like phantom used for simulation and measurement, viewed from above. c) Zoomed side view of the RF antenna, coronary stent and E-field sensor placement in the ASTM like phantom. d) Calibration setup using a TEM cell together with the E-field sensor

Figure 6.8: Challenges using the non-punctual E-field probe: a) Ambiguity of the positioning of the measuring channels in the E-field probe sensor caused by horizontal symmetry and E-Field decay in the probe holder along the green line for b) the empty phantom (-11 V/m) and c) in presence of a stent equivalent (-60 V/m) encountered for different sensor positions.

Figure 6.9: Simulated E-field profiles along the probe holder tube in the ASTM phantom at the supposed sensor positions. a)-c) Data set 1: Sensor orientations 0°, 120°, 240°. d)-f) Data set 2: sensor orientations 60°, 180°, 300°. g) Average over data set 1 (blue) and 2 (red). h) Average over all profiles.

Figure 6.10: Measured absolute E-field values in the presence of a 4 cm copper tube. a) Data set 1: sensor position 0°, 120°, 240° (blue), Data set 2: sensor positions 60°, 180°, 300° (red). b) Averaged result of both data sets.

Figure 6.11: Comparison of the simulated and measured E-field profiles a) in the empty phantom b) for a copper tube (simulation and measurement) and a coronary stent (measurement). c) comparison of the normalized profiles for the copper tube.

Figure 6.12: Stent phantom (20x30x12)$cm^3$ before filling, equipped with two PTFE tubes for optical temperature sensor positioning at d1 = 2 cm and d2 = 5 cm and a 4 cm stent placed around the lower tube.

Figure 6.13: Temperature evolution curves in the empty phantom with the sensor centered underneath the antenna at a depth of d = 5 cm for simulation (Pin = 74 W, green) and experiment (Pin = 100 W, blue). Heating periods evoke linear temperature increase while the high specific heat capacity of the phantom material enables longer measuring windows for MRTh data acquisition with negligible temperature decrease.

Figure 6.14: Temperature maps obtained with MR thermometry (Pin = 100 W) (a+c)-and simulation (Pin = 74 W) (b+d) after 10 minutes of heating in a sagittal (a+b) and axial (c+d) view. The high temperatures at the upper right side in a are caused by artifacts due to B0-inhomeneities.

Figure 6.16: MR localizer image with the stent phantom and oil reference probe indicating the stent placement and the slices chosen for MRTh. Slice a is positioned along the upper and slice c along the lower PTFE tube.

Figure 6.17: Temperature distribution maps acquired throughout the stent heating simulation (Pin = 77W) (a) in slice a and experiment (Pin = 105 W) (b-d) in three coronary slices at t = [2,4,6,8] min. Please note the different colorscales for slice a versus slice b and c.

Figure 6.18: Temperature curves recorded with fiber optic sensors during the stent heating experiment together with single temperature values extracted from MR thermometry. Channel 1: d = 2 cm, centered underneath the antenna; Channel 2: d = 5 cm, centered underneath the antenna, i.e. positioned at the stent middle; Channel 3: d = 5 cm, positioned at the tip of the stent; Reference: placed at a sufficient distance to the antenna to be unaffected by the heating experiment.

Figure 6.19: Temperature curves obtained in a stent equivalent heating simulation for a homogeneous phantom at the sensor positions equivalent to the heating experiment. Channel 1: d = 2 cm, centered underneath the antenna; Channel 2: d = 5 cm, centered underneath the antenna, i.e. positioned at the stent middle; Channel 3: d = 5 cm, positioned at the tip of the stent; Reference: placed at a sufficient distance to the antenna to be unaffected by the heating experiment.

Figure 7.1: Picture photograph of A) the investigated stent type and B) the measurement setup. C) E-Field simulations with a stent equivalent showing the antenna effect and D) the resulting $SAR_{1g}$ distribution at its tip.

Fig. 7.2: Dependence of the induced max SAR1g and SAR10g based on length (A), orientation (B), diameter (C) and depth (D) of a stent and w/o a stent (E). Correlation of the 1 g SAR curves w/ and w/o stent equivalent (F). G) Thermal simulations (6 min) of a CAD model of a stent and H) temperature saturation curve (30 s) for a stent equivalent.

Fig. 7.3: ASTM simulation (A) and measurement (B) setup. C) TEM cell for E-field sensor calibration. D) Simulations (green) vs. measurements (blue) w/o stent. E) Simulations (green) vs. measurements w/ stent equivalent (red) and stent (blue). F) Normalized comparison of simulations (green) vs. measurements w/ stent equivalent (red).

## Claims

1. Method for the assessment of radiofrequency induced power absorption, in particular heating of conducting implants, in particular intercoronary stents during magnetic resonance imaging by calculating a specific absorption rate (SAR) using a mathematical model, the model comprising a dependency of the absorption rate from a COS-function of the angular position between the long axis of the stent and the E-field-vector.

2. Method according to claim 1, **characterized in that** the model comprises a dependency upon the term A x COS

(2γ) + B, in particular γ being the rotation angle between the long axis of the implant and the E-field vector and A and B being normalized coefficients representing the length of the implant, particularly a stent.

**3.** Method according to anyone of the preceding claims, **characterized in that** the model is derived by

• defining the boundary conditions for an investigated clinical implant, in particular these boundary condition being the geometry and/or shape and/or material of implant and / or positions inside the human body
• performing electromagnetic field simulations and/or thermal simulations and validation measurements in a preferably uniform phantom to determine at least one critical parameter that influences induced SAR levels, in particular the parameter being the length of implant, and/or the position with relation to the E-field vector and / or SAR levels at location of implant particularly without the presence of the implant
• generation of fitting functions that match induced SAR levels of a single critical parameter
• merging of the results into the multi-parametric SAR estimation.

**4.** Method according to claim 3, **characterized by** the validation of the SAR estimation as compared to simulations in realistic human voxel models including the medical implant.

**5.** Method for designing MRI coils and / or implants, in particular coronary stents in such a way that the design of coil / implant is in compliance with a value, in particular less than a value calculated in accordance with a method according to anyone of claims 1 to 4.

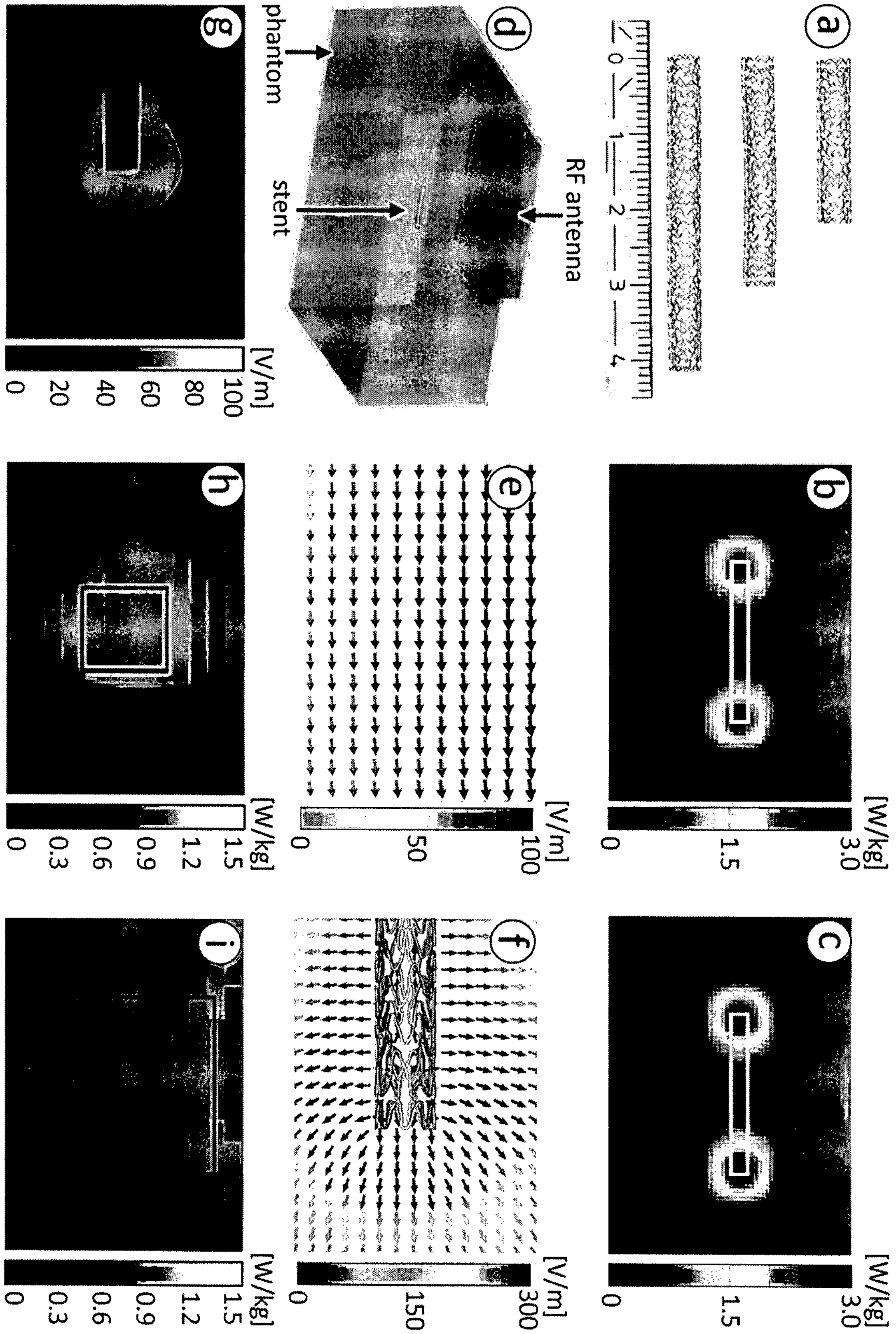
a
b
c
d
e
f
g
h
i
RF antenna
stent
phantom
0 1 2 3 4
[W/kg]
3.0
1.5
0
[V/m]
100
50
0
[V/m]
300
150
0
[V/m]
100
80
60
40
20
0
[W/kg]
1.5
1.2
0.9
0.6
0.3
0

Figure 1.1

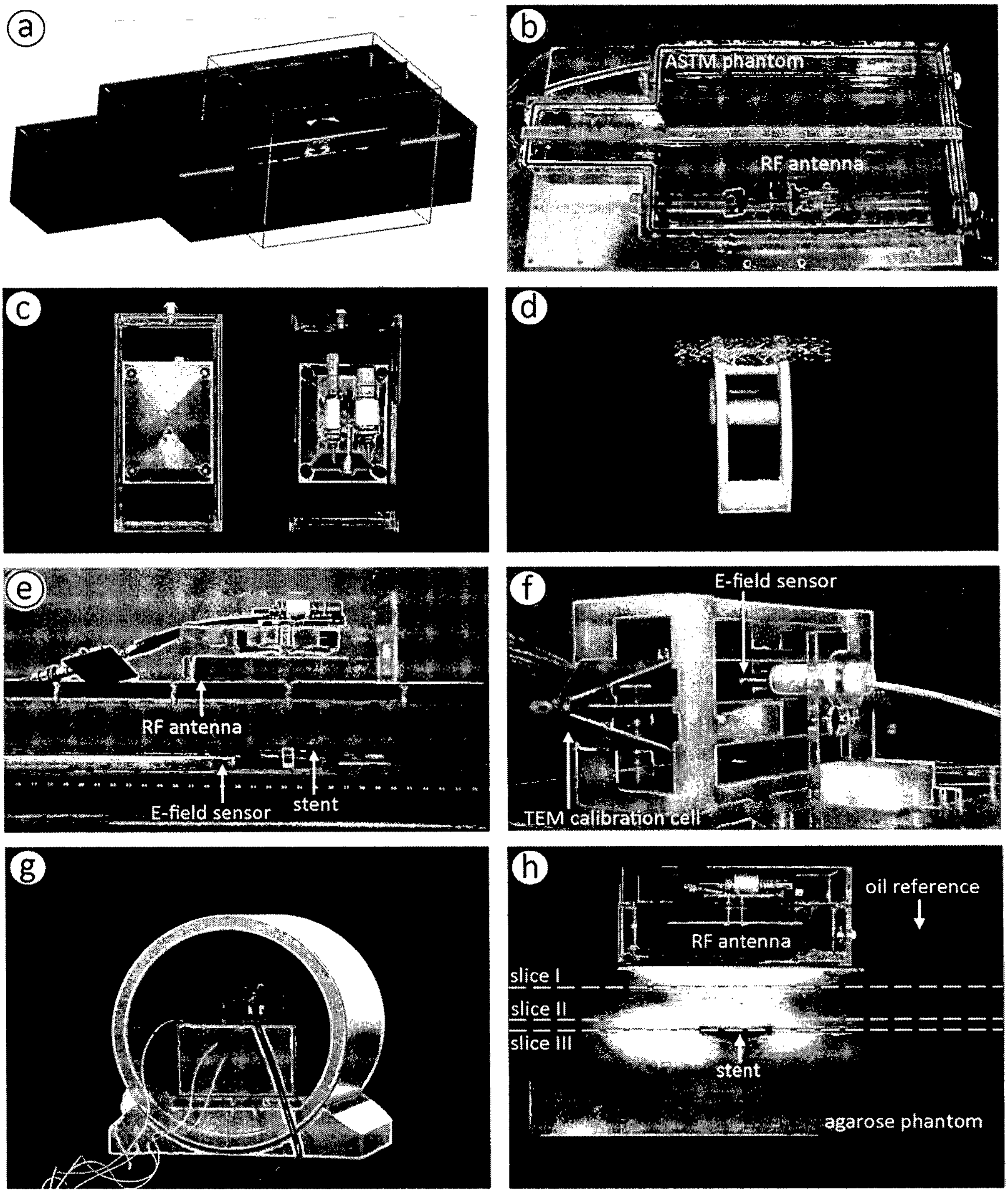
a
b
ASTM phantom
RF antenna
c
d
e
RF antenna
E-field sensor
stent
f
E-field sensor
TEM calibration cell
g
h
oil reference
RF antenna
slice I
slice II
slice III
stent
agarose phantom

Figure 1.2

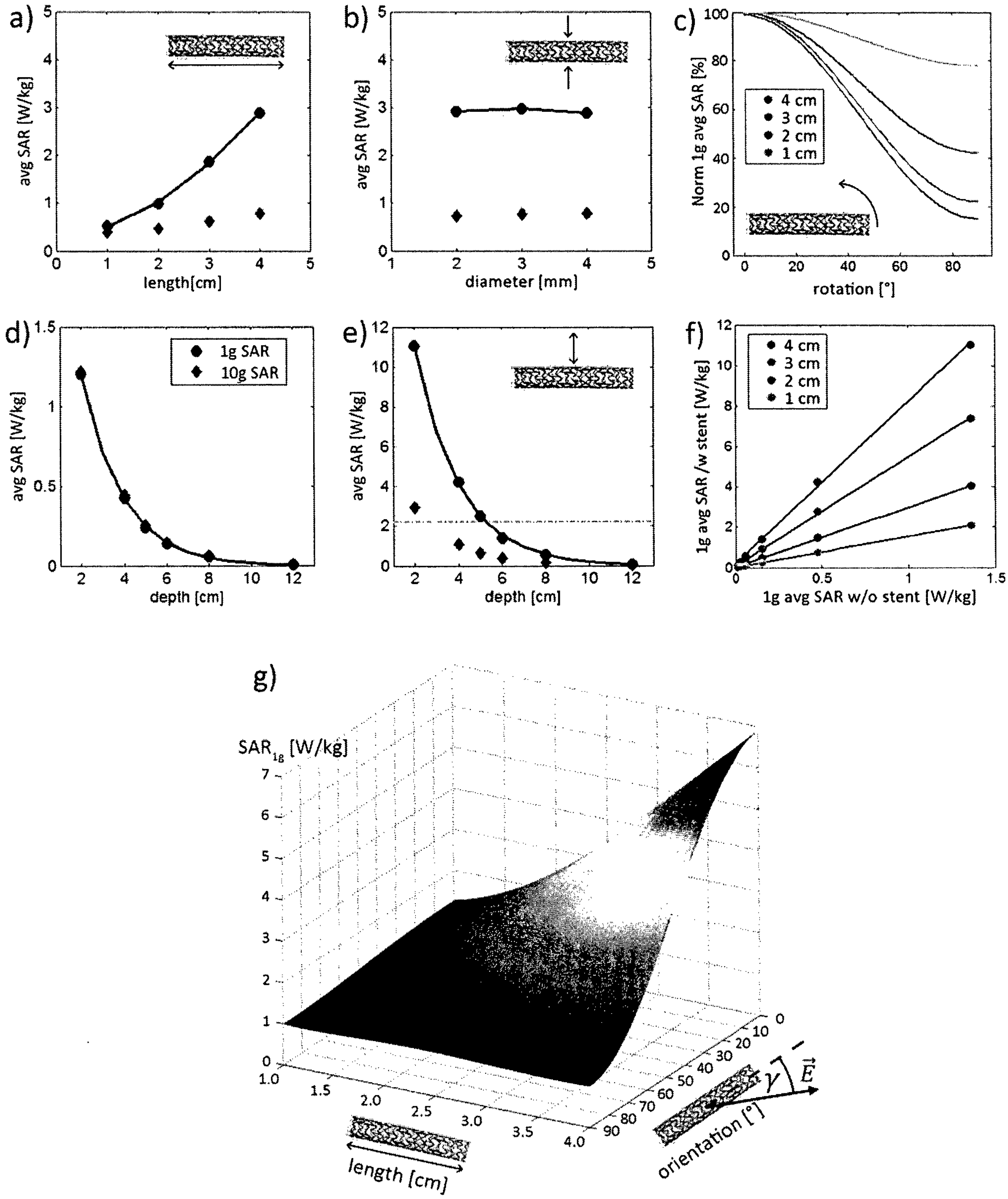
a)
avg SAR [W/kg]
length[cm]
b)
avg SAR [W/kg]
diameter [mm]
c)
Norm 1g avg SAR [%]
4 cm
3 cm
2 cm
1 cm
rotation [°]
d)
1g SAR
10g SAR
avg SAR [W/kg]
depth [cm]
e)
avg SAR [W/kg]
depth [cm]
f)
4 cm
3 cm
2 cm
1 cm
1g avg SAR /w stent [W/kg]
1g avg SAR w/o stent [W/kg]
g)
SAR1g [W/kg]
length [cm]
orientation [°]
γ
E

Figure 1.3

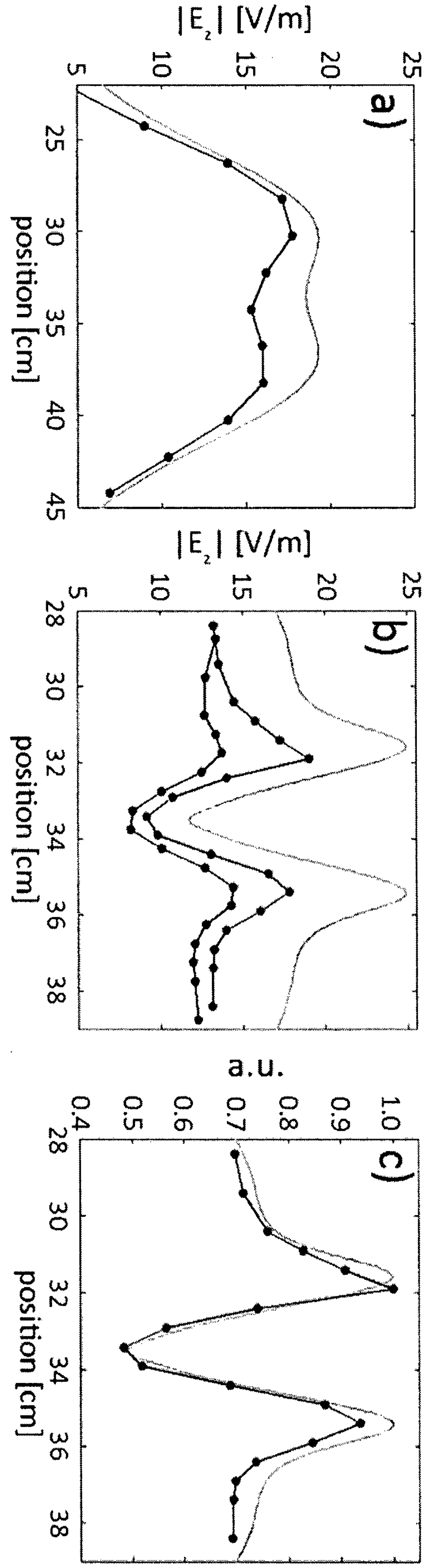


Figure 1.4

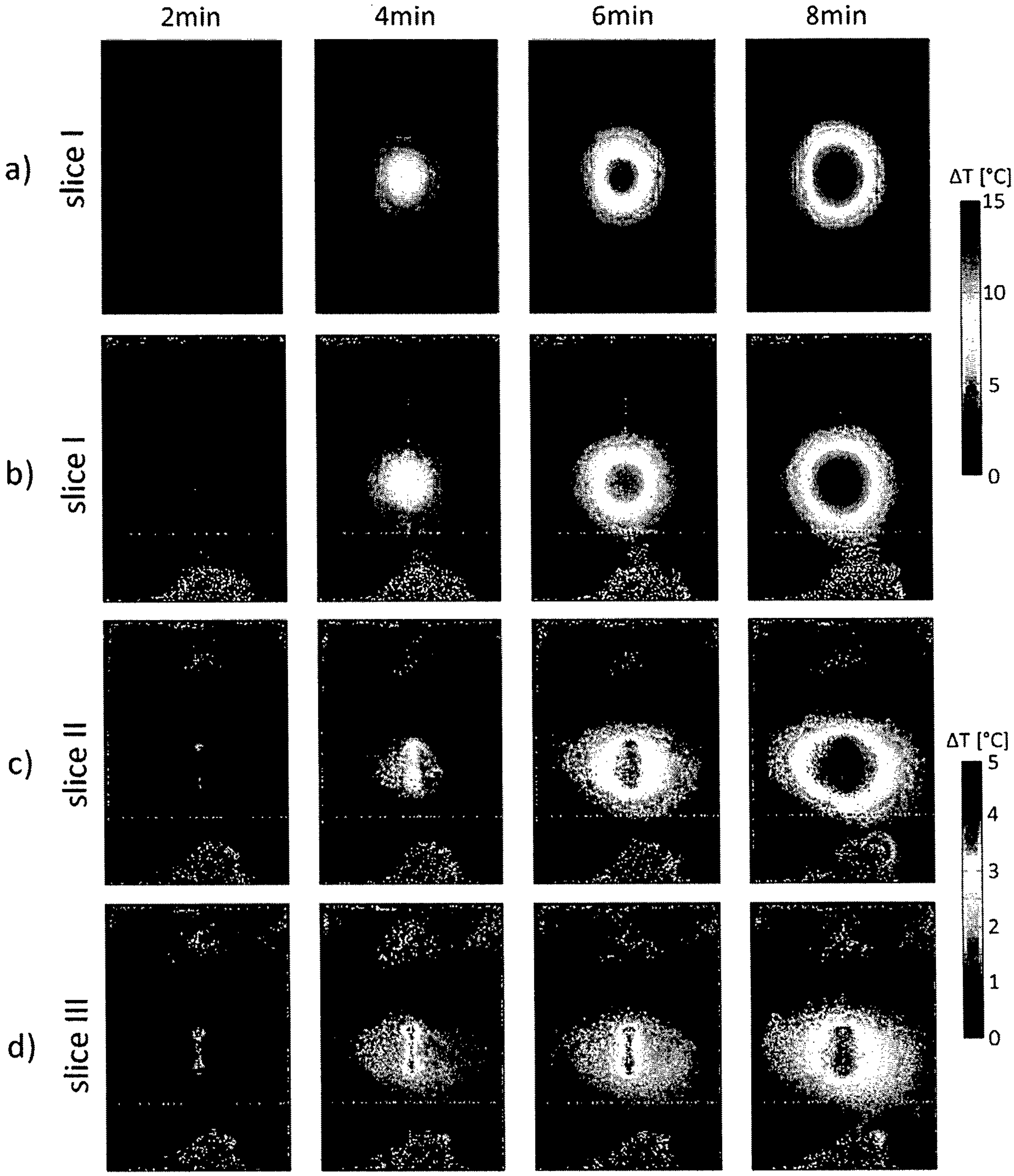
2min
4min
6min
8min
a)
slice I
b)
slice I
c)
slice II
d)
slice III
ΔT [°C]
15
10
5
0
ΔT [°C]
5
4
3
2
1
0

Figure 1.5

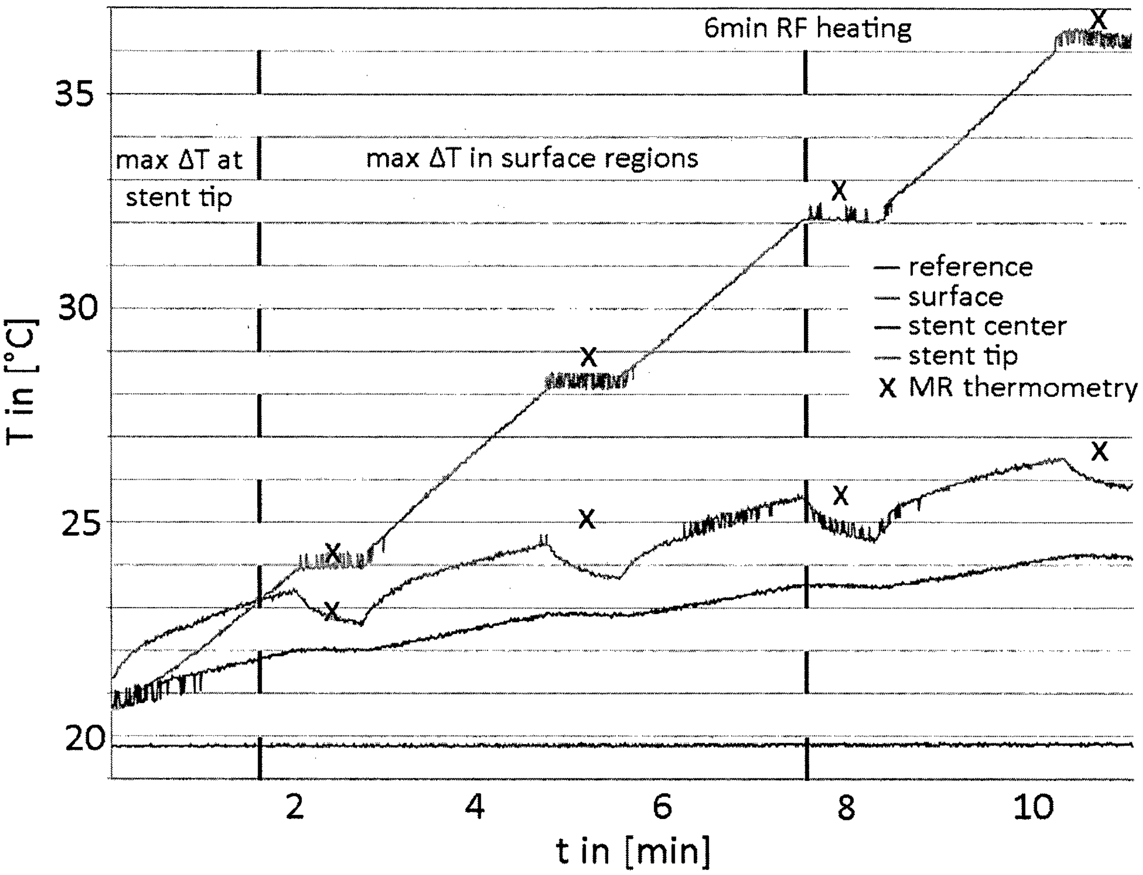
6min RF heating
max ΔT at stent tip
max ΔT in surface regions
— reference
— surface
— stent center
— stent tip
X MR thermometry
35
30
25
20
T in [°C]
2
4
6
8
10
t in [min]

Figure 1.6

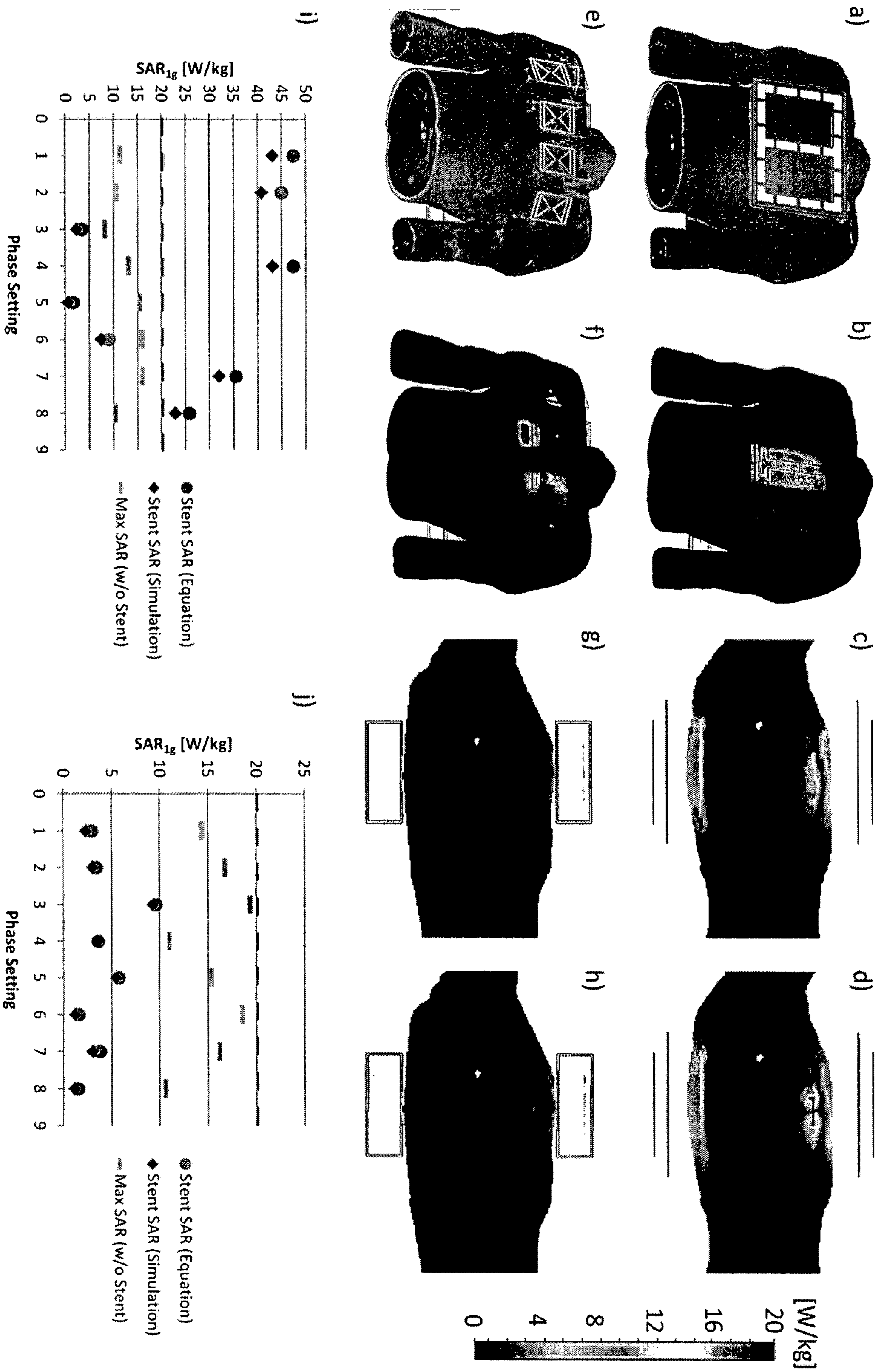
a)
b)
c)
d)
e)
f)
g)
h)
i)
j)
[W/kg]
0
4
8
12
16
20
SAR1g [W/kg]
Phase Setting
Stent SAR (Equation)
Stent SAR (Simulation)
Max SAR (w/o Stent)

Figure 1.7

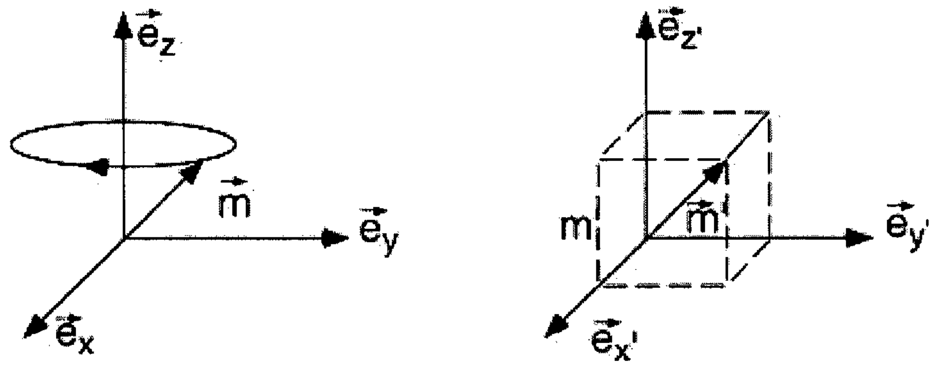


Figure 2.1

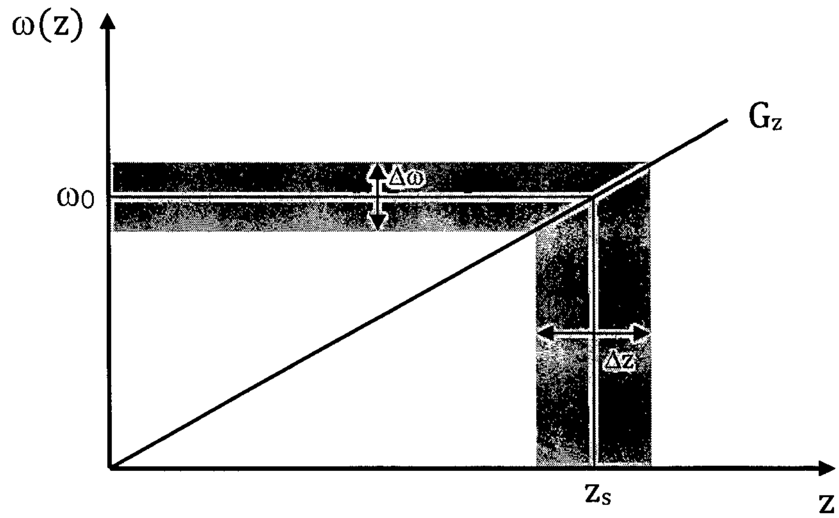


Figure 2.2

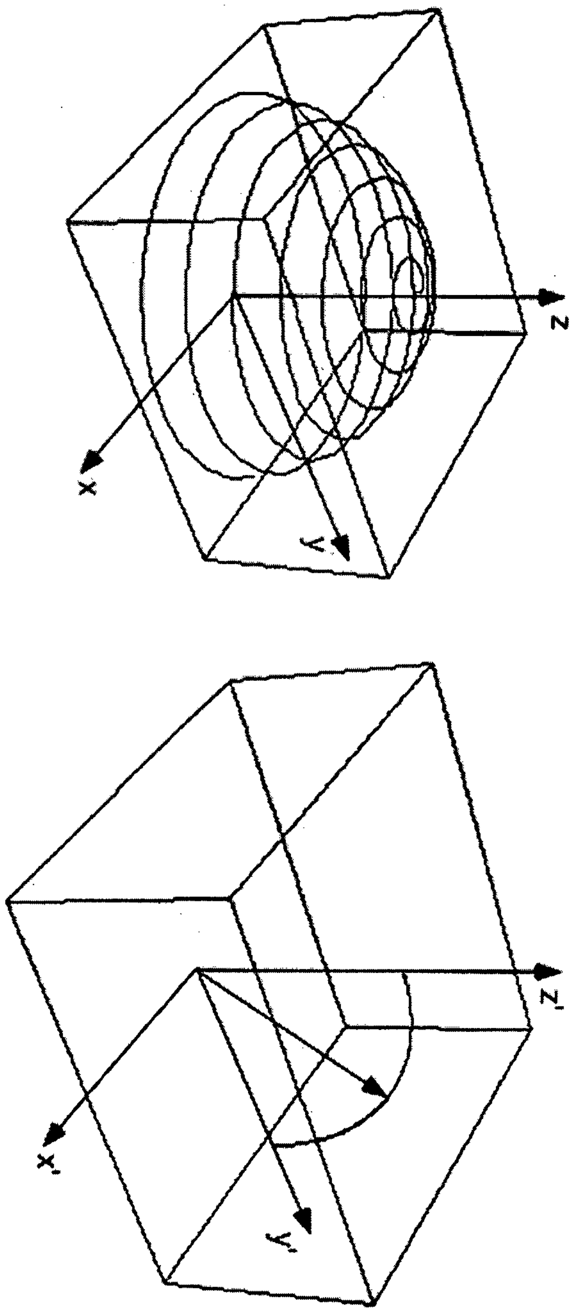


Figure 2.3

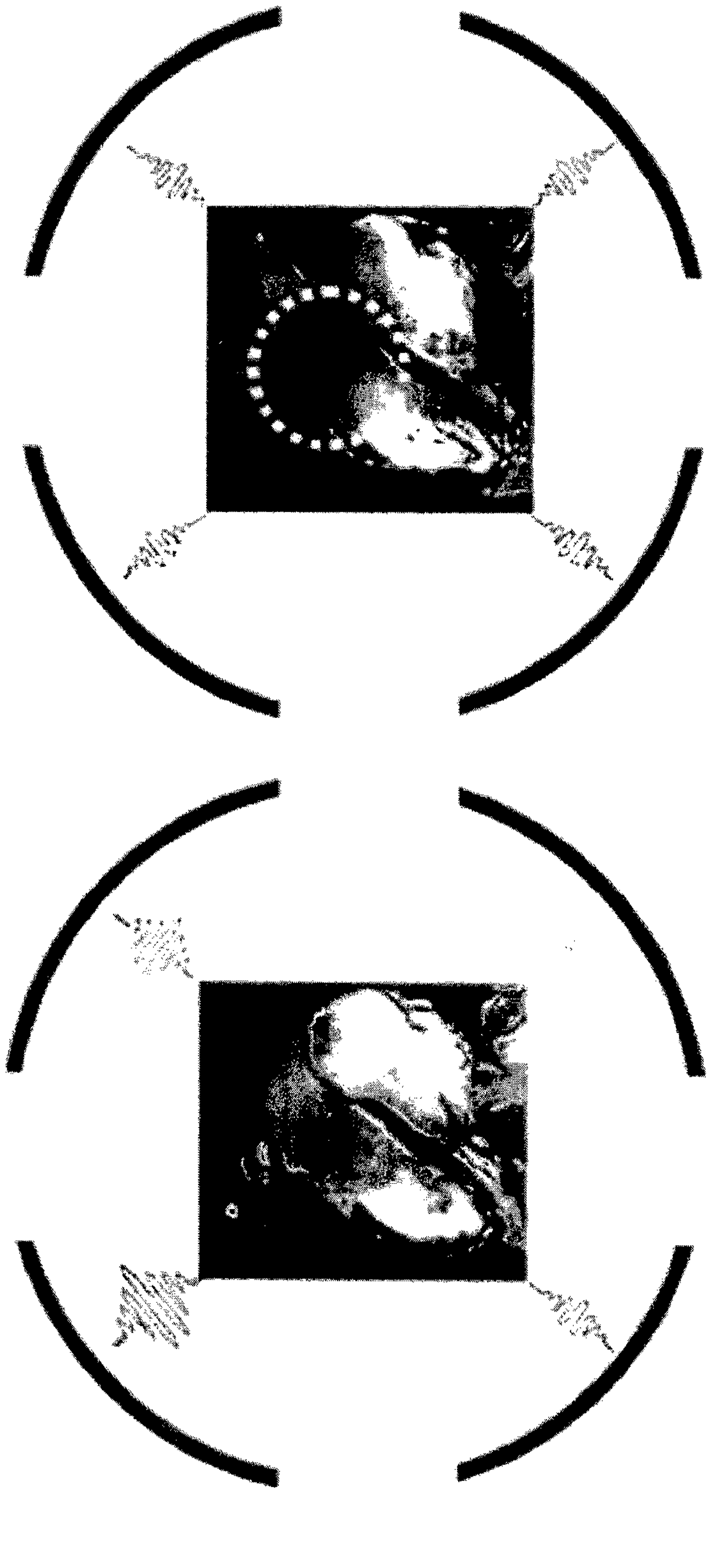

Figure 3.1

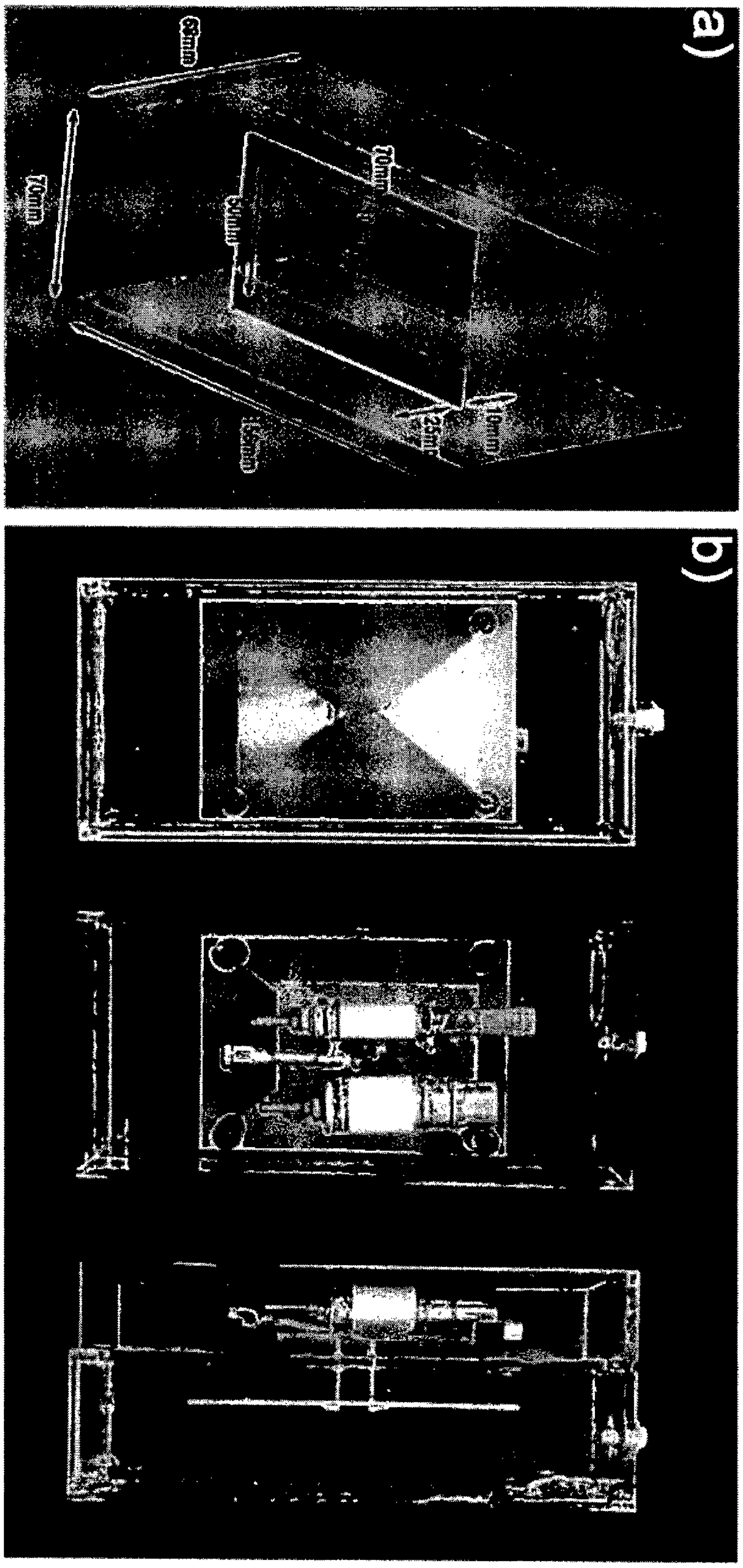


Figure 3.2

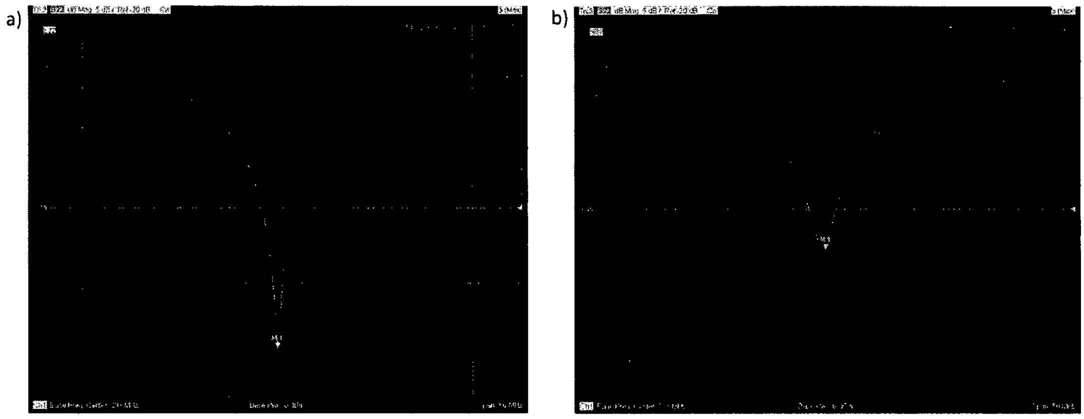

Figure 3.3

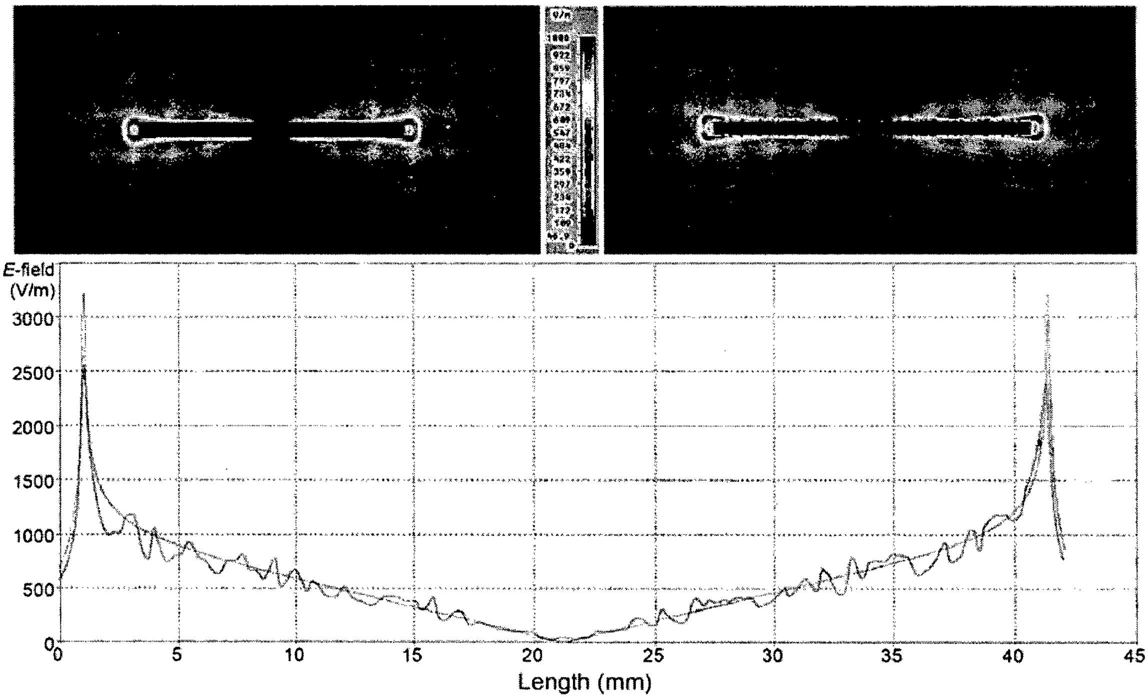


Figure 4.1

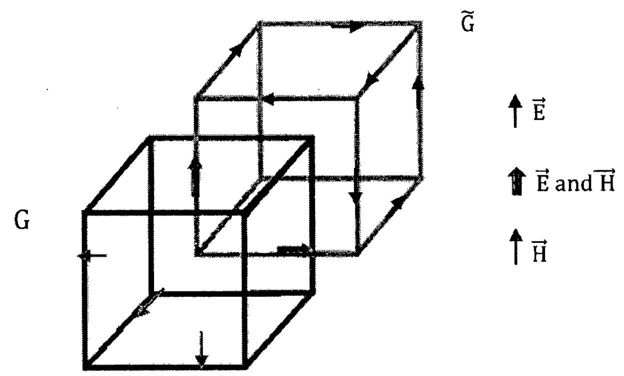


Figure 5.1

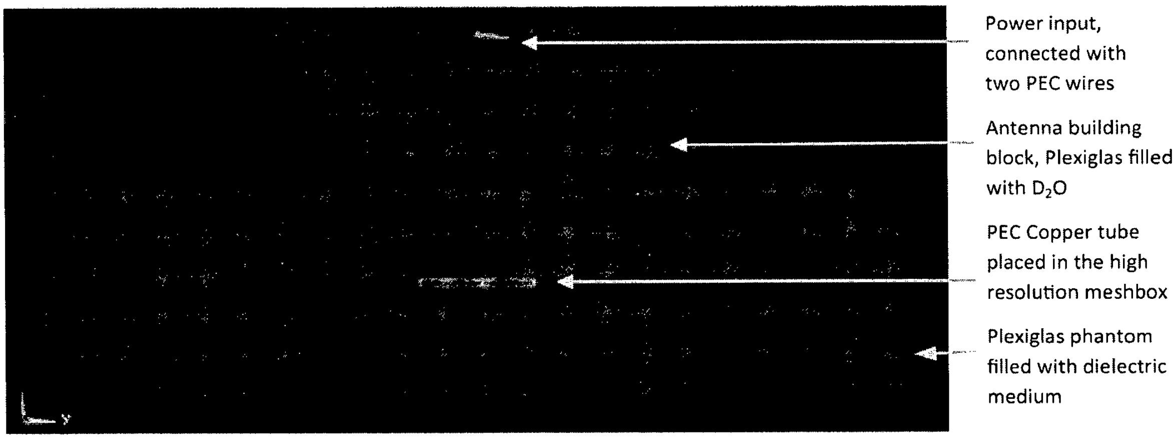


Figure 5.2

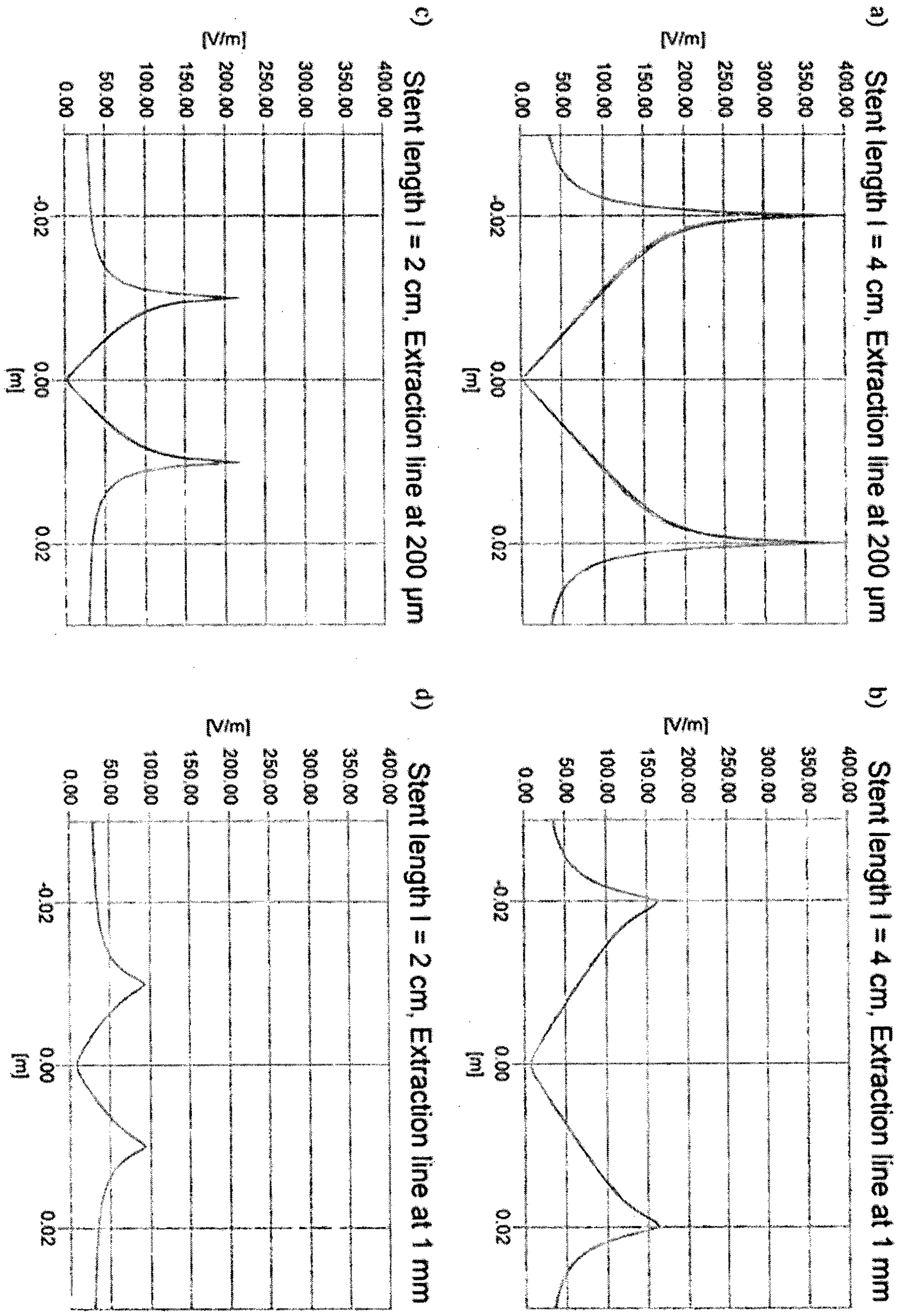
a)
Stent length l = 4 cm, Extraction line at 200 µm
b)
Stent length l = 4 cm, Extraction line at 1 mm
c)
Stent length l = 2 cm, Extraction line at 200 µm
d)
Stent length l = 2 cm, Extraction line at 1 mm
[V/m]
400.00
350.00
300.00
250.00
200.00
150.00
100.00
50.00
0.00
-0.02
0.00
0.02
[m]

Figure 5.3

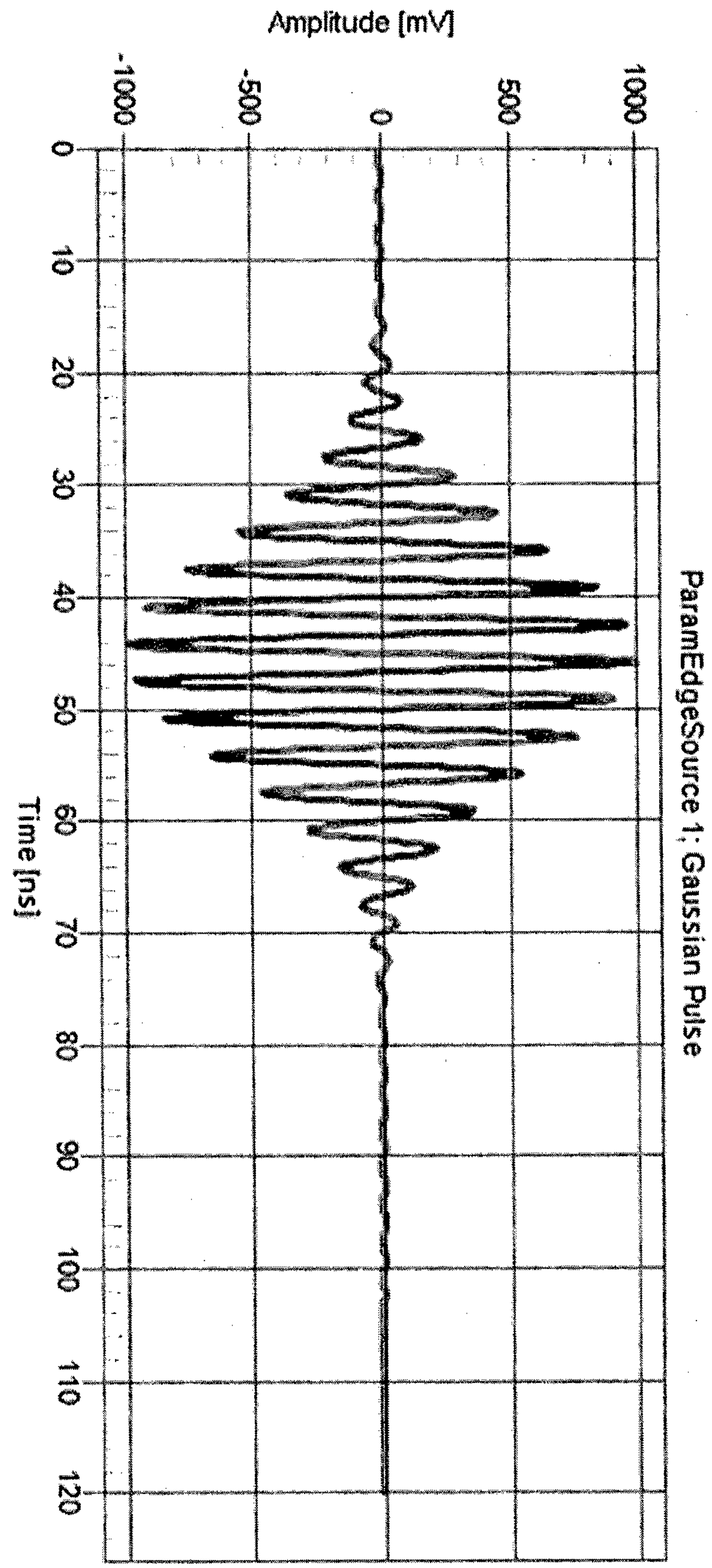
ParamEdgeSource 1; Gaussian Pulse
Amplitude [mV]
-1000
-500
0
500
1000
Time [ns]
0
10
20
30
40
50
60
70
80
90
100
110
120

Figure 5.4

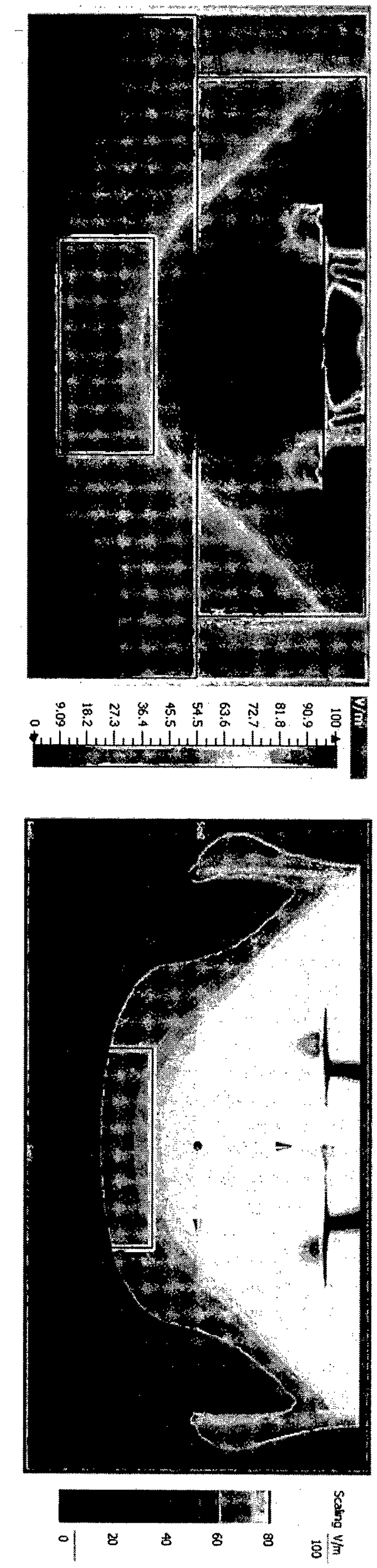
V/m
0
9.09
18.2
27.3
36.4
45.5
54.5
63.6
72.7
81.8
90.9
100
Scaling V/m
0
20
40
60
80
100

Figure 5.5

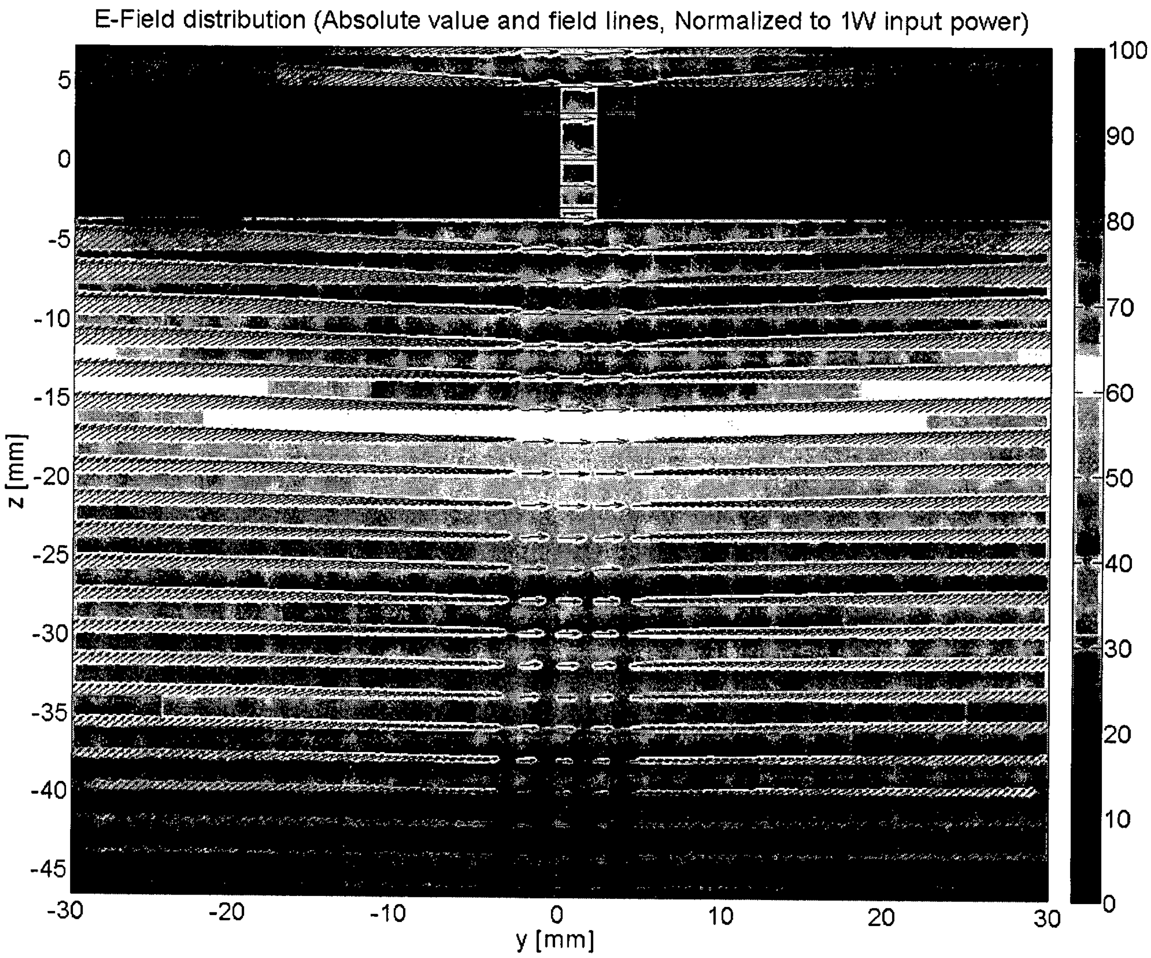
E-Field distribution (Absolute value and field lines, Normalized to 1W input power)
z [mm]
5
0
-5
-10
-15
-20
-25
-30
-35
-40
-45
y [mm]
-30
-20
-10
0
10
20
30
100
90
80
70
60
50
40
30
20
10
0

Figure 5.6

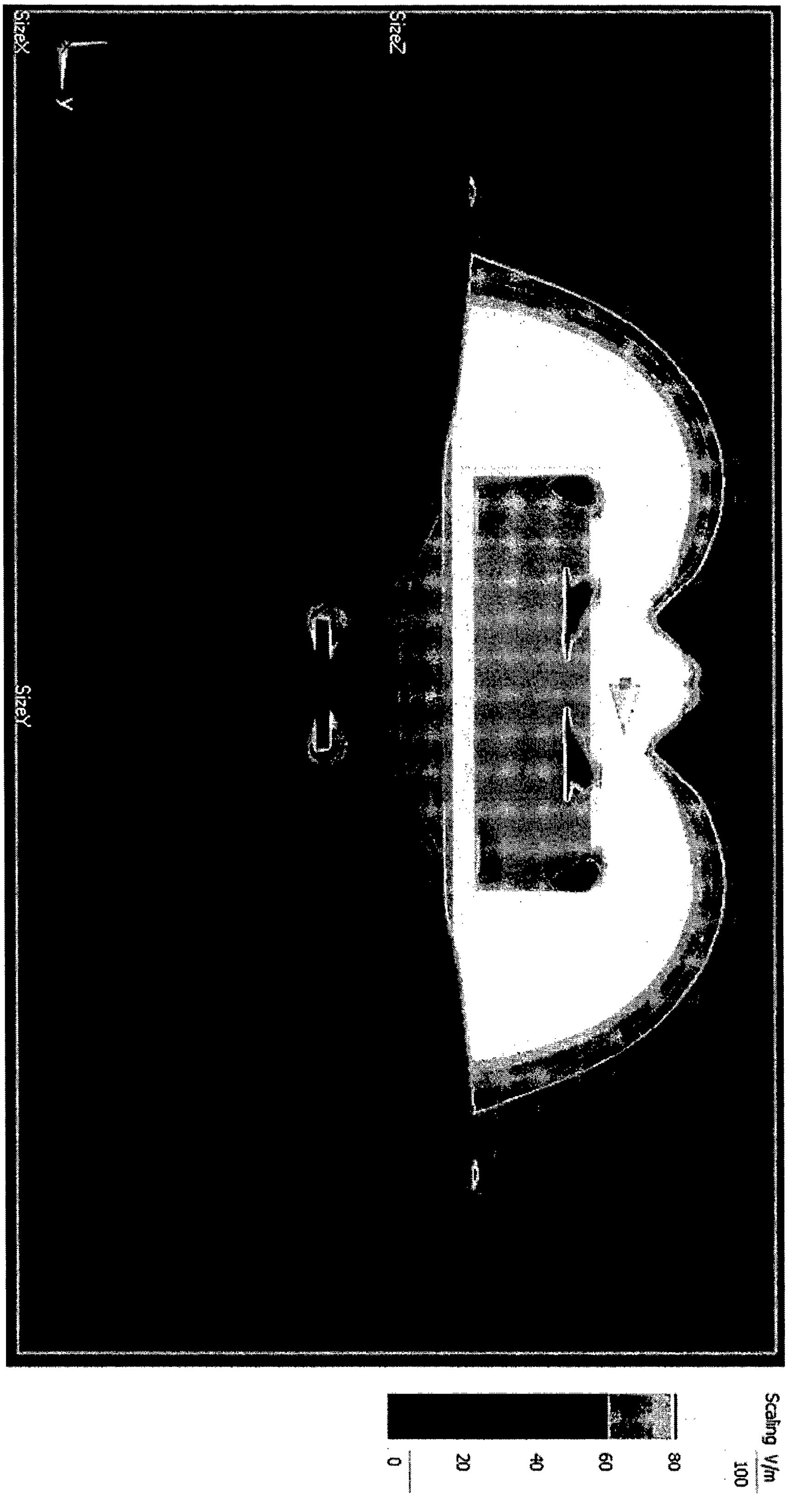


Figure 5.7

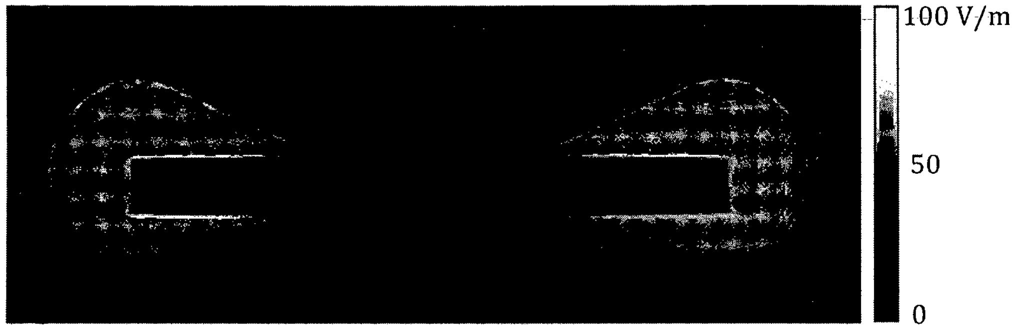


Figure 5.8

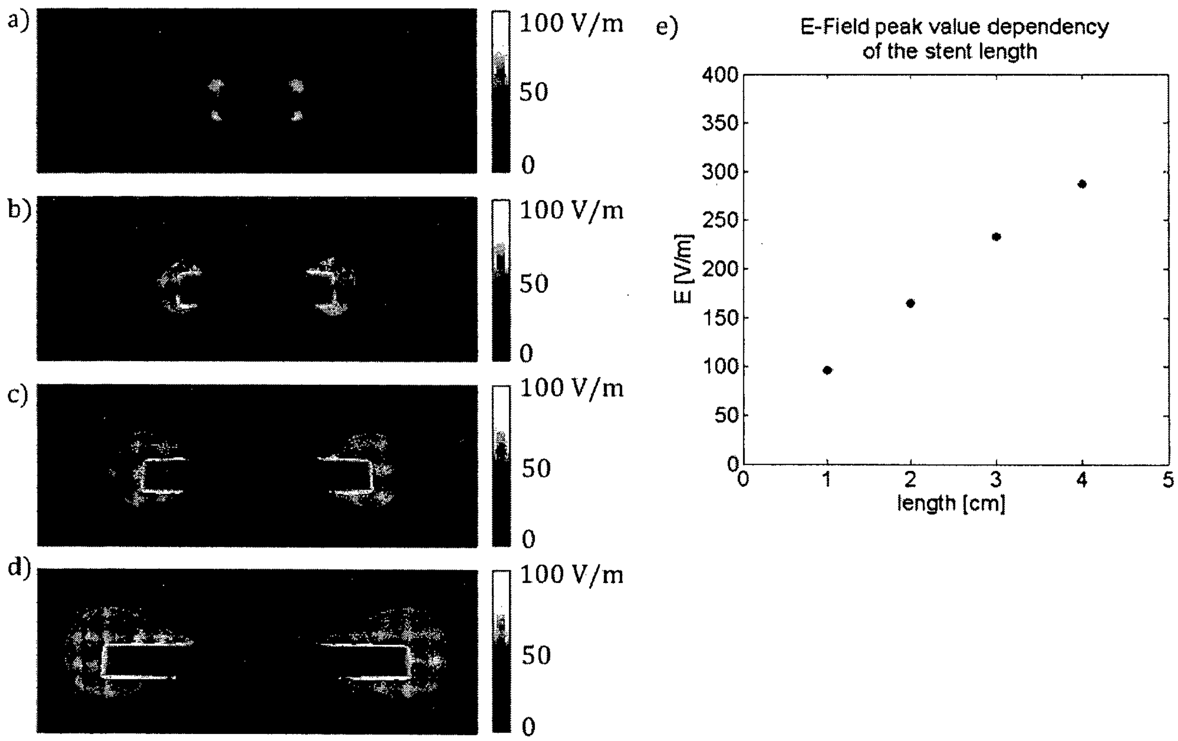


Figure 5.9

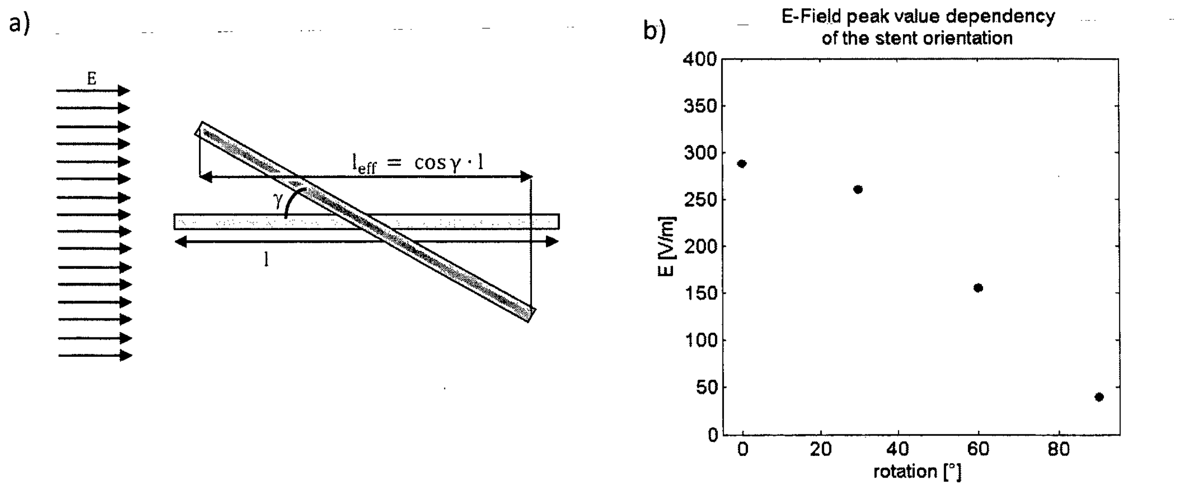


Figure 5.10

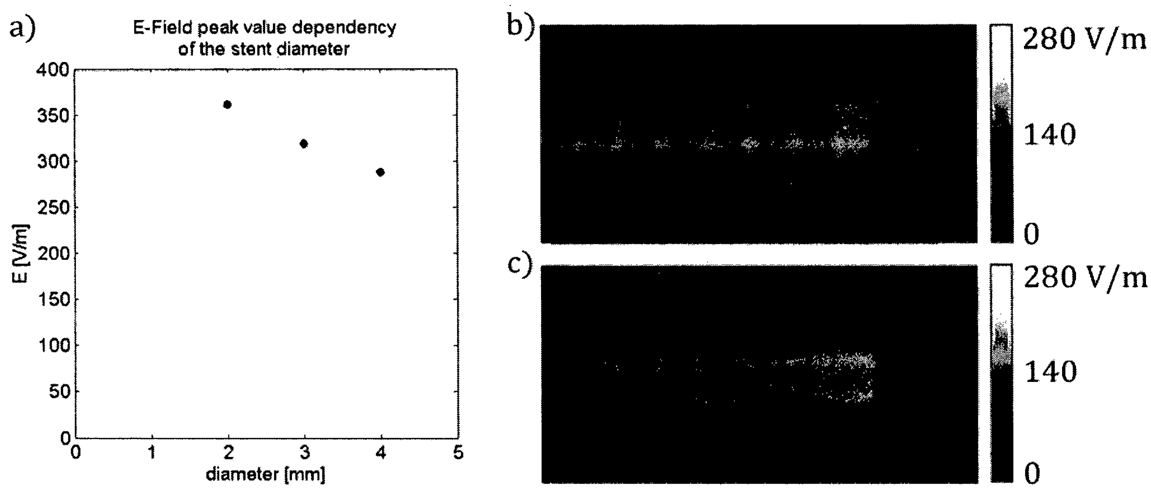


Figure 5.11

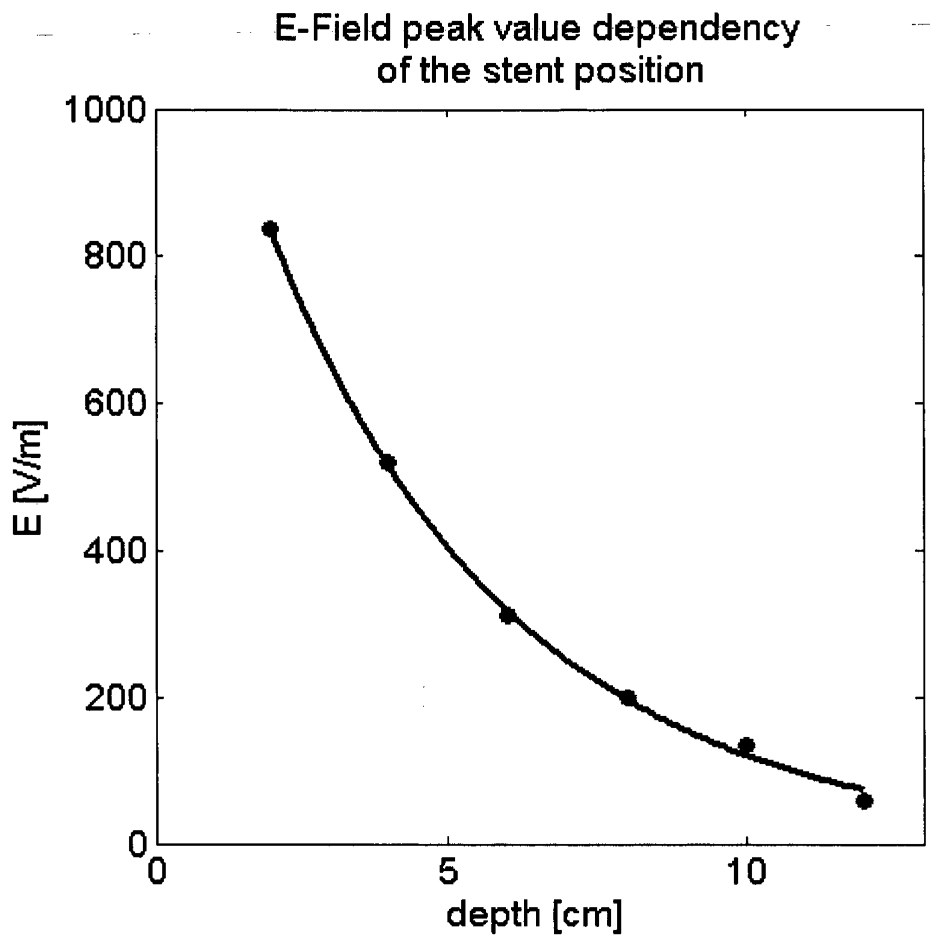


Figure 5.12

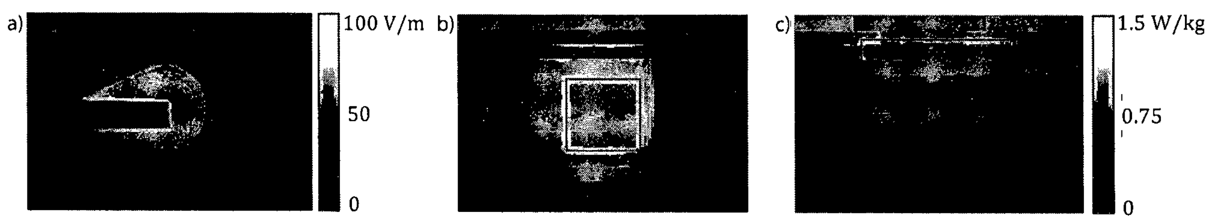


Figure 5.13

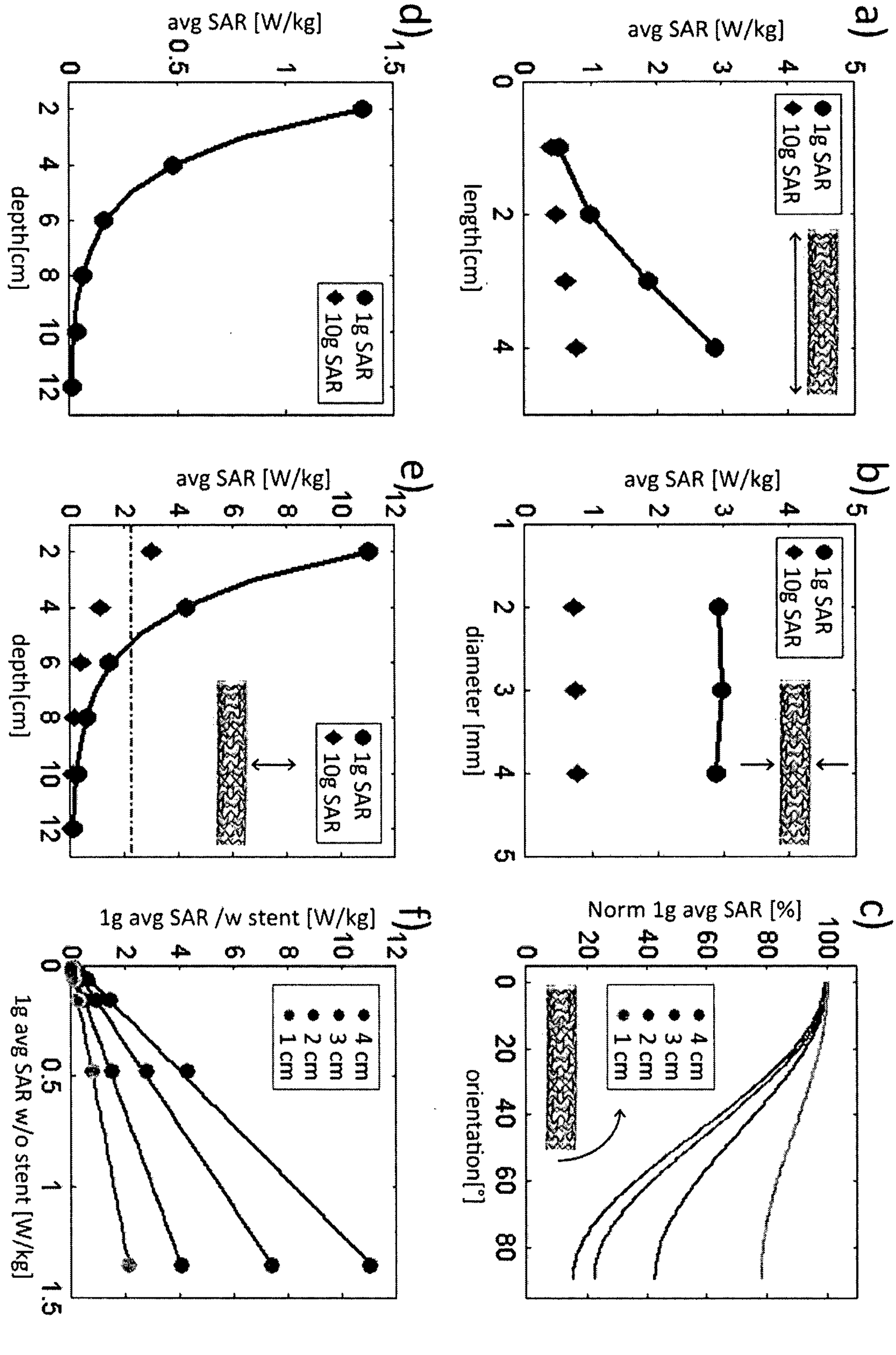
a)
avg SAR [W/kg]
length[cm]
1g SAR
10g SAR
b)
avg SAR [W/kg]
diameter [mm]
1g SAR
10g SAR
c)
Norm 1g avg SAR [%]
orientation[°]
4 cm
3 cm
2 cm
1 cm
d)
avg SAR [W/kg]
depth[cm]
1g SAR
10g SAR
e)
avg SAR [W/kg]
depth[cm]
1g SAR
10g SAR
f)
1g avg SAR /w stent [W/kg]
1g avg SAR w/o stent [W/kg]
4 cm
3 cm
2 cm
1 cm

Figure 5.14

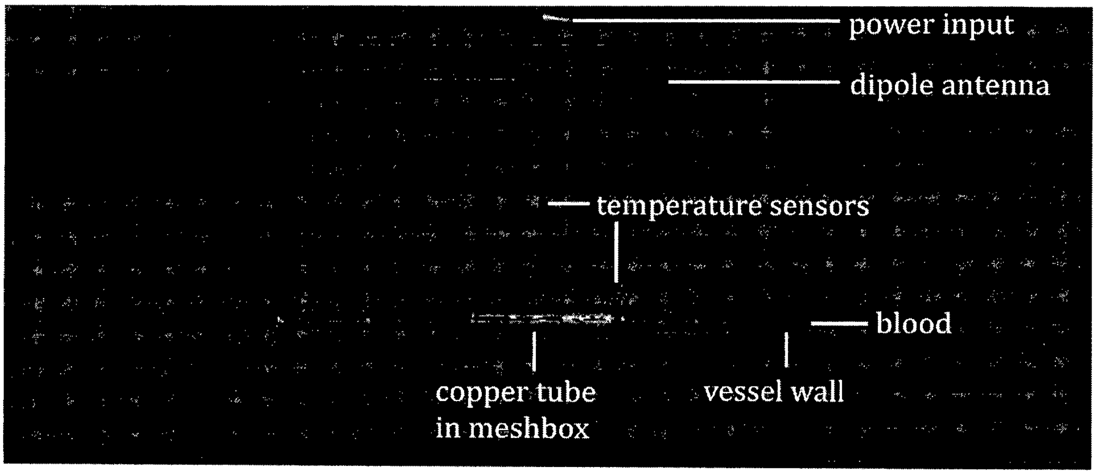


Figure 5.15

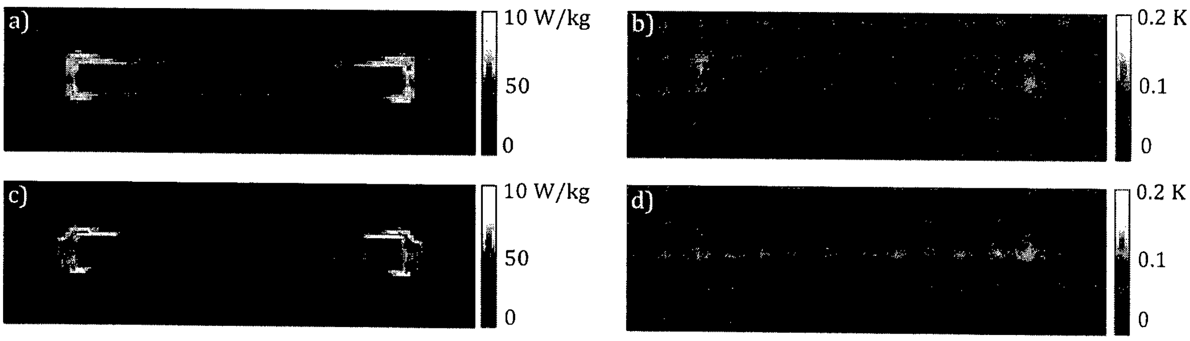


Figure 5.16

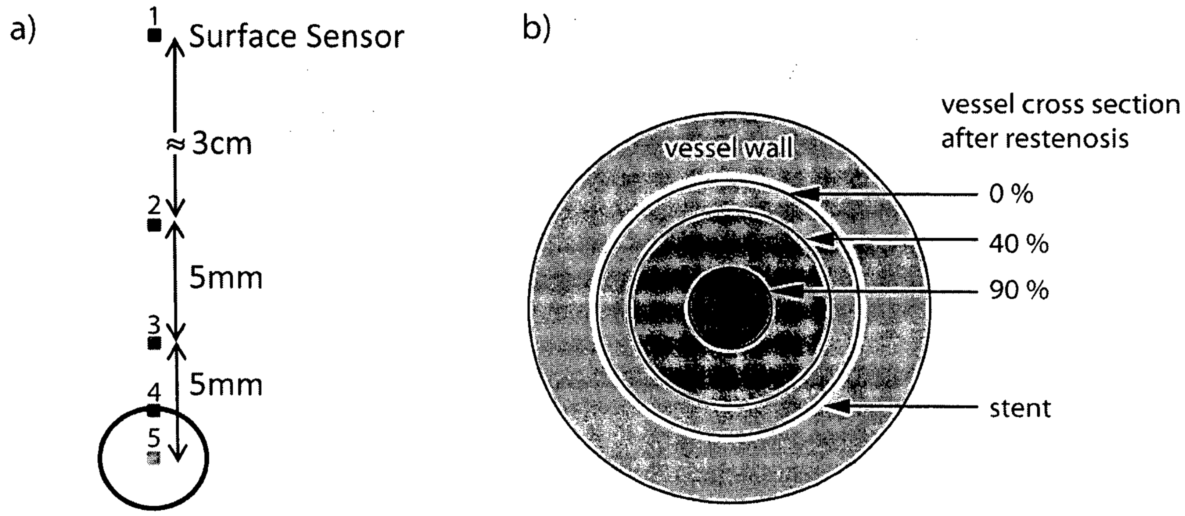
a)
1
Surface Sensor
≈3cm
2
5mm
3
5mm
4
5
b)
vessel cross section
after restenosis
vessel wall
0 %
40 %
90 %
stent

Figure 5.17

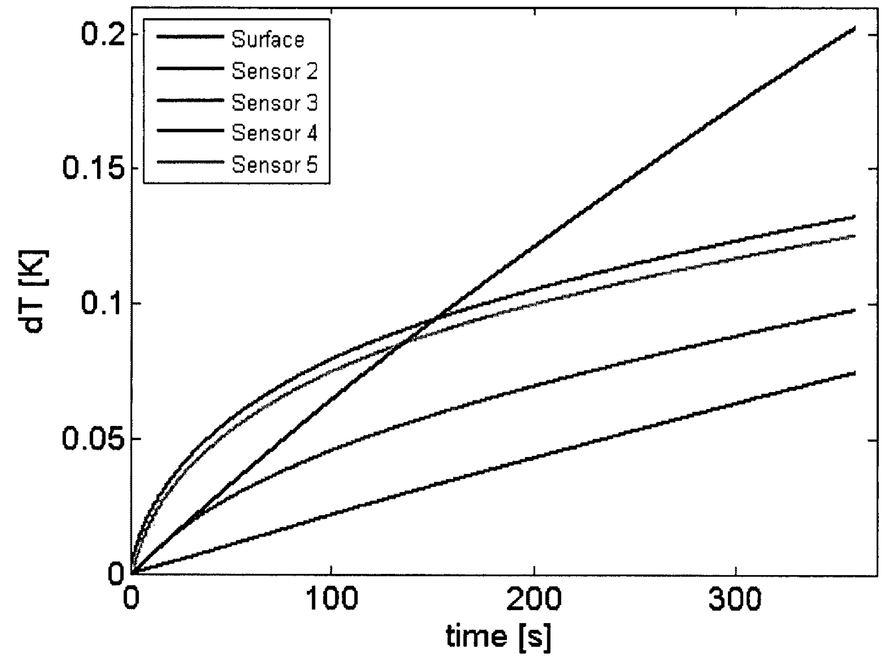


Figure 5.18

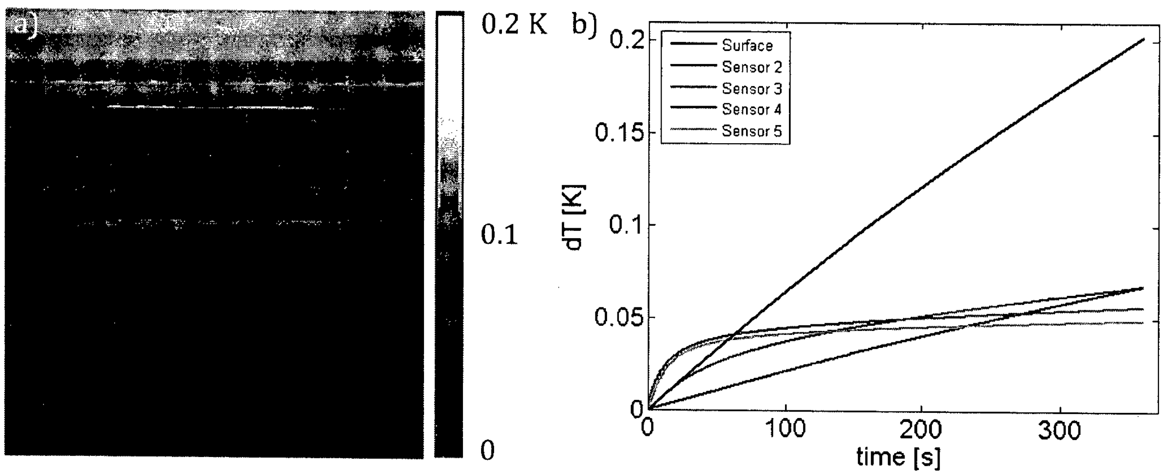


Figure 5.19

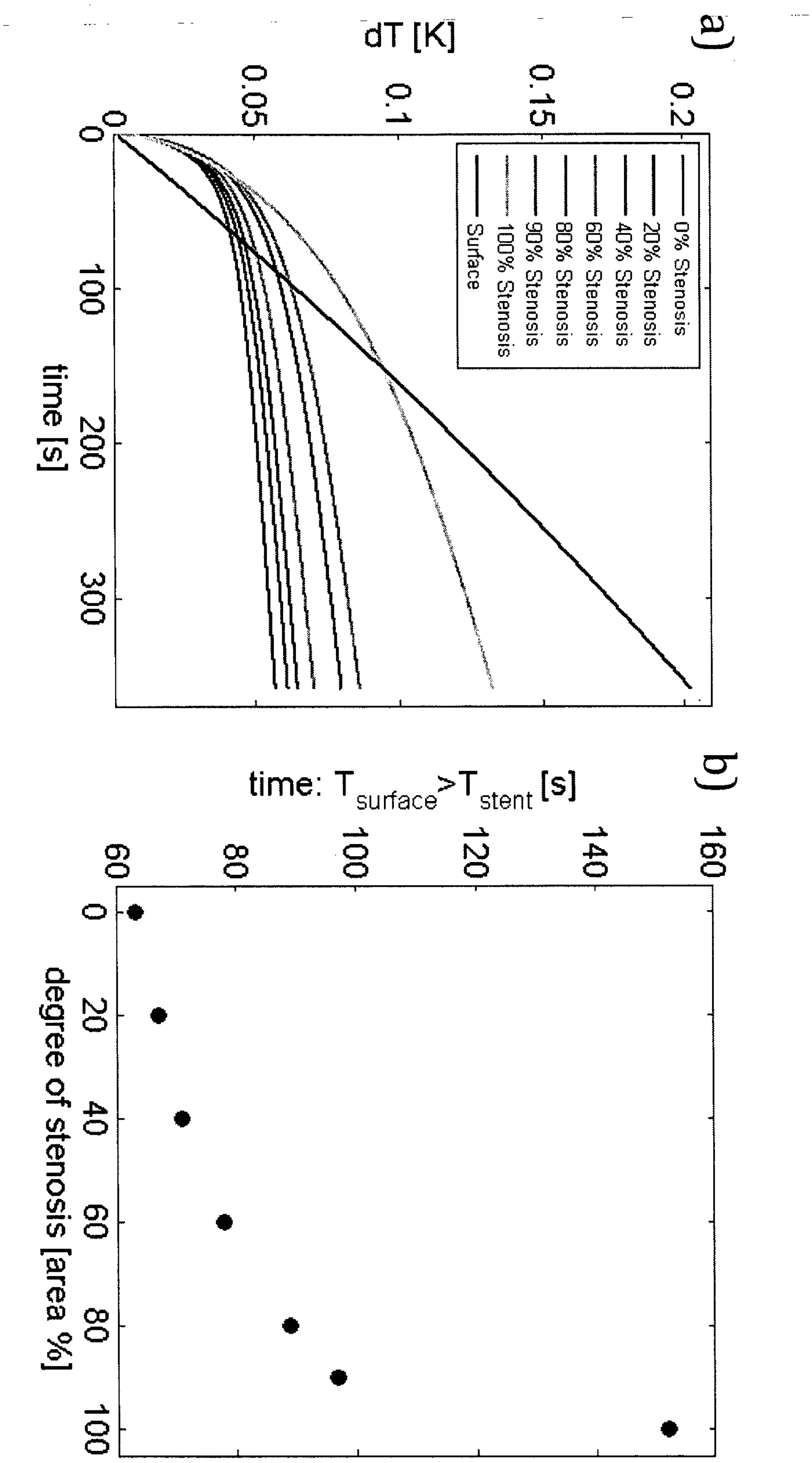
a)
dT [K]
0.2
0.15
0.1
0.05
0
0% Stenosis
20% Stenosis
40% Stenosis
60% Stenosis
80% Stenosis
90% Stenosis
100% Stenosis
Surface
0
100
200
300
time [s]
b)
time: $T_{surface}$>$T_{stent}$ [s]
160
140
120
100
80
60
0
20
40
60
80
100
degree of stenosis [area %]

Figure 5.20

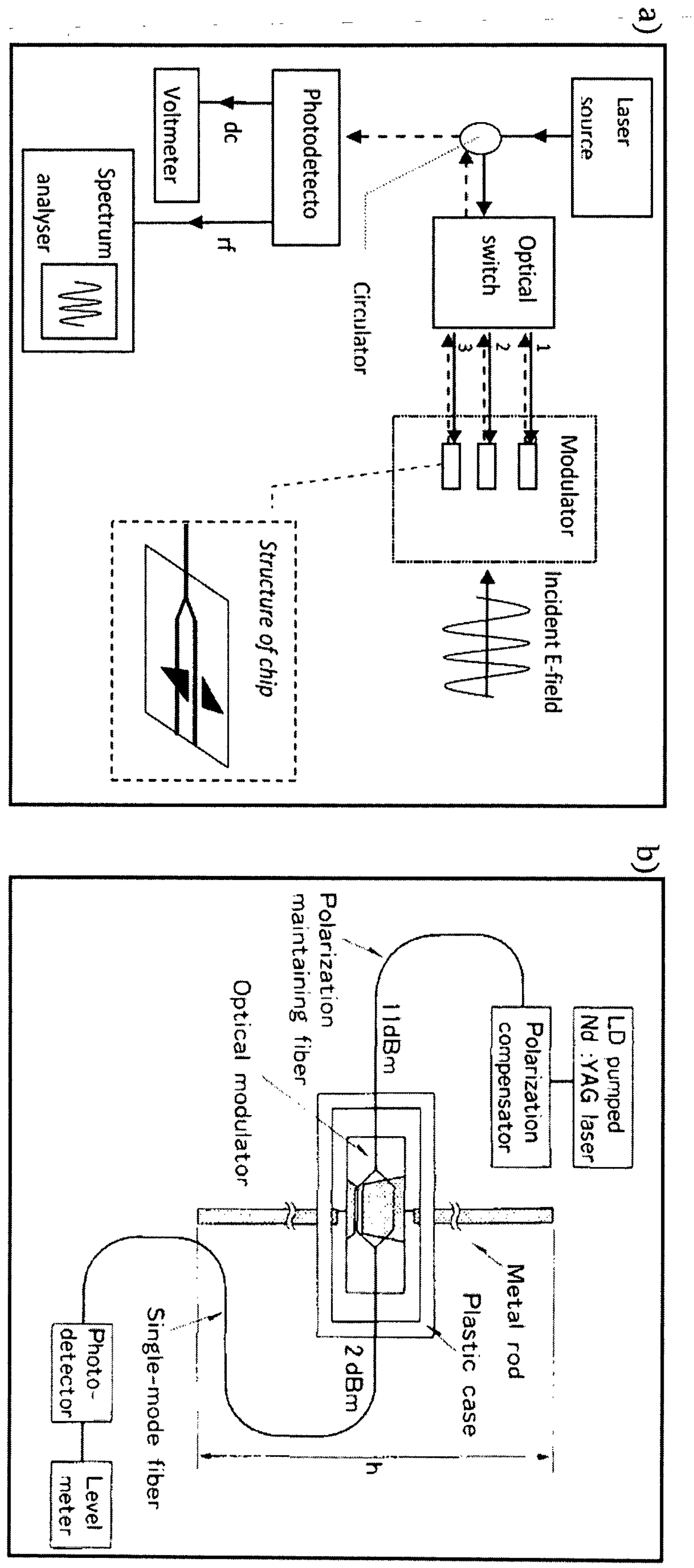
a)
Laser source
Optical switch
Circulator
Photodetecto
Voltmeter
dc
rf
Spectrum analyser
1
2
3
Modulator
Incident E-field
Structure of chip
b)
LD pumped Nd :YAG laser
Polarization compensator
Polarization maintaining fiber
11dBm
Optical modulator
Metal rod
Plastic case
2 dBm
h
Single-mode fiber
Photo-detector
Level meter

Figure 6.1

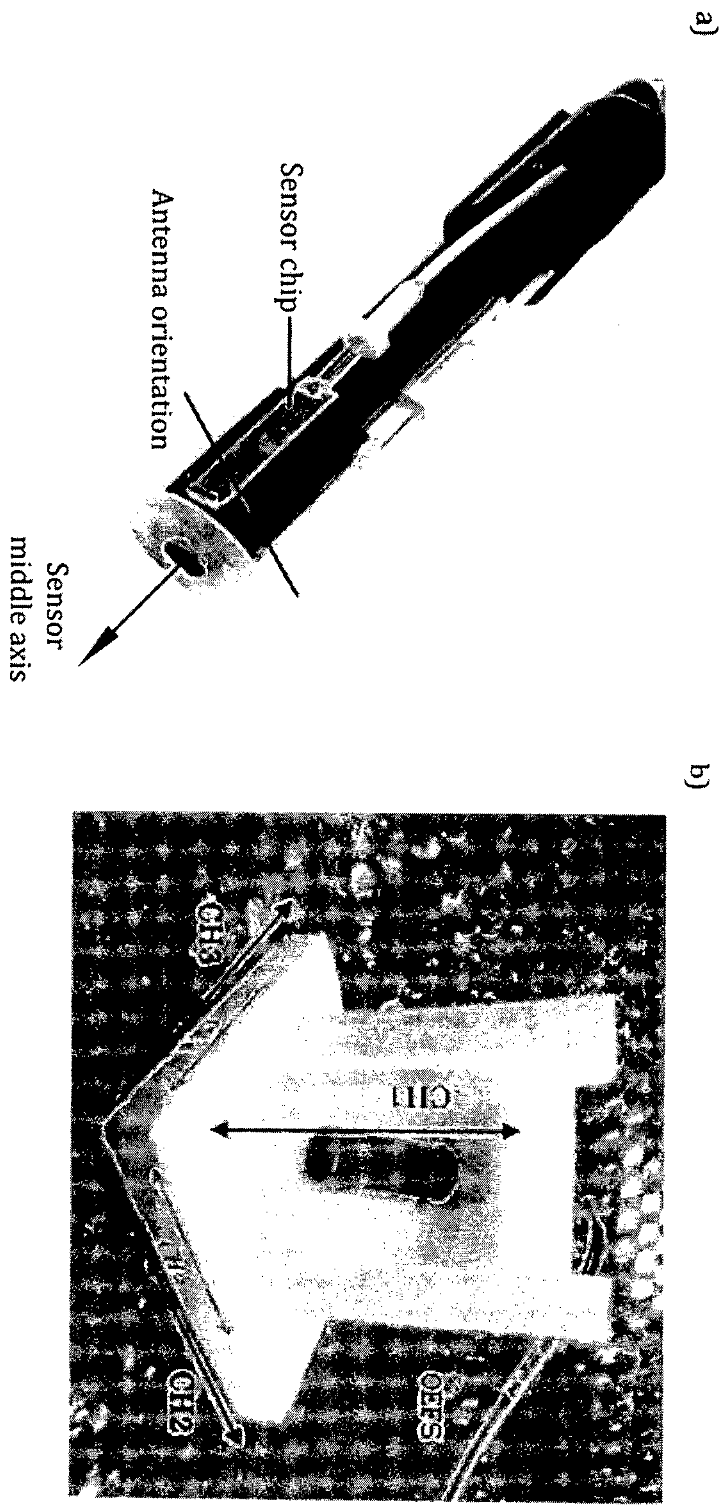
a)
Sensor chip
Antenna orientation
Sensor
middle axis
b)
CH1
CH2
CH3
OEFS

Figure 6.2

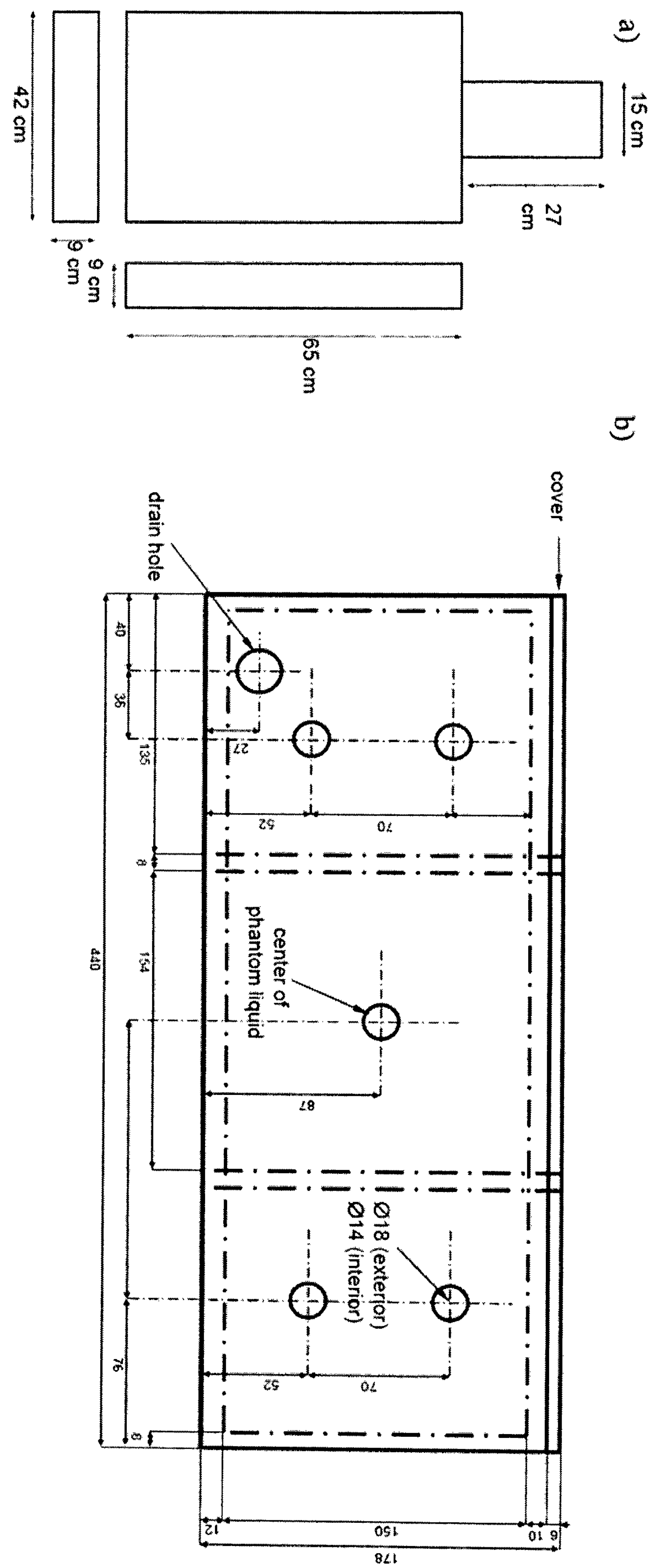
a)
15 cm
27 cm
42 cm
9 cm
9 cm
65 cm
b)
cover
drain hole
center of phantom liquid
Ø18 (exterior)
Ø14 (interior)
40
36
135
8
154
440
76
8
27
52
70
87
52
70
12
150
10
6
178

Figure 6.3

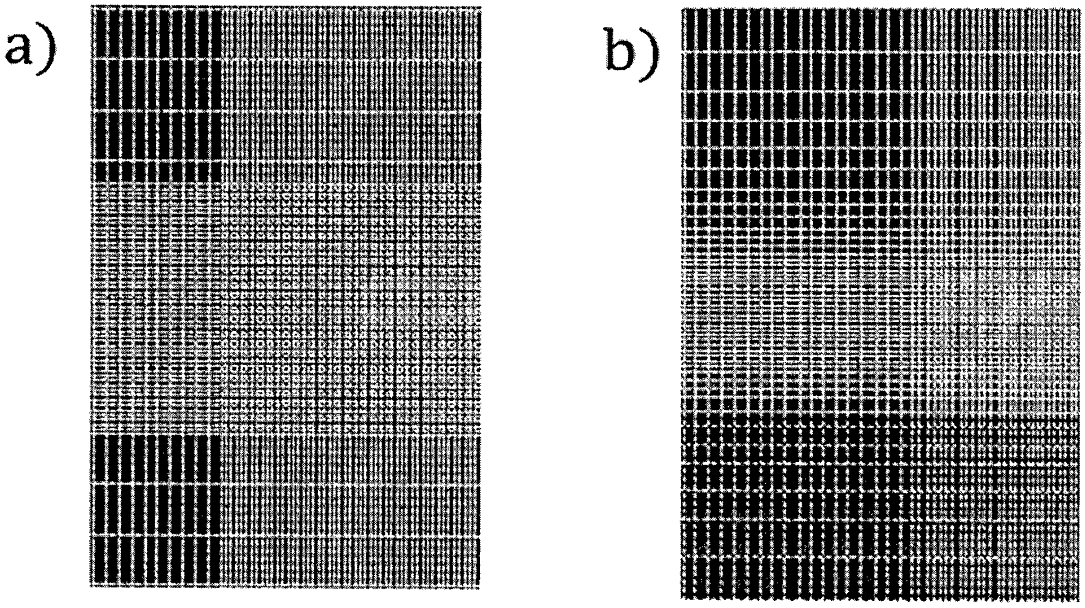


Figure 6.4

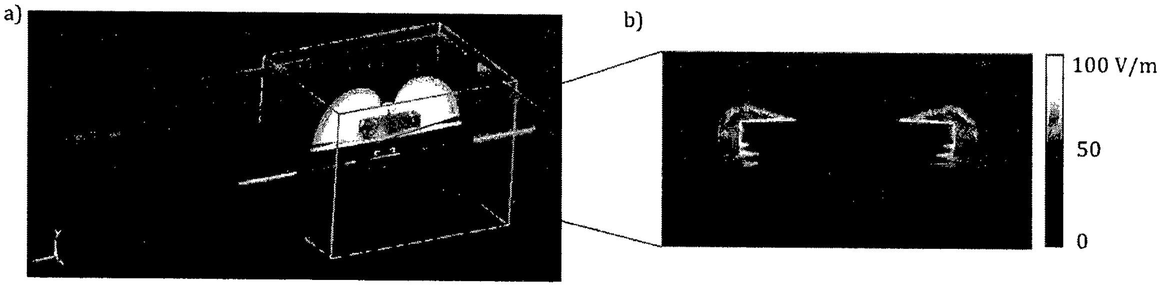


Figure 6.5

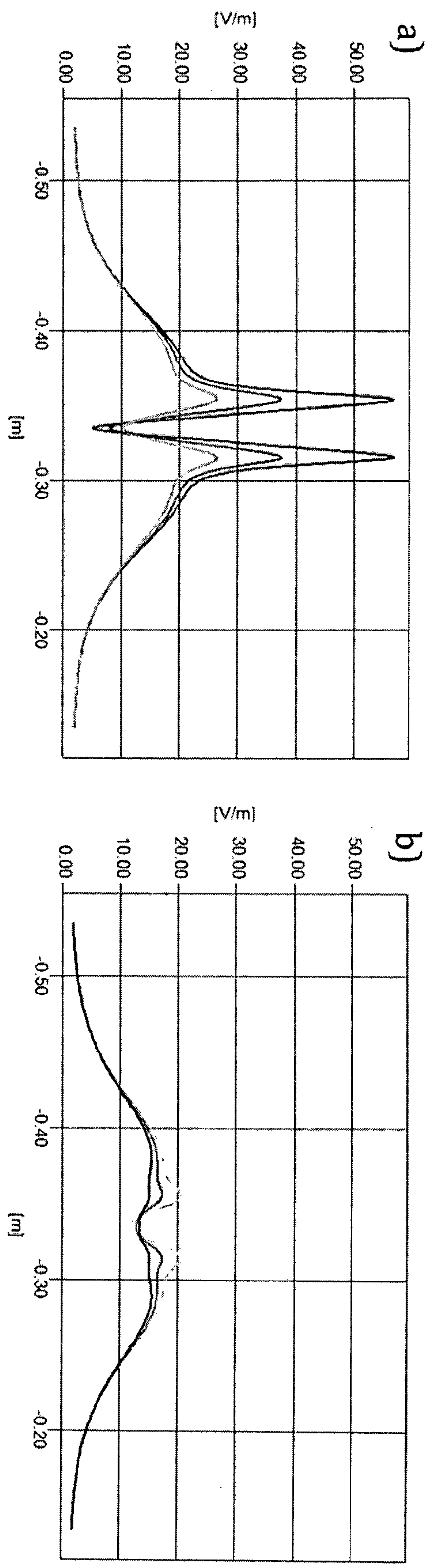
a)
[V/m]
0.00
10.00
20.00
30.00
40.00
50.00
-0.50
-0.40
[m]
-0.30
-0.20
b)
[V/m]
0.00
10.00
20.00
30.00
40.00
50.00
-0.50
-0.40
[m]
-0.30
-0.20

Figure 6.6

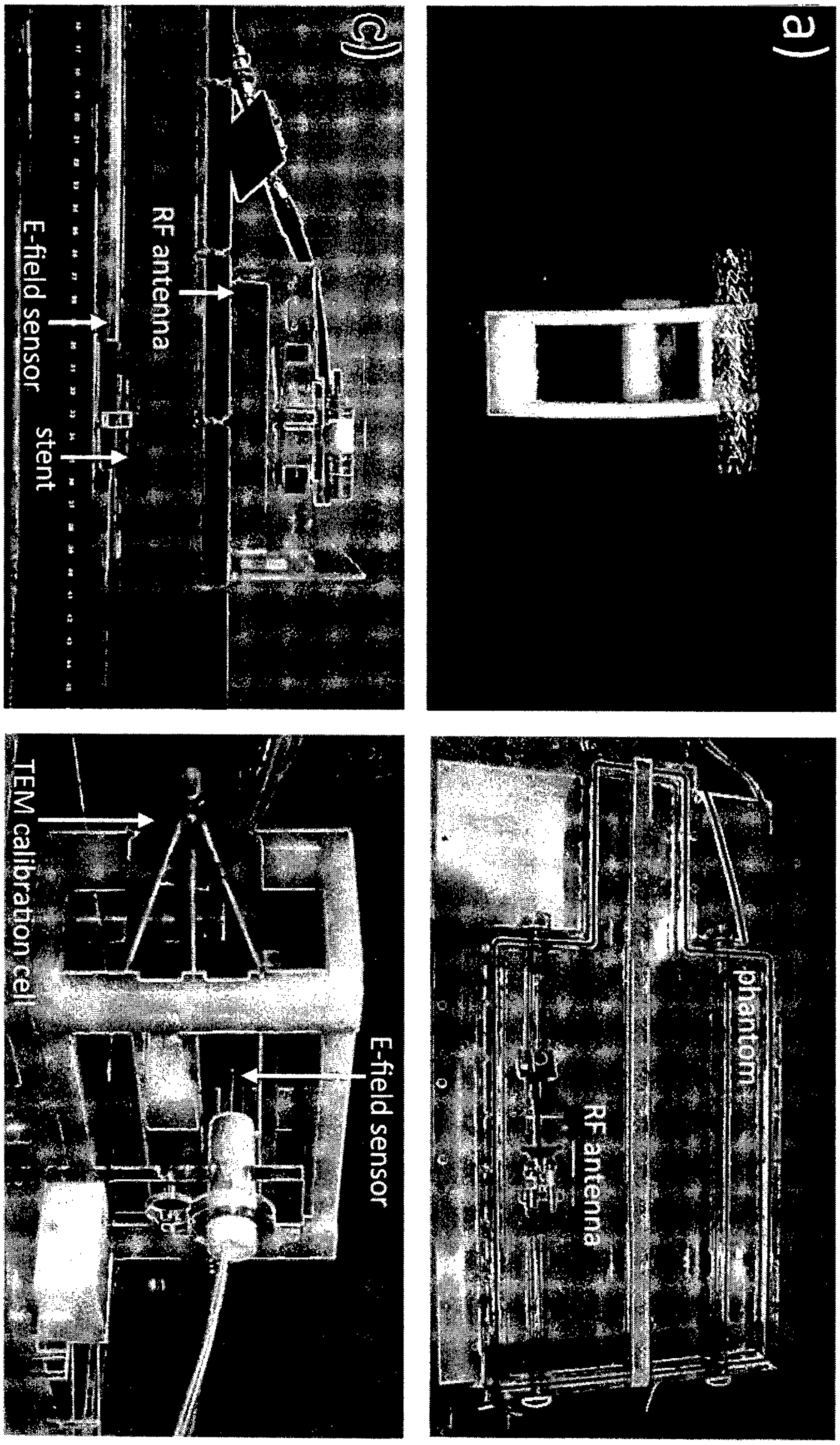
c)
RF antenna
E-field sensor
stent
a)
TEM calibration cell
E-field sensor
phantom
RF antenna

Figure 6.7

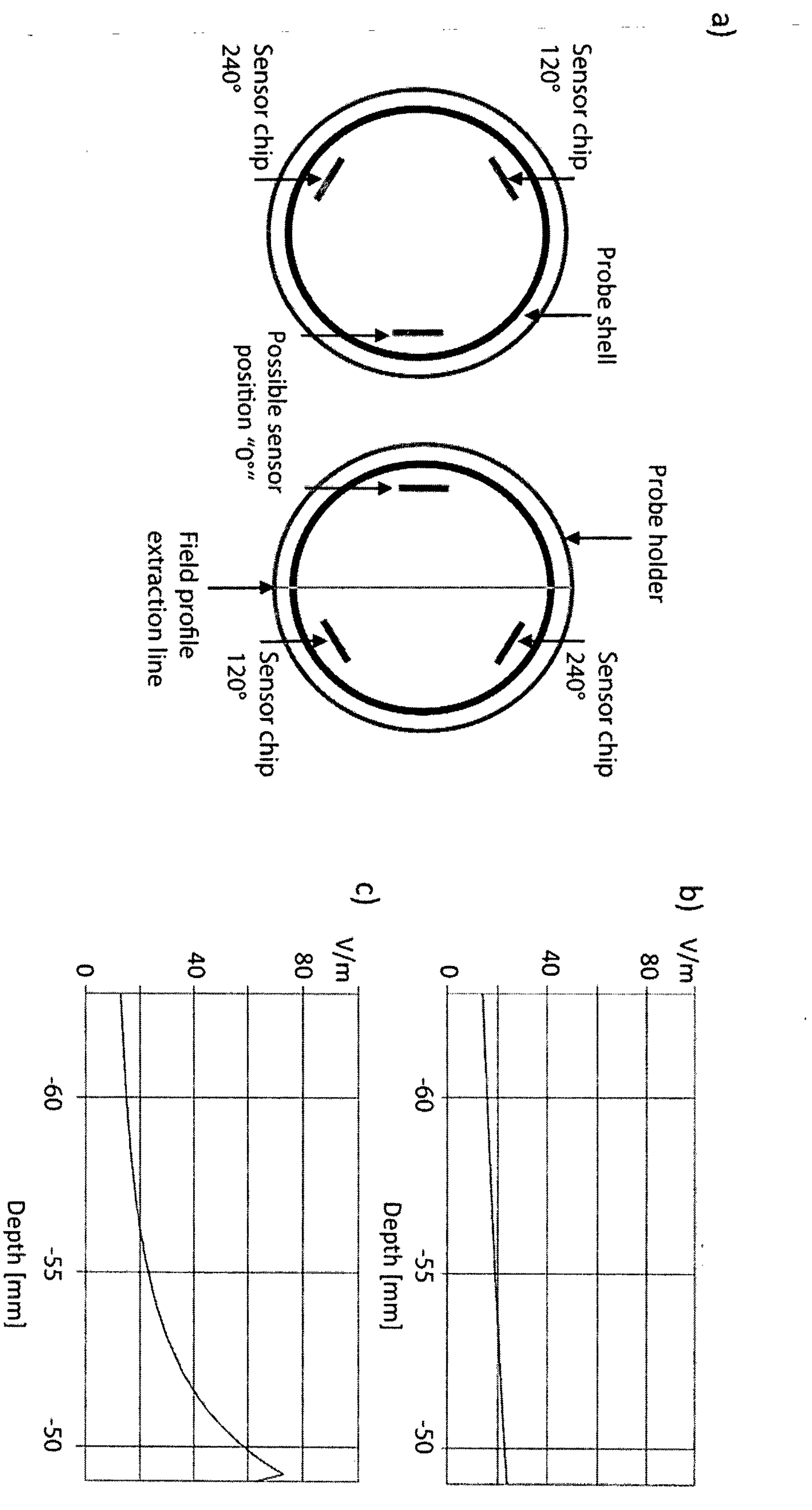
a)
Sensor chip
120°
Sensor chip
240°
Probe shell
Possible sensor
position "0°"
Probe holder
Sensor chip
240°
Sensor chip
120°
Field profile
extraction line
b)
V/m
80
40
0
-60
-55
-50
Depth [mm]
c)
V/m
80
40
0
-60
-55
-50
Depth [mm]

Figure 6.8

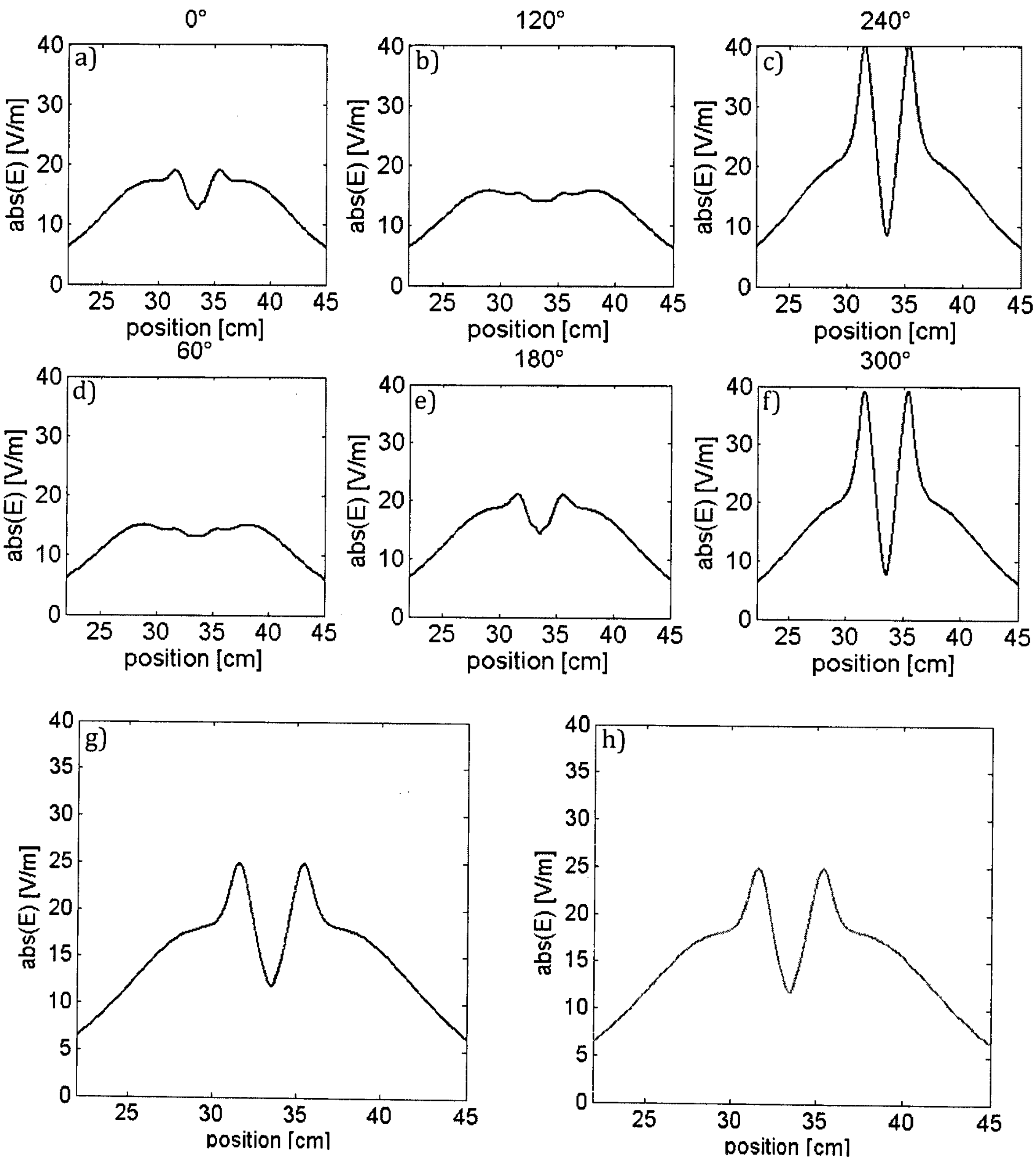


Figure 6.9

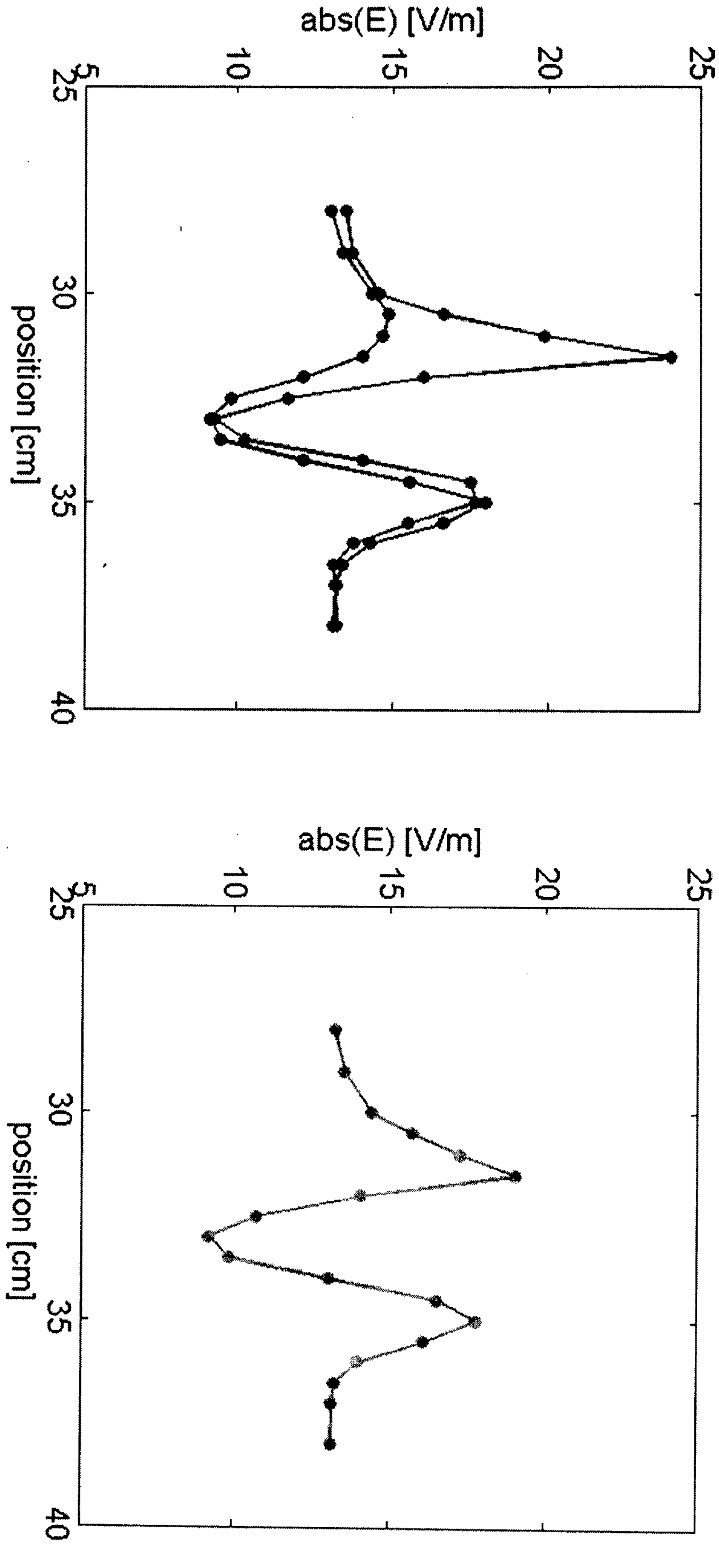
abs(E) [V/m]
position [cm]
5
10
15
20
25
30
35
40
abs(E) [V/m]
position [cm]
5
10
15
20
25
30
35
40

Figure 6.10

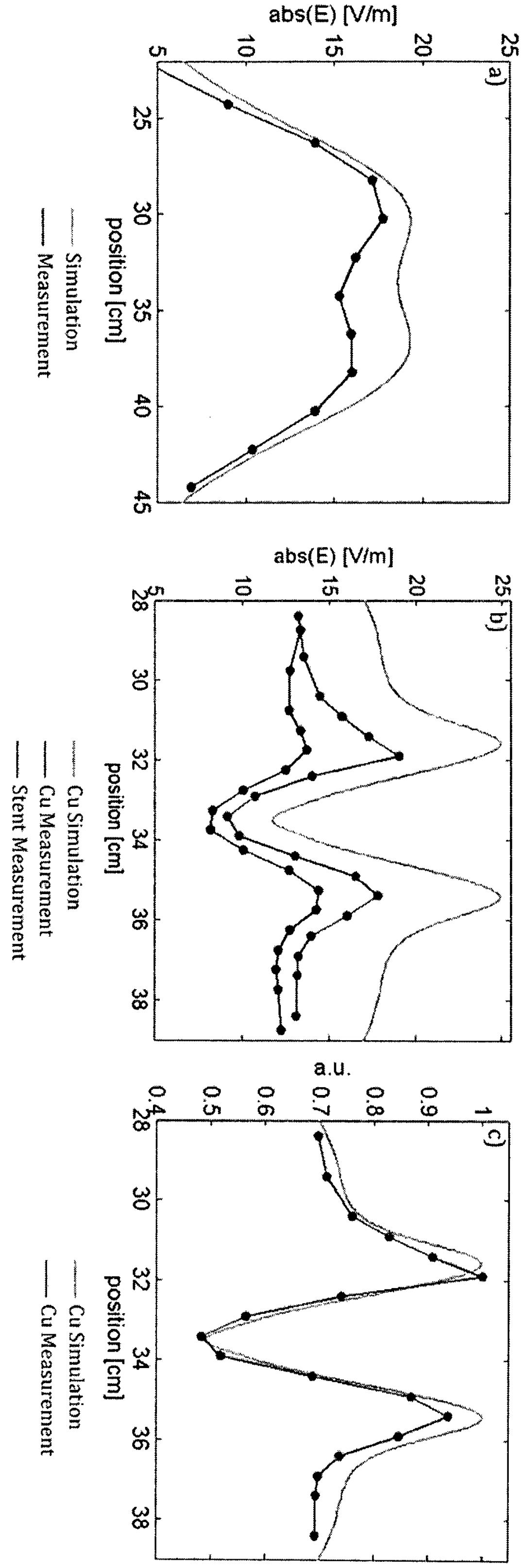
a)
abs(E) [V/m]
position [cm]
Simulation
Measurement
b)
abs(E) [V/m]
position [cm]
Cu Simulation
Cu Measurement
Stent Measurement
c)
a.u.
position [cm]
Cu Simulation
Cu Measurement

Figure 6.11

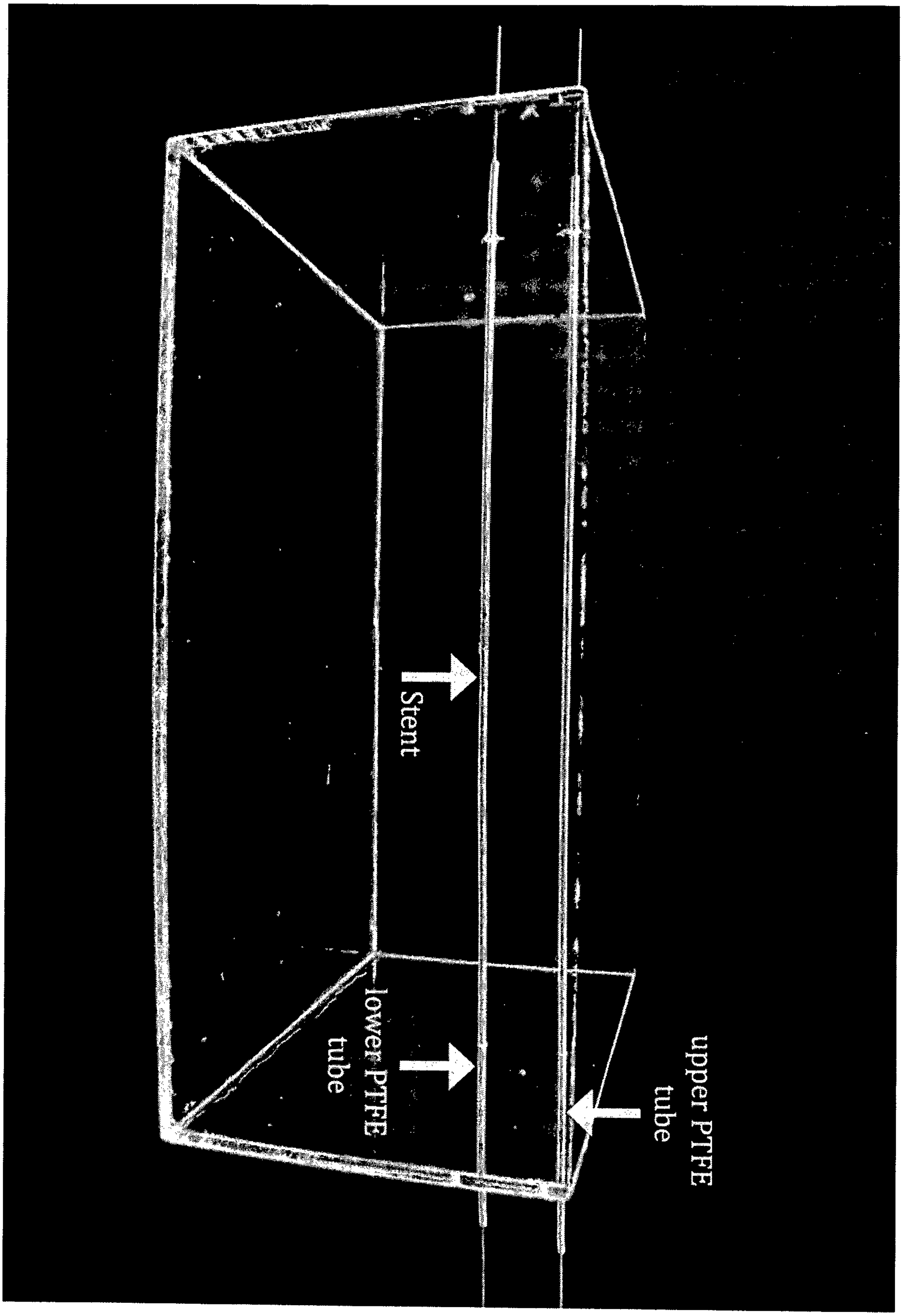


Figure 6.12

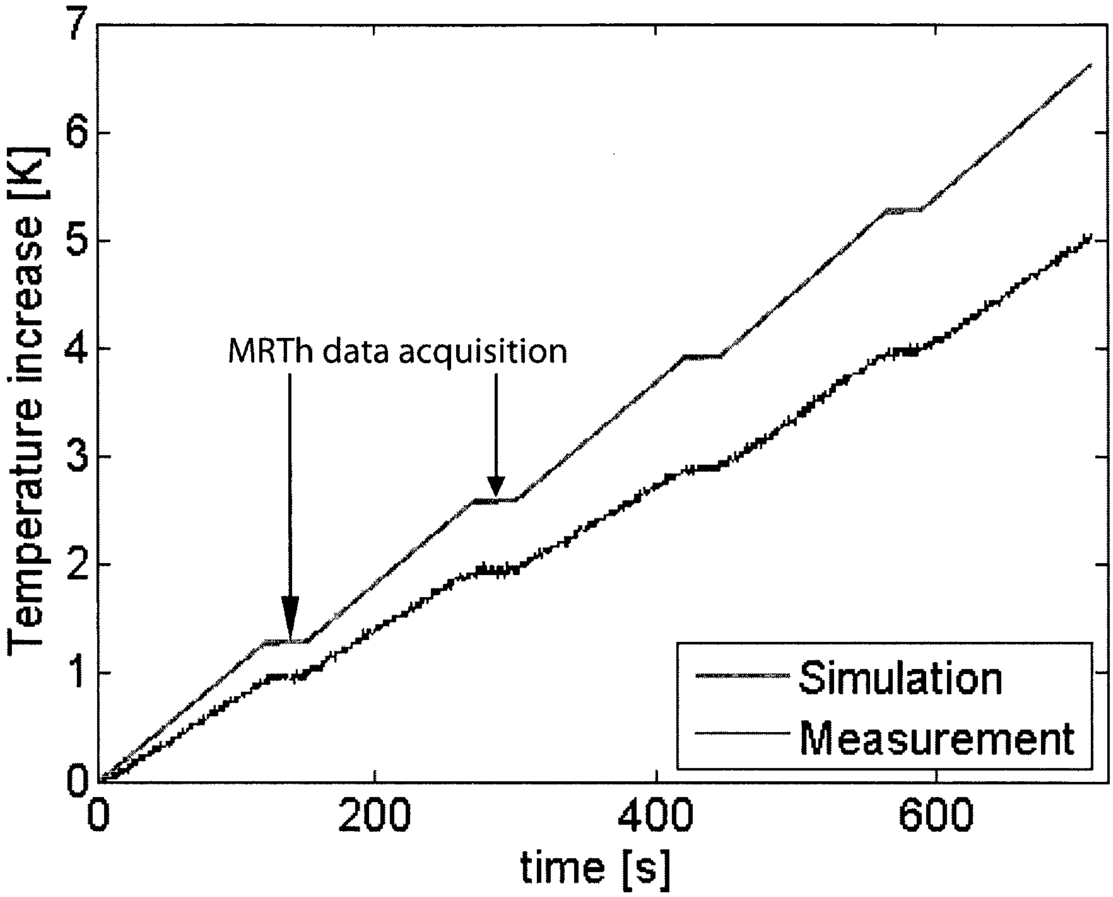
MRTh data acquisition
Temperature increase [K]
time [s]
Simulation
Measurement
0
1
2
3
4
5
6
7
0
200
400
600

Figure 6.13

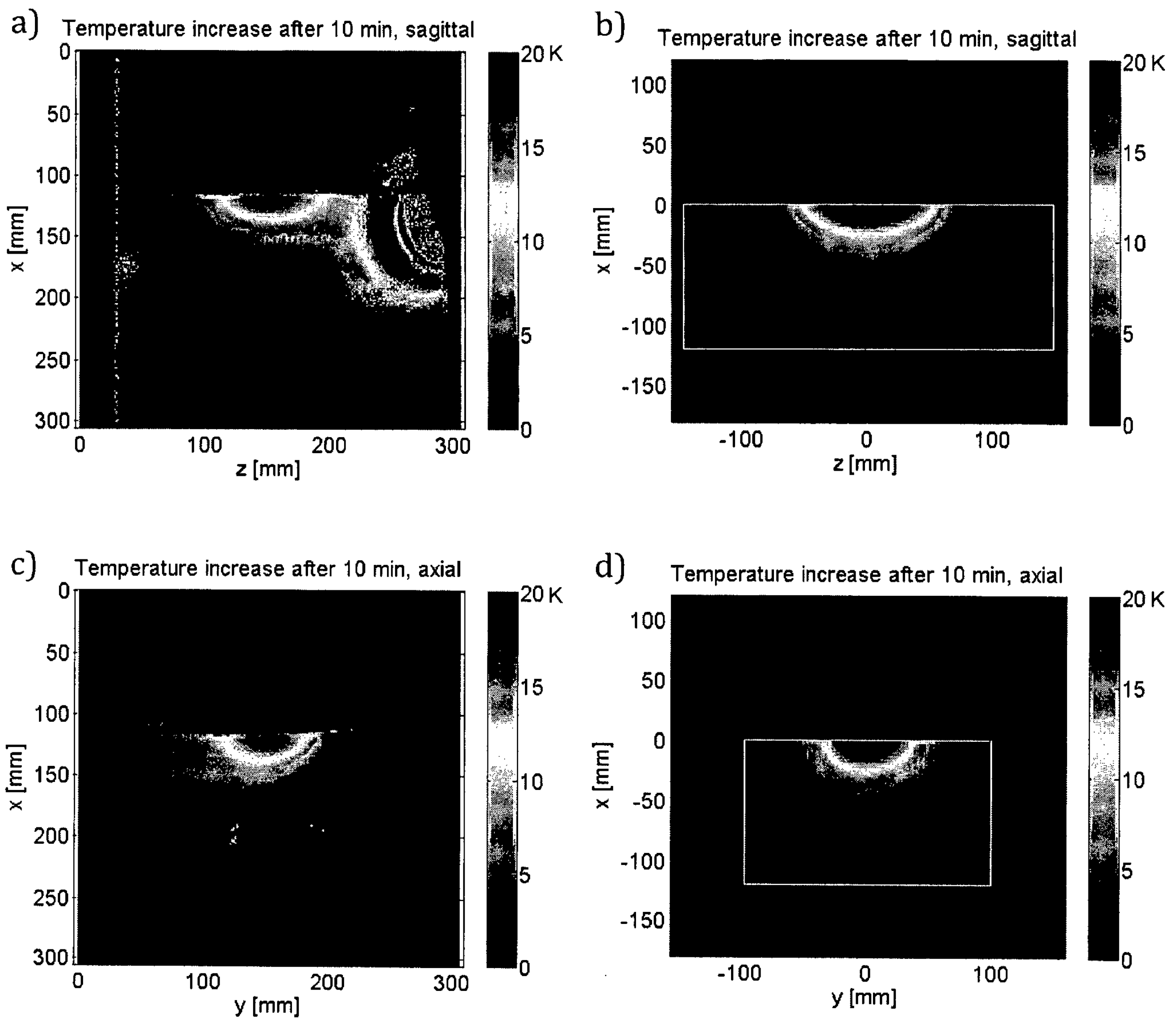


Figure 6.14

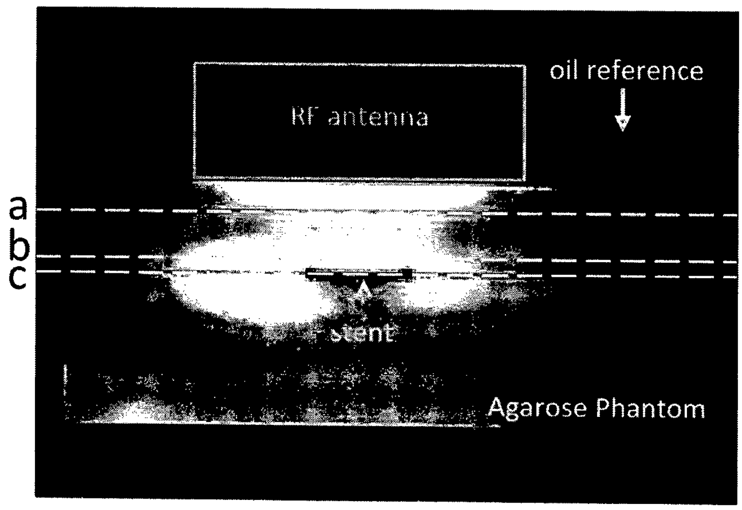


Figure 6.16

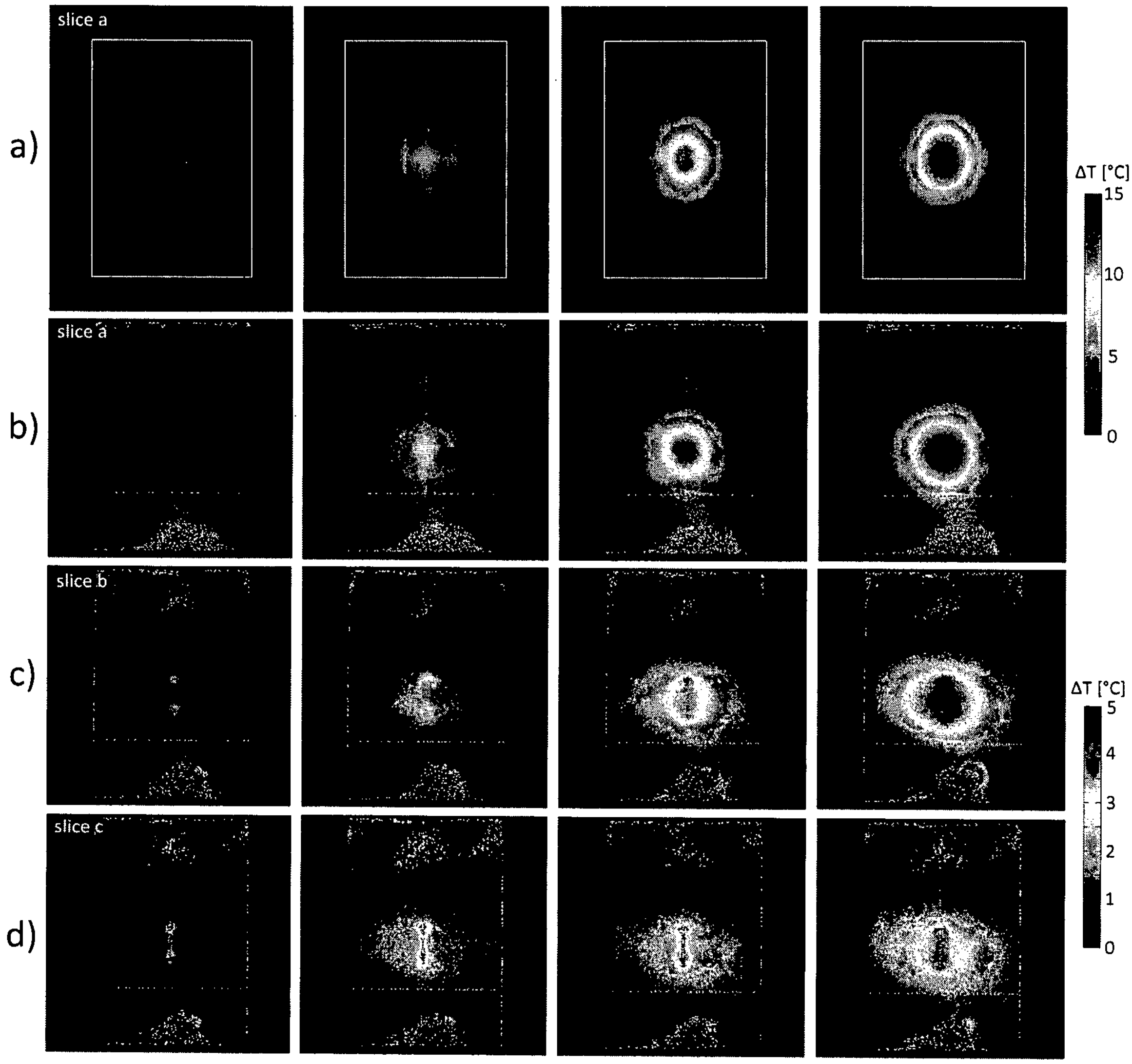


Figure 6.17

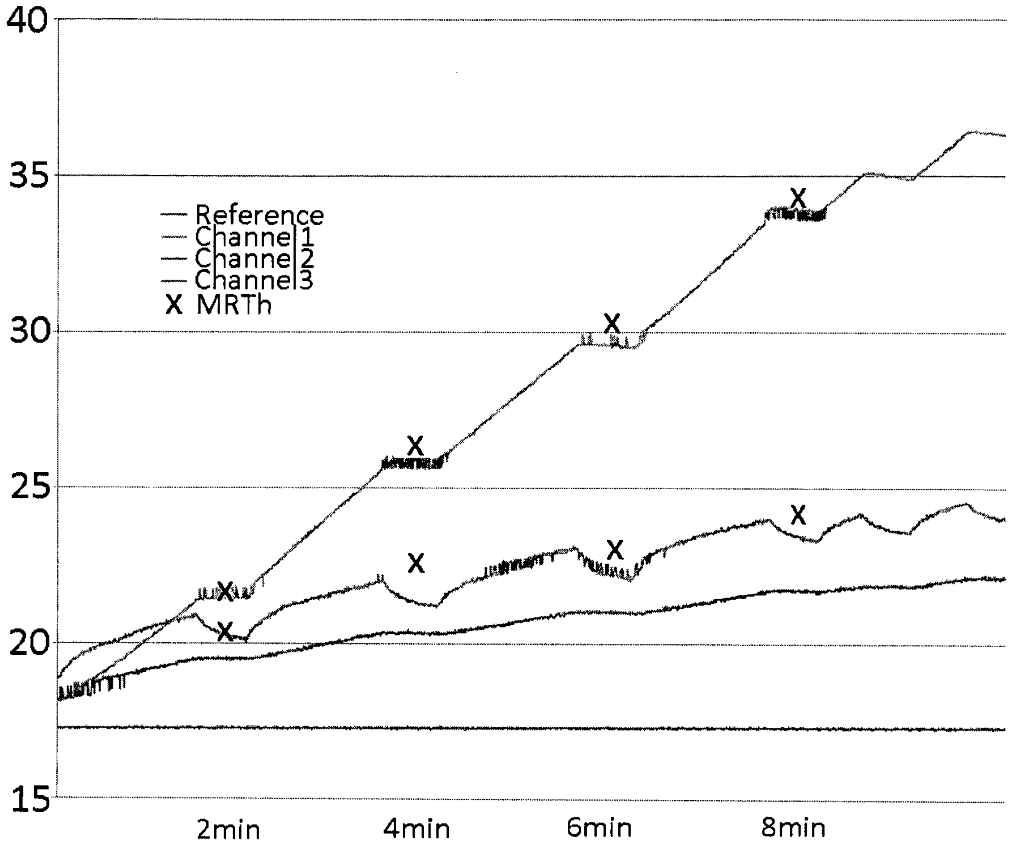


Figure 6.18

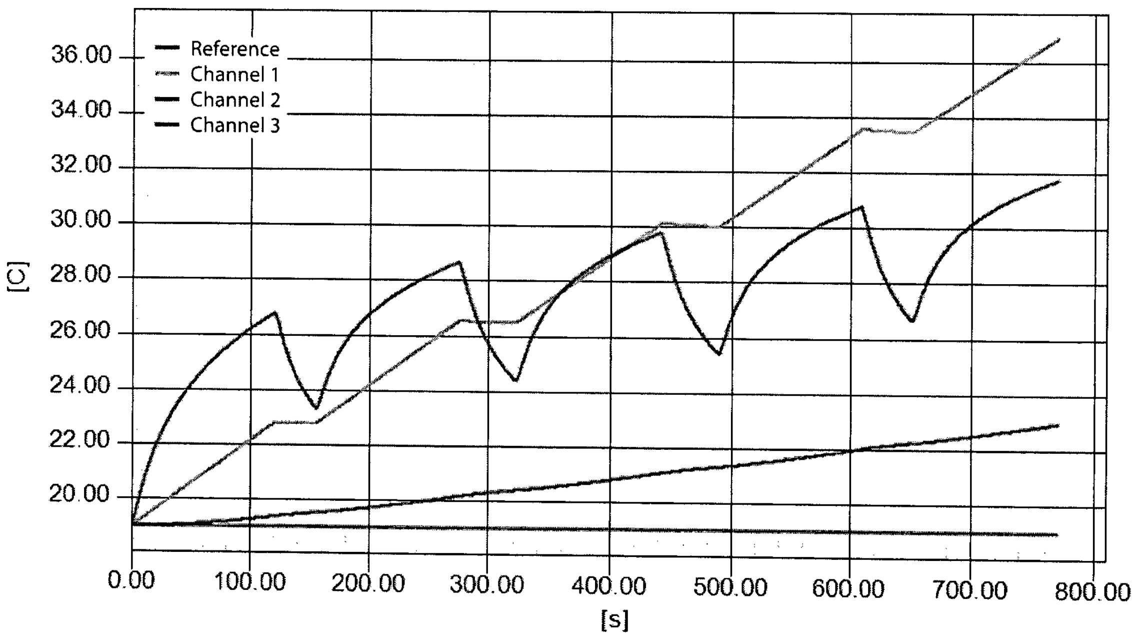


Figure 6.19

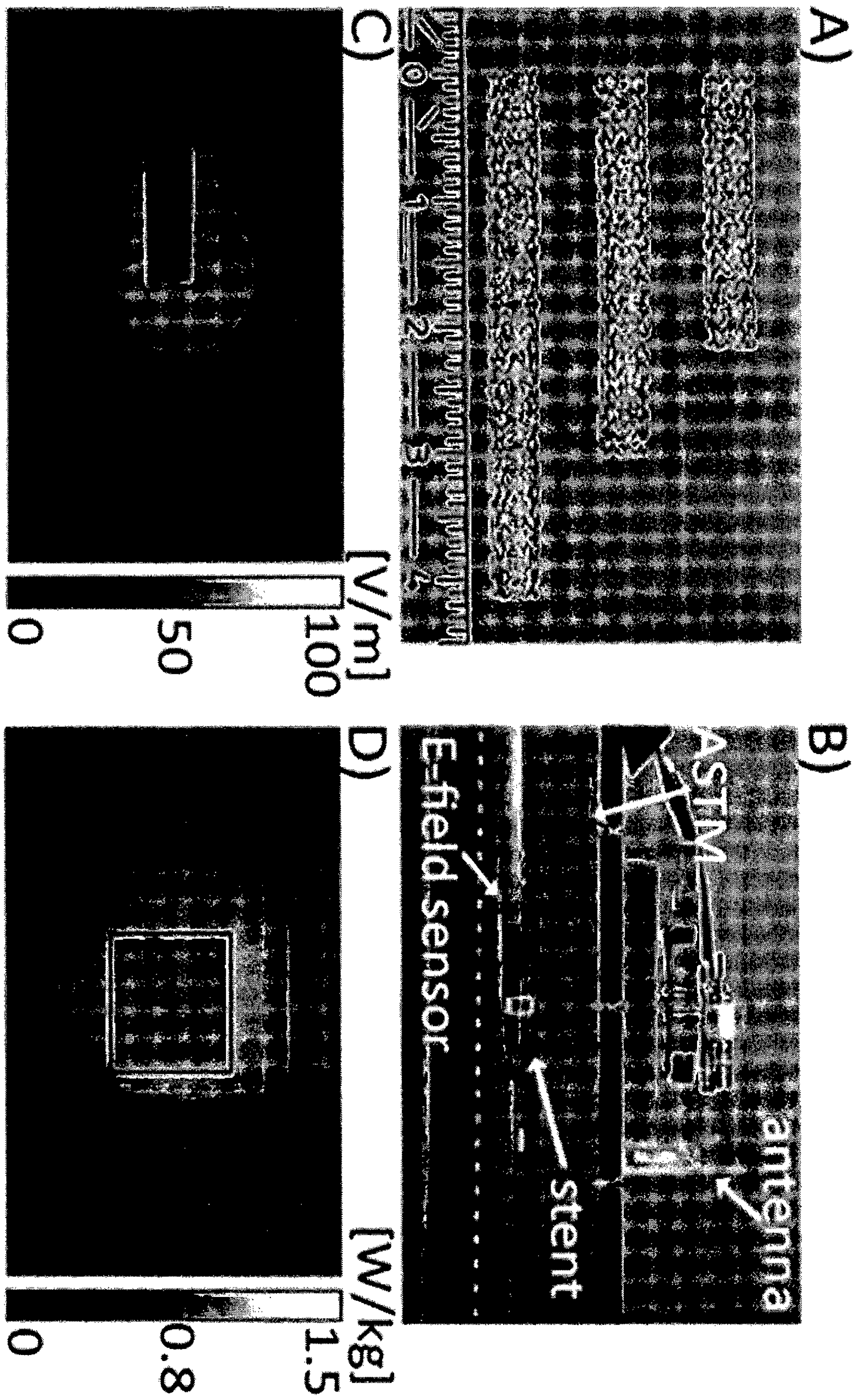


Figure 7.1

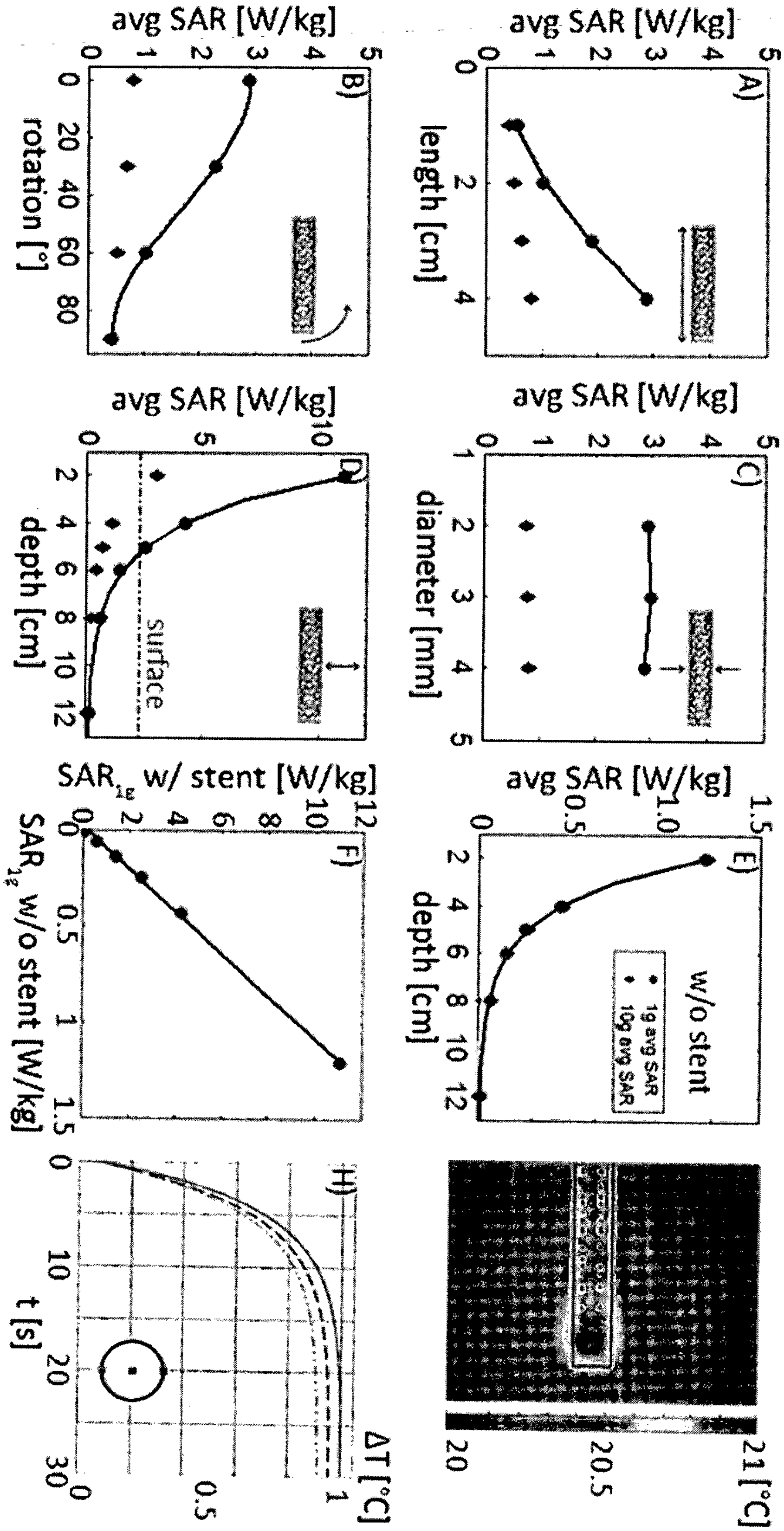
A)
avg SAR [W/kg]
length [cm]
B)
avg SAR [W/kg]
rotation [°]
C)
avg SAR [W/kg]
diameter [mm]
D)
avg SAR [W/kg]
surface
depth [cm]
E)
avg SAR [W/kg]
w/o stent
1g avg SAR
10g avg SAR
depth [cm]
F)
SAR1g w/ stent [W/kg]
SAR1g w/o stent [W/kg]
21 [°C]
20.5
20
H)
ΔT [°C]
t [s]

Figure 7.2

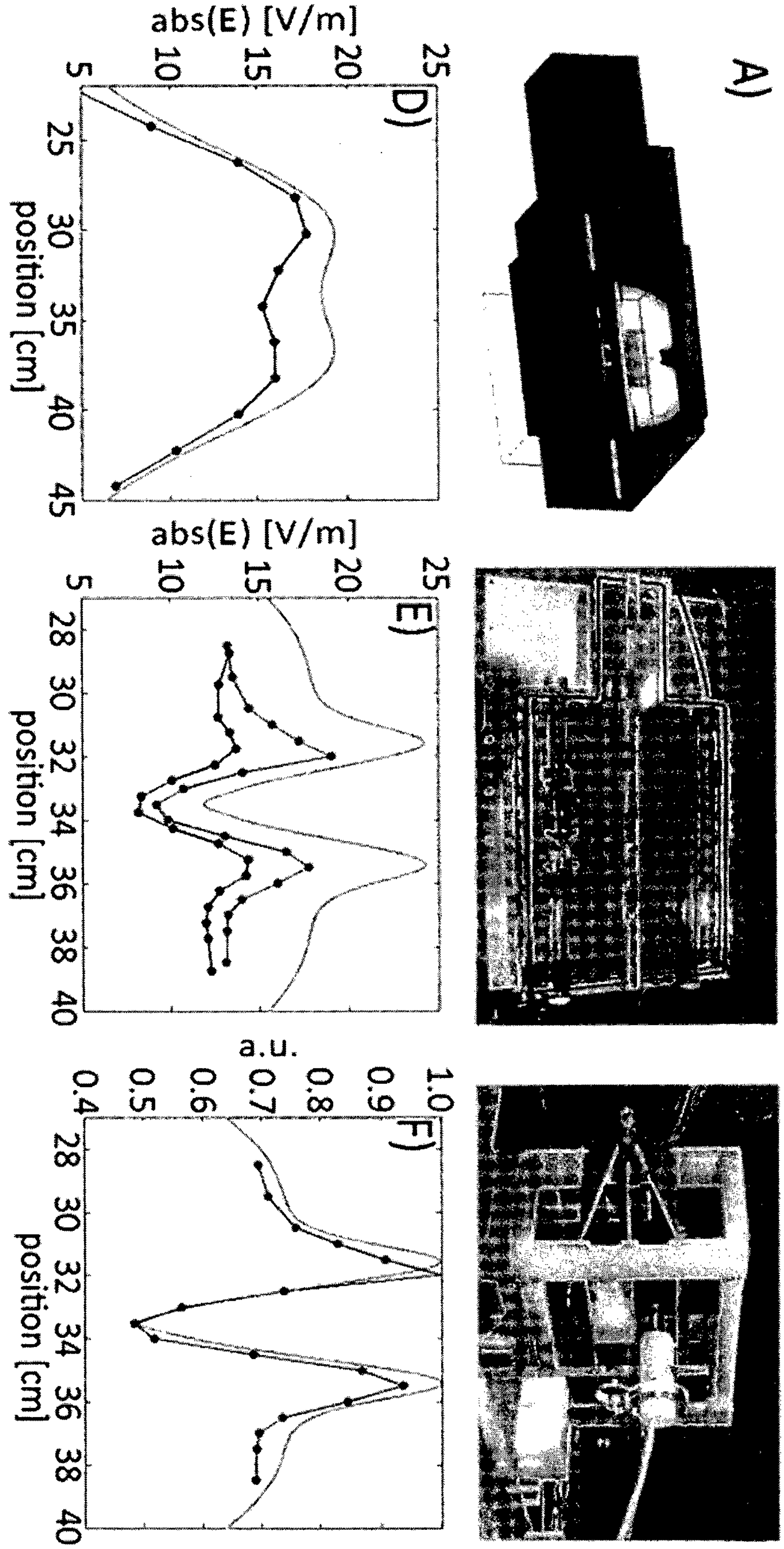


Figure 7.3

Europäisches Patentamt
European Patent Office
Office européen des brevets

# EUROPEAN SEARCH REPORT

Application Number
EP 14 00 1658

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | E OBERACKER ET AL: "En route to ultrahigh cardiac MR in patients: RF safety assessment of intracoronary stents at 7.0 T using numerical simulations and E-field measurements", PROCEEDINGS OF THE INTERNATIONAL SOCIETY FOR MAGNETIC RESONANCE IN MEDICINE, ISMRM, JOINT ANNUAL MEETING ISMRM-ESMRMB, MILAN, ITALY, 10-16 MAY 2014, 25 April 2014 (2014-04-25), page 0177, XP055154017, * Sections "Purpose", "Method", "Results" * * figure 2(B) * | 1-5 | INV. G01R33/28 G01R33/48 |
| L | International Society for Magnetic Resonance in Medicine, ISMRM: "Call for Papers", , 1 January 2013 (2013-01-01), pages 1-3, XP055154007, Retrieved from the Internet: URL:http://www.ismrm.org/14/call.htm [retrieved on 2014-04-30] * This document was cited in order to prove that the publication date of the ISMRM abstract by Oberacker et al, ISMRM 2014, p. 0177 was published on 25.04.2014.; page 3 * * page 3 * | 1-5 | |
| | -/-- | | TECHNICAL FIELDS SEARCHED (IPC) |
| | | | G01R |

1

The present search report has been drawn up for all claims

| Place of search | Date of completion of the search | Examiner |
|---|---|---|
| Munich | 24 November 2014 | Streif, Jörg Ulrich |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
..........................................................
& : member of the same patent family, corresponding document

EPO FORM 1503 03.82 (P04C01)

Europäisches Patentamt
European Patent Office
Office européen des brevets

# EUROPEAN SEARCH REPORT

Application Number
EP 14 00 1658

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | CHRISTOPHER J. YEUNG ET AL: "RF safety of wires in interventional MRI: Using a safety index", MAGNETIC RESONANCE IN MEDICINE, vol. 47, no. 1, 20 December 2001 (2001-12-20), pages 187-193, XP055154448, ISSN: 0740-3194, DOI: 10.1002/mrm.10037 * the whole document * ----- | 1-5 | |
| A | PETER NORDBECK ET AL: "Spatial distribution of RF-induced E-fields and implant heating in MRI", MAGNETIC RESONANCE IN MEDICINE, vol. 60, no. 2, 1 August 2008 (2008-08-01), pages 312-319, XP055154454, ISSN: 0740-3194, DOI: 10.1002/mrm.21475 * the whole document * ----- | 1-5 | |
| A | MARTIN BUSCH ET AL: "On the heating of inductively coupled resonators (stents) during MRI examinations", MAGNETIC RESONANCE IN MEDICINE, vol. 54, no. 4, 1 January 2005 (2005-01-01), pages 775-782, XP055154458, ISSN: 0740-3194, DOI: 10.1002/mrm.20618 * the whole document * ----- | 1-5 | TECHNICAL FIELDS SEARCHED (IPC) |

1

The present search report has been drawn up for all claims

| Place of search | Date of completion of the search | Examiner |
|---|---|---|
| Munich | 24 November 2014 | Streif, Jörg Ulrich |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
..............................................................
& : member of the same patent family, corresponding document

EPO FORM 1503 03.82 (P04C01)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Non-patent literature cited in the description


- **NIENDORF T et al.** *JMR,* 2012
- **CHRISTIANSEN E et al.** *The Lancet,* 2004
- **BAKHAI A et al.** *Int J. Cardiol.,* 2004
- **SANTORO D et al.** *PLOS ONE,* 2012
- **WINTER L et al.** *PLOS ONE,* 2013
- **SEIFERT F et al.** *ISMRM Proc.,* 2011
- **DIERINGER M et al.** *JMRI,* 2011